(19) Europäisches Patentamt
European Patent Office
Office européen des brevets

(11) EP 3 960 745 A1

(12) EUROPEAN PATENT APPLICATION
published in accordance with Art. 153(4) EPC

(43) Date of publication:
**02.03.2022 Bulletin 2022/09**

(21) Application number: **20840774.2**

(22) Date of filing: **16.07.2020**

(51) International Patent Classification (IPC):
***C07F 5/02*** (2006.01) ***H01L 51/00*** (2006.01)
***C09K 11/06*** (2006.01) ***H01L 51/50*** (2006.01)

(52) Cooperative Patent Classification (CPC):
**C07F 5/027; C07F 5/02; C09K 11/06; H01L 51/00; H01L 51/50**

(86) International application number:
**PCT/KR2020/009377**

(87) International publication number:
**WO 2021/010767 (21.01.2021 Gazette 2021/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **16.07.2019 KR 20190085898**
**17.07.2019 KR 20190086310**

(71) Applicant: **LG CHEM, LTD.**
**Yeongdeungpo-gu,**
**Seoul 07336 (KR)**

(72) Inventors:
- **LIM, Byeong Yun**
  **Daejeon 34122 (KR)**
- **BAE, Jaesoon**
  **Daejeon 34122 (KR)**
- **LEE, Jaechol**
  **Daejeon 34122 (KR)**
- **WOO, Yu Jin**
  **Daejeon 34122 (KR)**
- **KIM, Yongwook**
  **Daejeon 34122 (KR)**
- **BAEK, Leehyeon**
  **Daejeon 34122 (KR)**
- **LEE, Jumin**
  **Daejeon 34122 (KR)**

(74) Representative: **Hoffmann Eitle**
**Patent- und Rechtsanwälte PartmbB**
**Arabellastraße 30**
**81925 München (DE)**

# (54) COMPOUND, COATING COMPOSITION INCLUDING SAME, AND ORGANIC LIGHT-EMITTING DEVICE USING SAME

(57) The present specification provides a compound of Chemical Formula 1, a coating composition including the same, and an organic light emitting device using the same.

【FIG. 1】

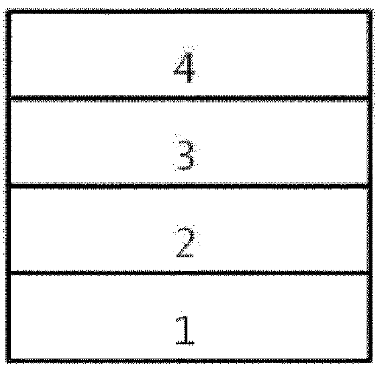


EP 3 960 745 A1

## Description

[Technical Field]

The present specification relates to a compound, a coating composition including the same, and an organic light emitting device using the same.

This application claims priority to and the benefits of Korean Patent Application No. 10-2019-0086310, filed with the Korean Intellectual Property Office on July 17, 2019, and Korean Patent Application No. 10-2019-0085898, filed with the Korean Intellectual Property Office on July 16, 2019, the entire contents of which are incorporated herein by reference.

[Background Art]

An organic light emitting device has a structure disposing an organic thin film between two electrodes. When a voltage is applied to an organic light emitting device having such a structure, electrons and holes injected from the two electrodes bind and pair in the organic thin film, and light emits as these annihilate. The organic thin film may be formed in a single layer or a multilayer as necessary.

A material of the organic thin film may have a light emitting function as necessary. For example, as a material of the organic thin film, compounds capable of forming a light emitting layer themselves alone may be used, or compounds capable of performing a role of a host or a dopant of a host-dopant-based light emitting layer may also be used. In addition thereto, compounds capable of performing roles of hole injection, hole transfer, electron blocking, hole blocking, electron transfer, electron injection or the like may also be used as a material of the organic thin film.

Development of an organic thin film material has been continuously required for enhancing performance, lifetime or efficiency of an organic light emitting device.

[Disclosure]

[Technical Problem]

The present specification is directed to providing a compound, a coating composition including the same, and an organic light emitting device using the same.

[Technical Solution]

One embodiment of the present specification provides a compound represented by the following Chemical Formula 1.

[Chemical Formula 1]

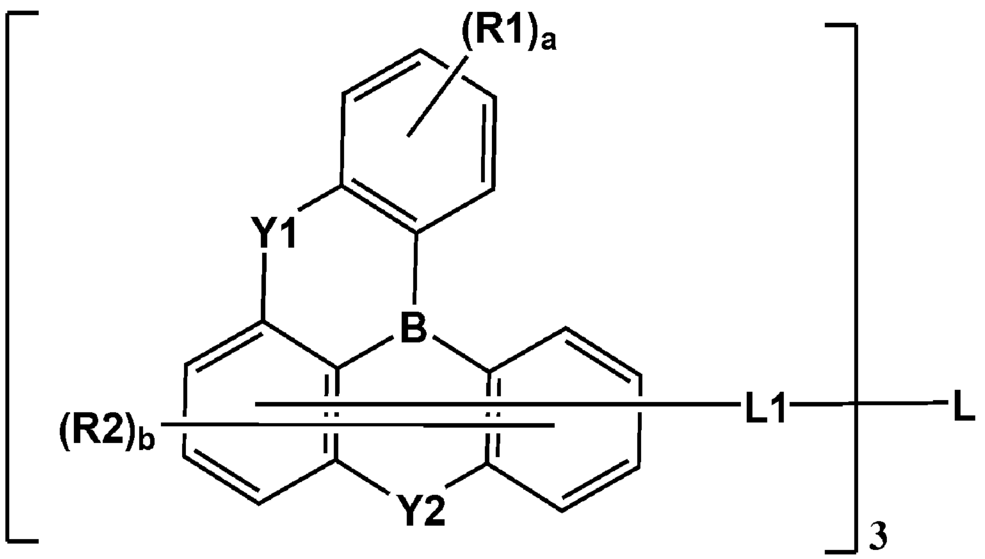

In Chemical Formula 1, L is CR, N, SiR' or

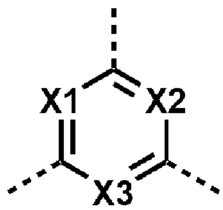

,

X1 to X3 are the same as or different from each other, and each independently CH or N,
L1 is a direct bond; or a substituted or unsubstituted arylene group,
Y1 and Y2 are the same as or different from each other, and each independently NR", O or S,
R1, R2, R, R' and R" are the same as or different from each other, and each independently hydrogen; deuterium; a halogen group; a nitrile group; a substituted or unsubstituted alkyl group; a substituted or unsubstituted alkoxy group; a substituted or unsubstituted cycloalkyl group; a substituted or unsubstituted silyl group; a substituted or unsubstituted amine group; a substituted or unsubstituted aryl group; a substituted or unsubstituted heteroaryl group; substituted or unsubstituted $C_{2-60}$ alkynyl; substituted or unsubstituted tri ($C_{1-60}$ alkyl) silyl; or substituted or unsubstituted tri($C_{6-60}$ aryl) silyl,
a is an integer of 0 to 4, and when a is 2 or greater, R1s are the same as or different from each other,
b is an integer of 0 to 6, and when b is 2 or greater, R2s are the same as or different from each other,

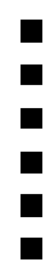

means a bond linked to Chemical Formula 1,
when X1 to X3 are CH, at least one of Y1 and Y2 is NR" or S, and
structures in the square bracket [] are the same as or different from each other.

Another embodiment of the present application provides a coating composition including the compound described above.

Another embodiment of the present application provides an organic light emitting device including a first electrode; a second electrode provided opposite to the first electrode; and one or more organic material layers provided between the first electrode and the second electrode, wherein one or more layers of the organic material layers include the coating composition described above or a cured material thereof.

[Advantageous Effects]

A compound according to one embodiment of the present application can be used as a material of an organic material layer of an organic light emitting device, can be used in a solution process, and is capable of enhancing efficiency, obtaining a low driving voltage and/or enhancing lifetime properties in the organic light emitting device.

The compound of Chemical Formula 1 has a trimer structure including three heterocyclic structures including boron, and is more stable in the chemical structure compared to compounds having a structure including one or two heterocyclic structures including boron, and as a result, a superior effect is obtained in terms of a lifetime.

[Description of Drawings]

FIG. 1 and FIG. 2 illustrate an example of an organic light emitting device.

[Reference Numeral]

1: Substrate
2: Anode
3: Light Emitting Layer
4: Cathode
5: Hole Injection Layer
6: Hole Transfer Layer
7: Electron Injection and Transfer Layer

[Mode for Disclosure]

Hereinafter, the present specification will be described in more detail.
One embodiment of the present specification provides a compound represented by Chemical Formula 1.
In the present specification, a description of a certain member being placed "on" another member includes not only a case of the one member in contact with the another member but a case of still another member being present between the two members.
In the present specification, a description of a certain part "including" certain constituents means capable of further including other constituents, and does not exclude other constituents unless particularly stated on the contrary.
Throughout the specification of the present application, the term "a combination thereof" included in a Markush-type expression means a mixture or a combination of one or more selected from the group consisting of constituents described in the Markush-type expression, and means including one or more selected from the group consisting of the constituents.
Examples of substituents in the present specification are described below, however, the substituents are not limited thereto.
In the present specification,

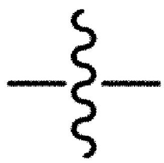

or

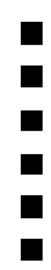

means a site bonding to other substituents or bonding sites.
In the present specification, the term "substitution" means a hydrogen atom bonding to a carbon atom of a compound being changed to another substituent. The position of substitution is not limited as long as it is a position at which the hydrogen atom is substituted, that is, a position at which a substituent can substitute, and when two or more substituents substitute, the two or more substituents may be the same as or different from each other.
In the present specification, the term "substituted or unsubstituted" means being substituted with one or more substituents selected from the group consisting of deuterium; a halogen group; a cyano group; a nitro group; a hydroxyl group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; or a heteroaryl group including one or more of N, O and S atoms, or being unsubstituted, or being

substituted with a substituent linking two or more substituents among the substituents illustrated above, or being unsubstituted. For example, "a substituent linking two or more substituents" may include a biphenyl group. In other words, a biphenyl group may be an aryl group, or interpreted as a substituent linking two phenyl groups.

In the present specification, examples of the halogen group may include fluorine, chlorine, bromine or iodine.

In the present specification, the alkyl group may be linear or branched, and although not particularly limited thereto, the number of carbon atoms is preferably from 1 to 50. Specific examples thereof may include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl and the like, but are not limited thereto.

In the present specification, the alkenyl group may be linear or branched, and although not particularly limited thereto, the number of carbon atoms is preferably from 2 to 30. Specific examples thereof may include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group and the like, but are not limited thereto.

In the present specification, the alkynyl group may be linear or branched, and although not particularly limited thereto, the number of carbon atoms is preferably from 2 to 30. Specific examples thereof may include ethynyl, propynyl, 2-methyl-2-propynyl, 2-butynyl, 2-pentynyl and the like, but are not limited thereto.

In the present specification, the cycloalkyl group is not particularly limited, but preferably has 3 to 60 carbon atoms, and specific examples thereof may include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl and the like, but are not limited thereto.

In the present specification, the alkoxy group may be linear, branched or cyclic. The number of carbon atoms of the alkoxy group is not particularly limited, but is preferably from 1 to 30. Specific examples thereof may include methoxy, ethoxy, n-propoxy, isopropoxy, i-propyloxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy and the like, but are not limited thereto.

In the present specification, specific examples of the boron group may include a trimethylboron group, a triethylboron group, a t-butyldimethylboron group, a triphenylboron group, a phenylboron group and the like, but are not limited thereto.

In the present specification, specific examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but are not limited thereto.

In the present specification, the amine group may be selected from the group consisting of $-NH_2$; a monoalkylamine group; a dialkylamine group; an N-alkylarylamine group; a monoarylamine group; a diarylamine group; an N-arylheteroarylamine group; an N-alkylheteroarylamine group, a monoheteroarylamine group and a diheteroarylamine group, and although not particularly limited thereto, the number of carbon atoms is preferably from 1 to 30. Specific examples of the amine group may include a methylamine group, a dimethylamine group, an ethylamine group, a diethylamine group, a phenylamine group, a naphthylamine group, a biphenylamine group, an anthracenylamine group, a 9-methyl-anthracenylamine group, a diphenylamine group, a ditolylamine group, an N-phenyltolylamine group, a triphenylamine group, an N-phenylbiphenylamine group; an N-phenylnaphthylamine group; an N-biphenylnaphthylamine group; an N-naphthylfluorenylamine group; an N-phenylphenanthrenylamine group; an N-biphenylphenanthrenylamine group; an N-phenylfluorenylamine group; an N-phenylterphenylamine group; an N-phenanthrenylfluorenylamine group; an N-biphenylfluorenylamine group and the like, but are not limited thereto.

In the present specification, the aryl group is not particularly limited, but preferably has 6 to 60 carbon atoms, and may be a monocyclic aryl group or a polycyclic aryl group. According to one embodiment, the number of carbon atoms of the aryl group is from 6 to 30. According to one embodiment, the number of carbon atoms of the aryl group is from 6 to 20. When the aryl group is a monocyclic aryl group, examples thereof may include a phenyl group, a biphenyl group, a terphenyl group and the like, but are not limited thereto. Examples of the polycyclic aryl group may include a naphthyl group, an anthracenyl group, a phenanthrenyl group, a pyrenyl group, a perylenyl group, a chrysenyl group, a fluorenyl group and the like, but are not limited thereto.

When the aryl group is a monocyclic aryl group in the present specification, the number of carbon atoms is not particularly limited, but is preferably from 6 to 25. Specific examples of the monocyclic aryl group may include a phenyl group, a biphenyl group, a terphenyl group, a quaterphenyl group and the like, but are not limited thereto.

When the aryl group is a polycyclic aryl group, the number of carbon atoms is not particularly limited, but is

preferably from 10 to 30. Specific examples of the polycyclic aryl group may include a naphthyl group, an anthracenyl group, a phenanthryl group, a pyrenyl group, a perylenyl group, a chrysenyl group, a fluorenyl group and the like, but are not limited thereto.

In the present specification, the fluorenyl group may be substituted, and adjacent substituents may bond to each other to form a ring.

When the fluorenyl group is substituted,

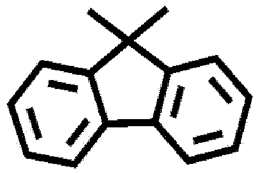

,

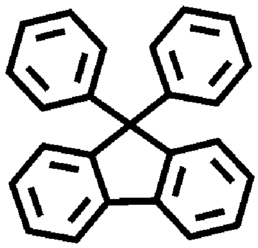

,

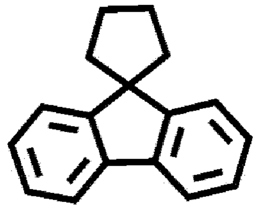

,

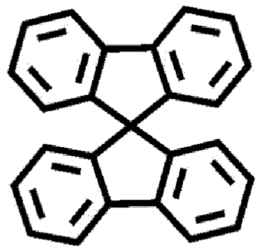

and the like may be included. However, the structure is not limited thereto.

The aryl group may be substituted with an alkyl group to function as an arylalkyl group. The alkyl group may be selected from among the examples described above.

In the present specification, the heteroaryl group is a group including one or more atoms that are not carbon, that is, heteroatoms, and specifically, the heteroatom may include one or more atoms selected from the group consisting of O, N, Si, Se, S and the like. The number of carbon atoms of the heteroaryl group is not particularly limited, but is preferably from 2 to 30, and the heteroaryl group may be monocyclic or polycyclic. Examples of the heteroaryl group may include xanthene, thioxanthen, a thiophene group, a furan group, a pyrrole group, an imidazole group, a thiazole group, an oxazole group, an oxadiazole group, a pyridine group, a pyrimidine group, a triazine group, a triazole group, a quinolinyl group, a quinazoline group, a carbazole group, a benzoxazole group, a benzimidazole group, a benzothiazole group, a benzocarbazole group, a benzothiophene group, a dibenzothiophene group, a benzofuran group, a phenanthroline group, an isoxazole group, a thiadiazole group, a dibenzofuran group and the like, but are not limited thereto.

In one embodiment of the present specification, the structures in the square bracket [] of Chemical Formula 1 are different from each other.

In one embodiment of the present specification, the structures in the square bracket [] of Chemical Formula 1 are the same as each other.

In one embodiment of the present specification, L is CR, N or SiR'.

In one embodiment of the present specification, L is

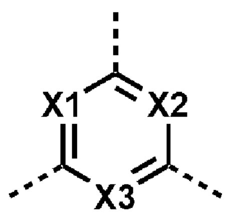

.

In one embodiment of the present specification, an organic light emitting device including a compound in which L is CR, N or SiR' has superior effects in terms of voltage, efficiency and lifetime compared to an organic light emitting device including a compound in which L is

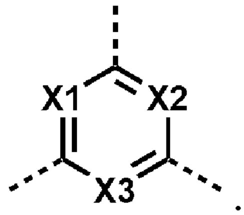

In one embodiment of the present specification, the structure of Chemical Formula 1 is represented by any one of the following Chemical Formulae 2 to 5.

[Chemical Formula 2]

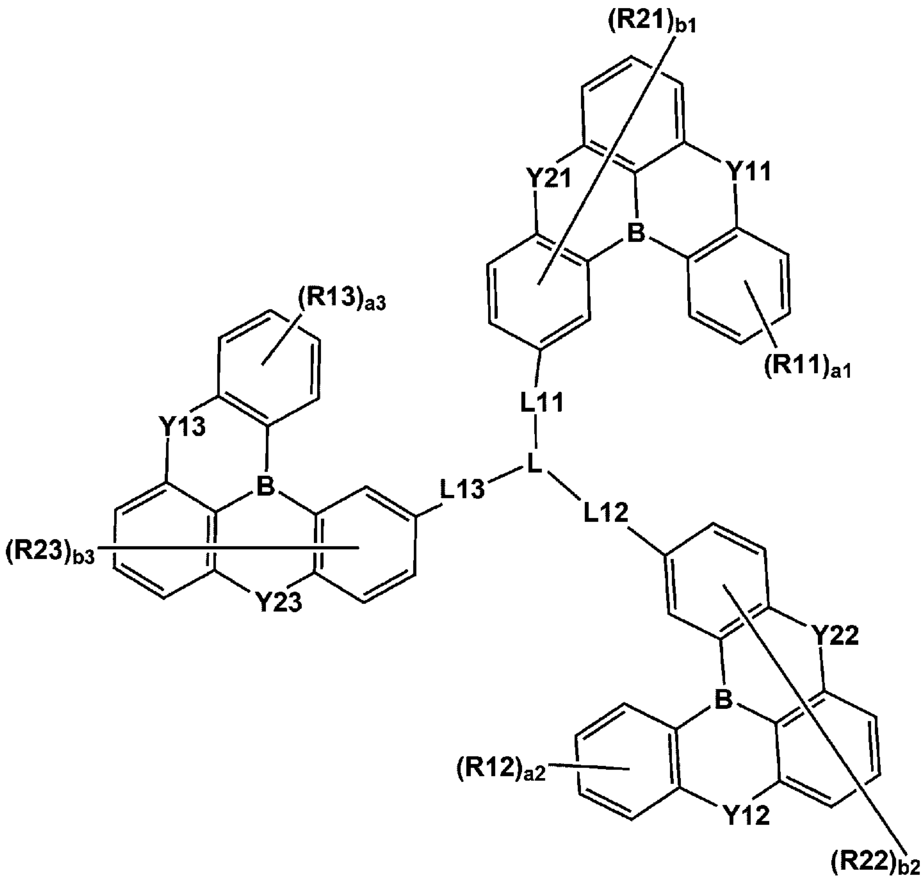

[Chemical Formula 3]

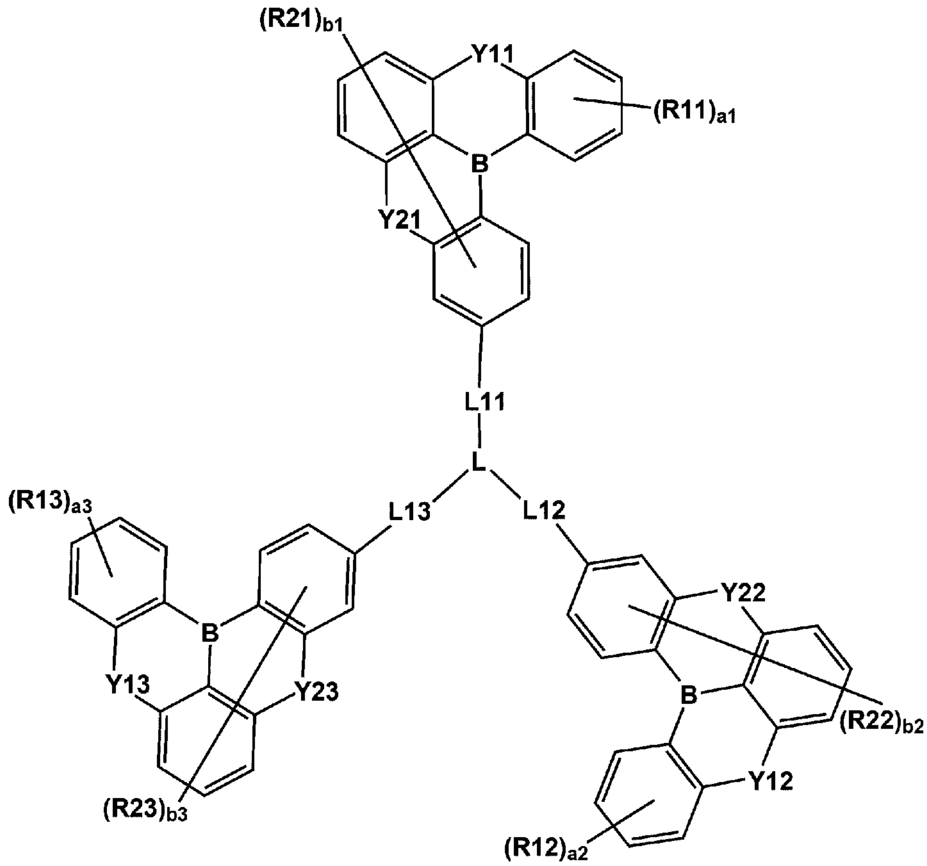

[Chemical Formula 4]

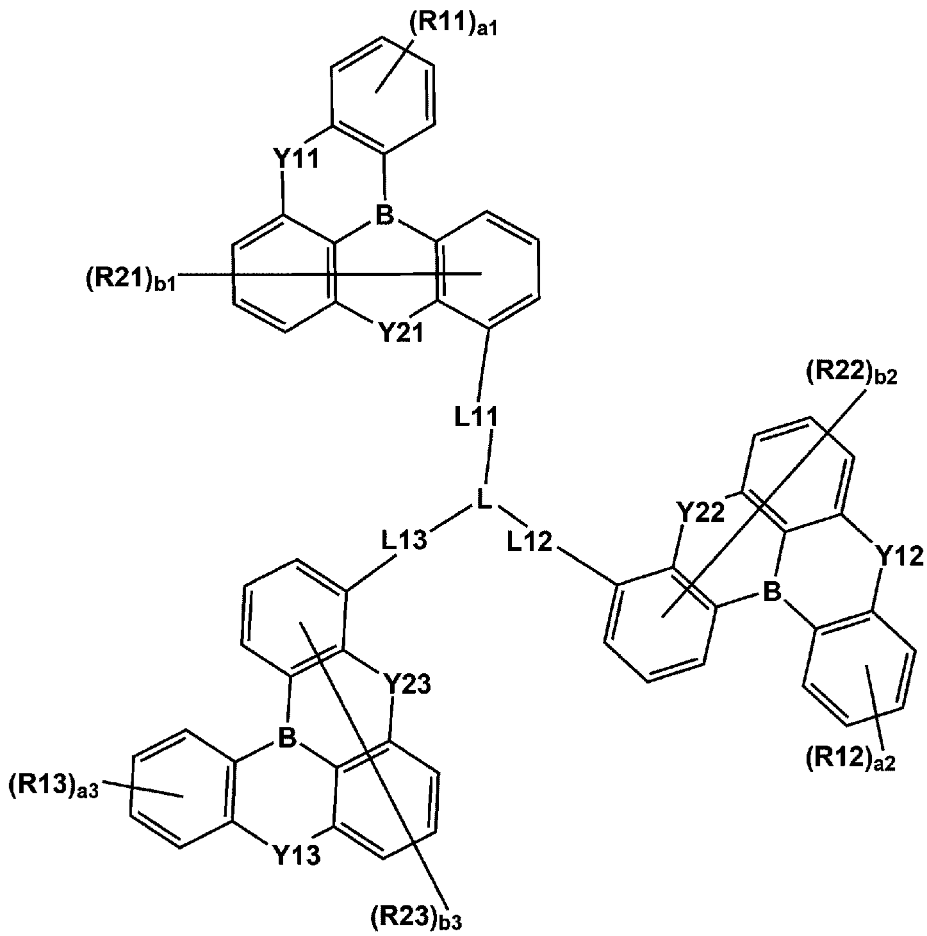

[Chemical Formula 5]

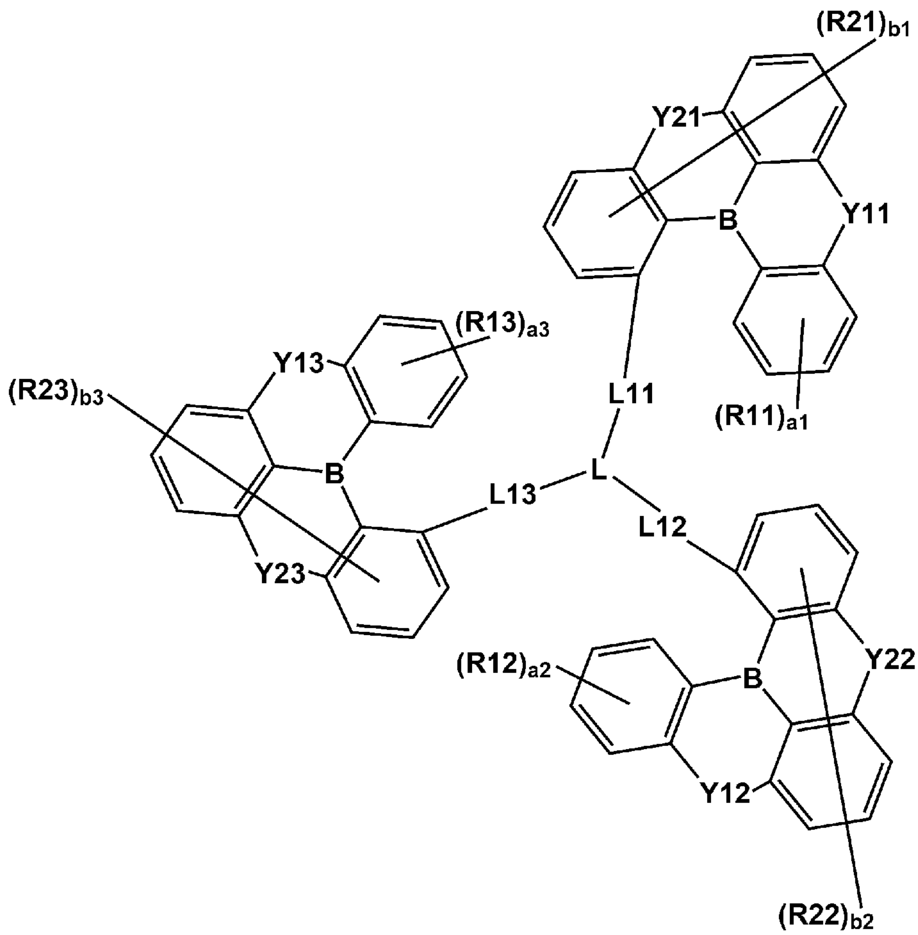

In Chemical Formulae 2 to 5,

L has the same definition as in Chemical Formula 1,
L11 to L13 are the same as or different from each other, and each independently have the same definition as L1 of Chemical Formula 1,
Y11 to Y13 and Y21 to Y23 have the same definitions as Y1 and Y2 in Chemical Formula 1,
R11 to R13 and R21 to R23 have the same definitions as R1 and R2 in Chemical Formula 1,
a1 to a3 have the same definition as a in Chemical Formula 1, and
b1 to b3 have the same definition as b in Chemical Formula 1.

In one embodiment of the present specification, the structure of Chemical Formula 1 is represented by the following Chemical Formula 6 or 7.

[Chemical Formula 6]

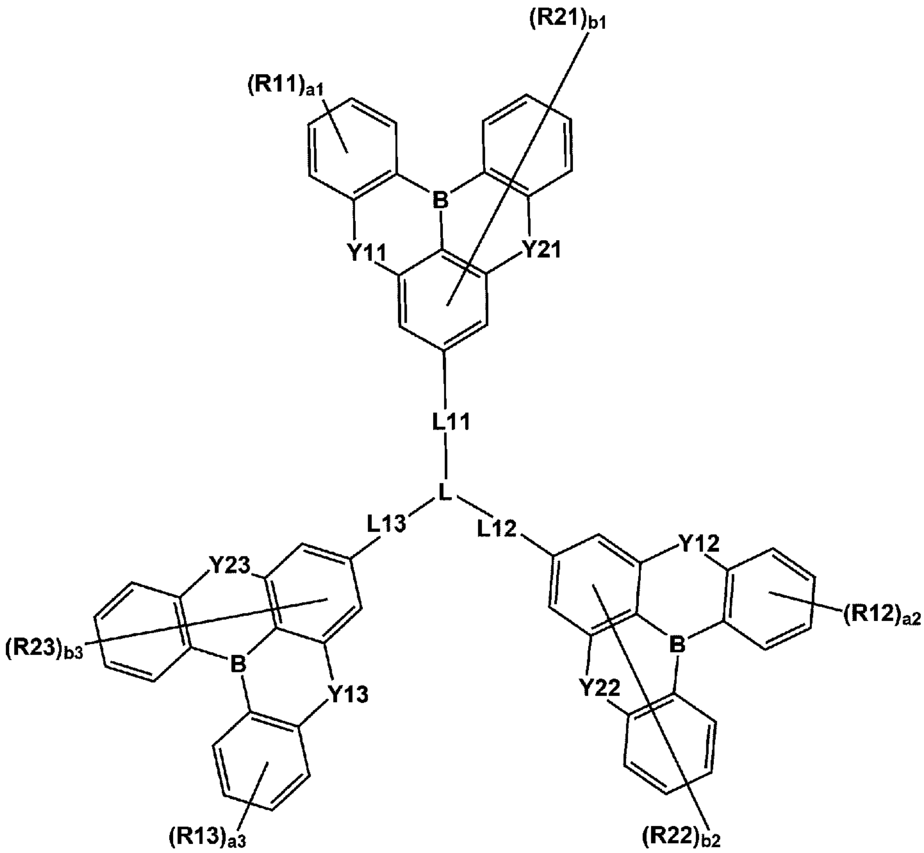

[Chemical Formula 7]

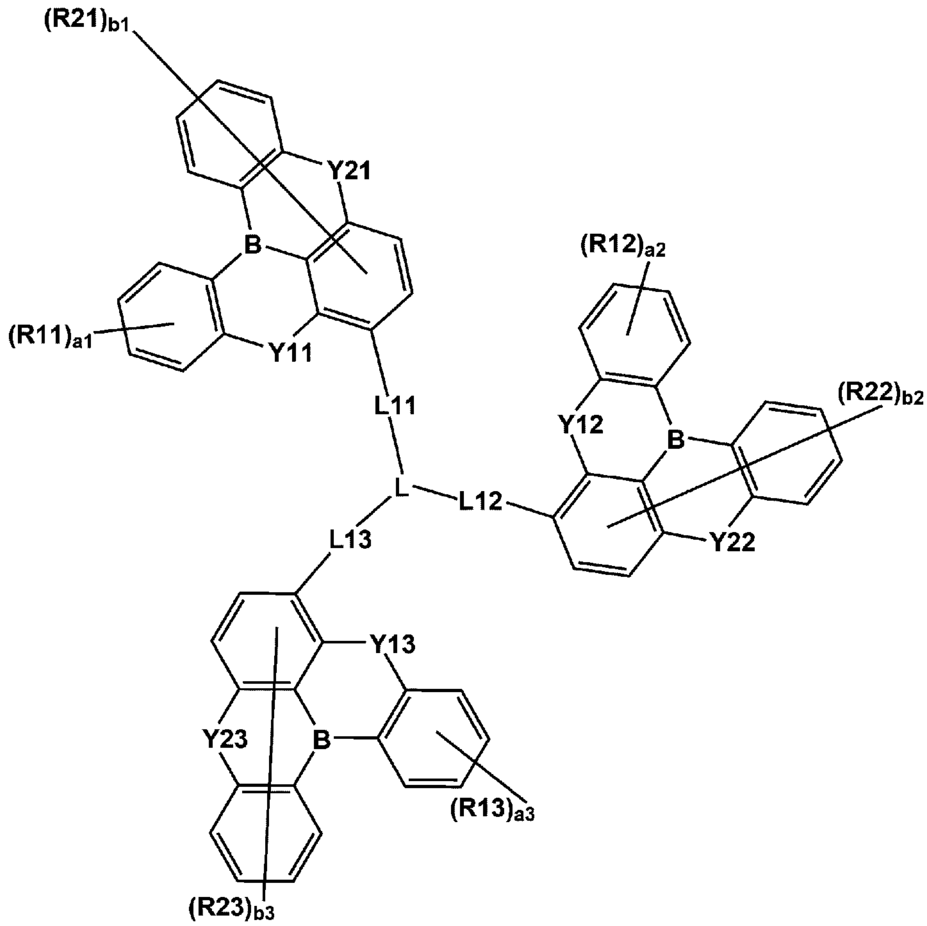

In Chemical Formulae 6 and 7,

L has the same definition as in Chemical Formula 1,
L11 to L13 are the same as or different from each other, and each independently have the same definition as L1 of Chemical Formula 1,
Y11 to Y13 and Y21 to Y23 have the same definitions as Y1 and Y2 in Chemical Formula 1,
R11 to R13 and R21 to R23 have the same definitions as R1 and R2 in Chemical Formula 1,
a1 to a3 have the same definition as a in Chemical Formula 1, and
b1 to b3 have the same definition as b in Chemical Formula 1.

In one embodiment of the present specification, L is CR, N, SiR' or

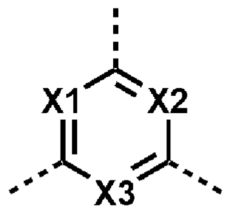

,

R and R' are the same as or different from each other and each independently hydrogen; a substituted or unsubstituted alkyl group; or a substituted or unsubstituted aryl group, and X1 to X3 are the same as or different from each other and each independently CH or N.

In one embodiment of the present specification, L is CR, N, or SiR', and R and R' are the same as or different from each other and each independently hydrogen; a substituted or unsubstituted alkyl group; or a substituted or unsubstituted aryl group.

In one embodiment of the present specification, L is CR, N, SiR' or

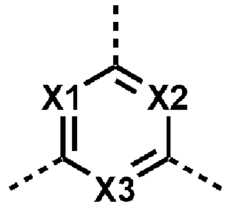

,

R and R' are the same as or different from each other and each independently hydrogen; an alkyl group having 1 to 10 carbon atoms; or an aryl group having 6 to 20 carbon atoms, and X1 to X3 are the same as or different from each other and each independently CH or N.

In one embodiment of the present specification, L is CR, N, SiR' or

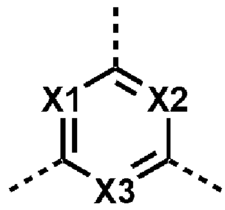

,

R and R' are the same as or different from each other and each independently hydrogen; or an alkyl group having 1 to 10 carbon atoms, and X1 to X3 are the same as or different from each other and each independently CH or N.

In one embodiment of the present specification, L is CR, N, SiR' or

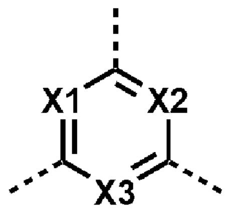

,

R and R' are the same as or different from each other and each independently hydrogen; or a linear or branched alkyl group having 1 to 10 carbon atoms, and X1 to X3 are the same as or different from each other and each independently CH or N.

In one embodiment of the present specification, L is CR, N or SiR', and R and R' are the same as or different from each other and each independently hydrogen; an alkyl group having 1 to 10 carbon atoms; or an aryl group having 6 to 20 carbon atoms.

In one embodiment of the present specification, L is CR, N or SiR', and R and R' are the same as or different from each other and each independently hydrogen; or an alkyl group having 1 to 10 carbon atoms.

In one embodiment of the present specification, L is CR, N or SiR', and R and R' are the same as or different from each other and each independently hydrogen; or a linear or branched alkyl group having 1 to 10 carbon atoms.

In one embodiment of the present specification, L is CR, and R is hydrogen; or a substituted or unsubstituted alkyl group.

In one embodiment of the present specification, L is CR, and R is hydrogen; or a substituted or unsubstituted alkyl group having 1 to 10 carbon atoms.

In one embodiment of the present specification, L is CR, and R is hydrogen; or an alkyl group having 1 to 10 carbon atoms.

In one embodiment of the present specification, L is CR, and R is hydrogen; or a linear or branched alkyl group having 1 to 10 carbon atoms.

In one embodiment of the present specification, L is CR, and R is hydrogen; a methyl group; an ethyl group; a propyl group; or a butyl group.

In one embodiment of the present specification, L is CR, and R is hydrogen; or a methyl group.
In one embodiment of the present specification, L is N.
In one embodiment of the present specification, L is SiR', and R' is hydrogen; a substituted or unsubstituted alkyl group; or a substituted or unsubstituted aryl group.
In one embodiment of the present specification, L is SiR', and R' is hydrogen; an alkyl group having 1 to 10 carbon atoms; or an aryl group having 6 to 20 carbon atoms.
In one embodiment of the present specification, L is SiR', and R' is hydrogen; or an alkyl group having 1 to 10 carbon atoms.
In one embodiment of the present specification, L is SiR', and R' is hydrogen; a methyl group; an ethyl group; a propyl group; or a butyl group.
In one embodiment of the present specification, L is SiR', and R' is hydrogen; or a methyl group.
In one embodiment of the present specification, L is

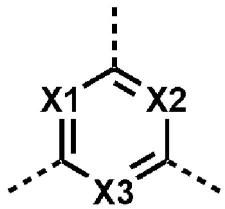

,

and X1 to X3 are the same as or different from each other and each independently CH or N.
In one embodiment of the present specification, X1 to X3 are all CH.
In one embodiment of the present specification, when X1 to X3 are CH, at least one of Y1 and Y2 is NR" or S.
In one embodiment of the present specification, when X1 to X3 are CH, at least one of Y1 and Y2 is NR".
In one embodiment of the present specification, when X1 to X3 are CH, Y1 and Y2 are the same as or different from each other, and each independently NR" or S.
In one embodiment of the present specification, when X1 to X3 are CH, Y1 and Y2 are NR".
In one embodiment of the present specification, X1 to X3 are all N.
In one embodiment of the present specification, at least one of X1 to X3 is N, and the rest are CH.
In one embodiment of the present specification, one of X1 to X3 is N, and the rest are CH.
In one embodiment of the present specification, at least two of X1 to X3 are N, and the other one is CH.
In one embodiment of the present specification, two of X1 to X3 are N, and the other one is CH.
In one embodiment of the present specification, L1 is a direct bond; or a phenylene group.
In one embodiment of the present specification, L1 is a direct bond.
In one embodiment of the present specification, Y1 and Y2 may be NR", O or S, however, a compound with NR" is preferred.
In one embodiment of the present specification, Y1 and Y2 are NR", and R" is hydrogen; deuterium; a substituted or unsubstituted aryl group; or a substituted or unsubstituted heteroaryl group.
In one embodiment of the present specification, Y1 and Y2 are NR", and R" is a substituted or unsubstituted aryl group; or a substituted or unsubstituted heteroaryl group.
In one embodiment of the present specification, Y1 and Y2 are NR", and R" is hydrogen; deuterium; a substituted or unsubstituted aryl group having 6 to 20 carbon atoms; or a substituted or unsubstituted heteroaryl group having 2 to 20 carbon atoms.
In one embodiment of the present specification, Y1 and Y2 are NR", and R" is a substituted or unsubstituted aryl group having 6 to 20 carbon atoms; or a substituted or unsubstituted heteroaryl group having 2 to 20 carbon atoms.
In one embodiment of the present specification, Y1 and Y2 are NR", and R" is hydrogen; deuterium; an aryl group unsubstituted or substituted with a substituent selected from the group consisting of an alkyl group, an alkoxy group, a silyl group, an amine group, an aryl group and a heteroaryl group; or a heteroaryl group unsubstituted or substituted with a substituent selected from the group consisting of an alkyl group, an alkoxy group, a silyl group, an amine group, an aryl group and a heteroaryl group.
In one embodiment of the present specification, Y1 and Y2 are NR", and R" is an aryl group unsubstituted or substituted with a substituent selected from the group consisting of an alkyl group, an alkoxy group, a silyl group, an amine group, an aryl group and a heteroaryl group; or a heteroaryl group unsubstituted or substituted with a substituent selected from the group consisting of an alkyl group, an alkoxy group, a silyl group, an amine group, an aryl group and a heteroaryl group.
In one embodiment of the present specification, Y1 and Y2 are NR", and R" is hydrogen; deuterium; or an aryl

group having 6 to 20 carbon atoms unsubstituted or substituted with an alkyl group having 1 to 10 carbon atoms, an alkoxy group having 1 to 10 carbon atoms, a silyl group substituted with an alkyl group having 1 to 10 carbon atoms, an amine group substituted with an aryl group having 6 to 20 carbon atoms, or a heteroaryl group having 2 to 20 carbon atoms.

In one embodiment of the present specification, Y1 and Y2 are NR", and R" is an aryl group having 6 to 20 carbon atoms unsubstituted or substituted with an alkyl group having 1 to 10 carbon atoms, an alkoxy group having 1 to 10 carbon atoms, a silyl group substituted with an alkyl group having 1 to 10 carbon atoms, an amine group substituted with an aryl group having 6 to 20 carbon atoms, or a heteroaryl group having 2 to 20 carbon atoms.

In one embodiment of the present specification, Y1 and Y2 are NR", and R" is an aryl group having 6 to 20 carbon atoms substituted with an alkyl group having 1 to 10 carbon atoms, a silyl group substituted with an alkyl group having 1 to 10 carbon atoms, an amine group substituted with an aryl group having 6 to 20 carbon atoms, or a heteroaryl group having 2 to 20 carbon atoms.

In one embodiment of the present specification, Y1 and Y2 are NR", and R" is hydrogen; deuterium; or an aryl group substituted with an alkyl group, an alkoxy group, a silyl group substituted with an alkyl group, an amine group substituted with an aryl group, or a heteroaryl group.

In one embodiment of the present specification, Y1 and Y2 are NR", and R" is hydrogen; deuterium; or a substituted or unsubstituted phenyl group.

In one embodiment of the present specification, Y1 and Y2 are NR", and R" is a substituted or unsubstituted phenyl group.

In one embodiment of the present specification, Y1 and Y2 are NR", and R" is hydrogen; deuterium; or a substituted phenyl group.

In one embodiment of the present specification, Y1 and Y2 are NR", and R" is a substituted phenyl group.

In one embodiment of the present specification, Y1 and Y2 are NR", and R" is a phenyl group unsubstituted or substituted with an alkyl group having 1 to 10 carbon atoms, an alkoxy group having 1 to 10 carbon atoms, a silyl group substituted with an alkyl group having 1 to 10 carbon atoms, an amine group substituted with an aryl group having 6 to 20 carbon atoms, or a heteroaryl group having 2 to 20 carbon atoms; or a biphenyl group unsubstituted or substituted with an alkyl group having 1 to 10 carbon atoms, an alkoxy group having 1 to 10 carbon atoms, a silyl group substituted with an alkyl group having 1 to 10 carbon atoms, an amine group substituted with an aryl group having 6 to 20 carbon atoms, or a heteroaryl group having 2 to 20 carbon atoms.

In one embodiment of the present specification, Y1 and Y2 are NR", and R" is a phenyl group substituted with an alkyl group having 1 to 10 carbon atoms, an alkoxy group having 1 to 10 carbon atoms, a silyl group substituted with an alkyl group having 1 to 10 carbon atoms, an amine group substituted with an aryl group having 6 to 20 carbon atoms, or a heteroaryl group having 2 to 20 carbon atoms; or a biphenyl group substituted with an alkyl group having 1 to 10 carbon atoms, an alkoxy group having 1 to 10 carbon atoms, a silyl group substituted with an alkyl group having 1 to 10 carbon atoms, an amine group substituted with an aryl group having 6 to 20 carbon atoms, or a heteroaryl group having 2 to 20 carbon atoms.

In one embodiment of the present specification, Y1 and Y2 are NR", and R" is hydrogen; deuterium; or a phenyl group substituted with one or more substituents selected from the group consisting of a methyl group, an ethyl group, a propyl group, a butyl group, a methoxy group, a trimethylsilyl group, a tripropylsilyl group, a diphenylamine group, a carbazole group, a phenylcarbazole group, a dibenzofuran group, a dibenzothiophene group and a phenoxazine group.

In one embodiment of the present specification, Y1 and Y2 are NR", and R" is hydrogen; deuterium; or a phenyl group substituted with one or more substituents selected from the group consisting of a methyl group, a tert-butyl group, a methoxy group, a trimethylsilyl group, a triisopropylsilyl group, a diphenylamine group, a carbazole group, a phenylcarbazole group, a dibenzofuran group, a dibenzothiophene group and a phenoxazine group.

In one embodiment of the present specification, Y1 and Y2 are NR", and R" is a phenyl group substituted with one or more substituents selected from the group consisting of a methyl group, an ethyl group, a propyl group, a butyl group, a methoxy group, a trimethylsilyl group, a tripropylsilyl group, a diphenylamine group, a carbazole group, a phenylcarbazole group, a dibenzofuran group, a dibenzothiophene group and a phenoxazine group.

In one embodiment of the present specification, Y1 and Y2 are NR", and R" is a phenyl group substituted with one or more substituents selected from the group consisting of a methyl group, a tert-butyl group, a methoxy group, a trimethylsilyl group, a triisopropylsilyl group, a diphenylamine group, a carbazole group, a phenylcarbazole group, a dibenzofuran group, a dibenzothiophene group and a phenoxazine group.

In one embodiment of the present specification, Y1 and Y2 are the same as or different from each other, and each independently O or S.

In one embodiment of the present specification, Y1 and Y2 are O.

In one embodiment of the present specification, Y1 and Y2 are S.

In one embodiment of the present specification, R1 and R2 are the same as or different from each other, and each independently hydrogen; deuterium; a substituted or unsubstituted alkyl group; a substituted or unsubstituted silyl group; a substituted or unsubstituted amine group; a substituted or unsubstituted aryl group; or a substituted or unsubstituted heteroaryl group.

In one embodiment of the present specification, R1 and R2 are the same as or different from each other, and each independently hydrogen; deuterium; an alkyl group; a silyl group unsubstituted or substituted with an alkyl group; an amine group unsubstituted or substituted with an amine group; an aryl group unsubstituted or substituted with an alkyl group, a silyl group, an amine group or a heterocyclic group; or a heteroaryl group unsubstituted or substituted with an aryl group.

In one embodiment of the present specification, R1 and R2 are the same as or different from each other, and each independently hydrogen; deuterium; an alkyl group having 1 to 10 carbon atoms; a silyl group substituted with an alkyl group having 1 to 10 carbon atoms; an amine group substituted with an aryl group having 6 to 20 carbon atoms; a substituted or unsubstituted aryl group having 6 to 20 carbon atoms; or a substituted or unsubstituted heteroaryl group having 2 to 20 carbon atoms, and

the aryl group and the heteroaryl group may be unsubstituted or substituted with one or more substituents selected from the group consisting of an alkyl group having 1 to 10 carbon atoms; a silyl group substituted with an alkyl group having 1 to 10 carbon atoms; an amine group substituted with an aryl group having 6 to 20 carbon atoms; an aryl group having 6 to 20 carbon atoms; and a heteroaryl group having 2 to 20 carbon atoms.

In one embodiment of the present specification, R1 and R2 are the same as or different from each other, and each independently hydrogen; deuterium; a methyl group; an ethyl group; a propyl group; a butyl group; a trimethylsilyl group; a carbazole group; a phenoxazine group; or a phenyl group substituted with a diphenylamine group.

In one embodiment of the present specification, R1 and R2 are the same as or different from each other, and each independently hydrogen; deuterium; a methyl group; a tert-butyl group; a trimethylsilyl group; a carbazole group; a phenoxazine group; or a phenyl group substituted with a diphenylamine group.

In one embodiment of the present specification, at least one of R1 and R2 is a substituted or unsubstituted alkyl group; a substituted or unsubstituted silyl group; a substituted or unsubstituted amine group; a substituted or unsubstituted aryl group; or a substituted or unsubstituted heteroaryl group.

In one embodiment of the present specification, at least one of R1 and R2 is an alkyl group having 1 to 10 carbon atoms; a silyl group substituted with an alkyl group having 1 to 10 carbon atoms; an amine group substituted with an aryl group having 6 to 20 carbon atoms; an aryl group having 6 to 20 carbon atoms substituted with an amine group substituted with an aryl group having 6 to 20 carbon atoms; or a heteroaryl group having 2 to 20 carbon atoms.

In one embodiment of the present specification, at least one of R1 and R2 is a methyl group; a tert-butyl group; a trimethylsilyl group; a carbazole group; a phenoxazine group; or a phenyl group substituted with a diphenylamine group.

In one embodiment of the present specification, at least one of R1 and R2 is a substituted or unsubstituted alkyl group; a substituted or unsubstituted silyl group; a substituted or unsubstituted amine group; a substituted or unsubstituted aryl group; or a substituted or unsubstituted heteroaryl group, and the other one is hydrogen.

In one embodiment of the present specification, at least one of R1 and R2 is an alkyl group having 1 to 10 carbon atoms; a silyl group substituted with an alkyl group having 1 to 10 carbon atoms; an amine group substituted with an aryl group having 6 to 20 carbon atoms; an aryl group having 6 to 20 carbon atoms substituted with an amine group substituted with an aryl group having 6 to 20 carbon atoms; or a heteroaryl group having 2 to 20 carbon atoms, and the other one is hydrogen.

In one embodiment of the present specification, at least one of R1 and R2 is a methyl group; a tert-butyl group; a trimethylsilyl group; a carbazole group; a phenoxazine group; or a phenyl group substituted with a diphenylamine group, and the other one is hydrogen.

In one embodiment of the present specification, the compound of Chemical Formula 1 is selected from among the following structural formulae.

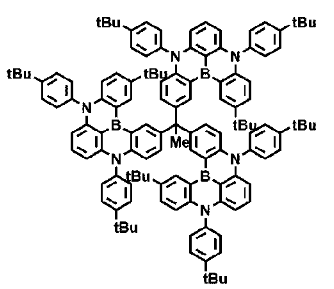
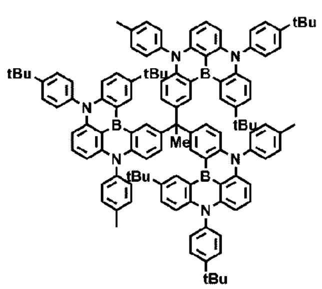
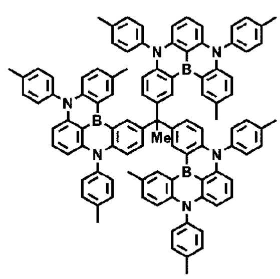

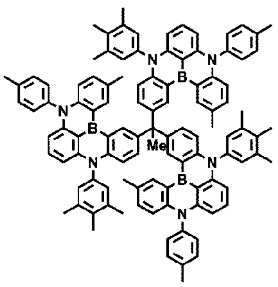

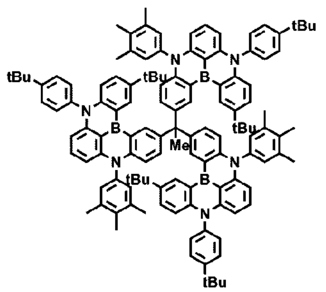

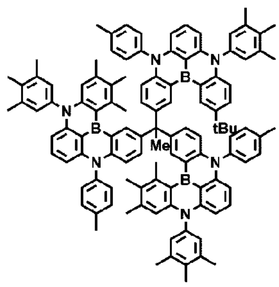

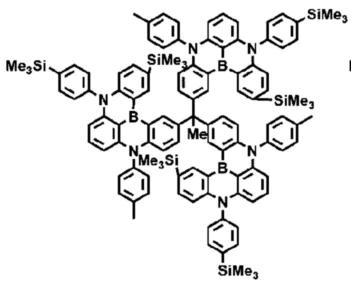

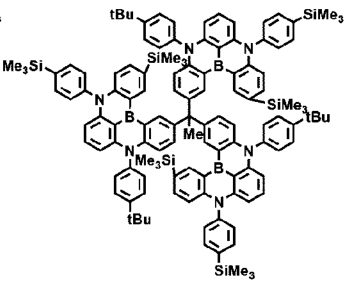

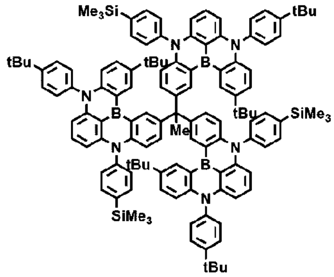

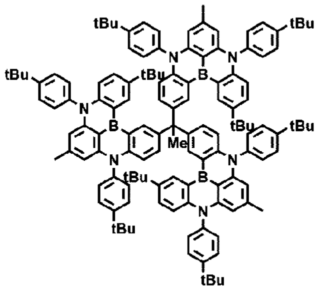

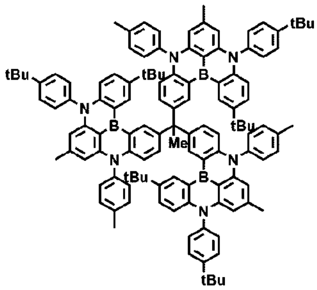

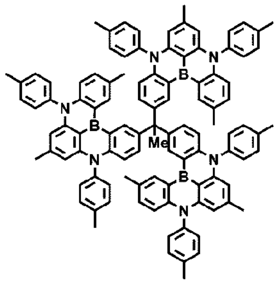

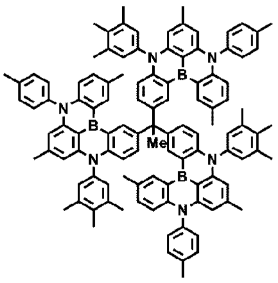

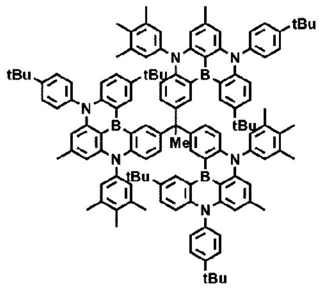

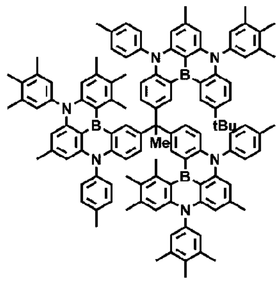

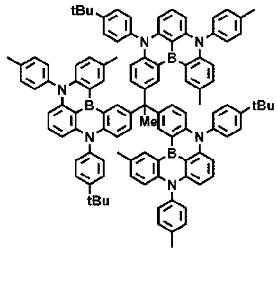

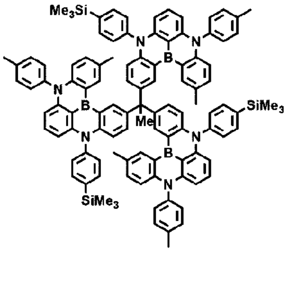

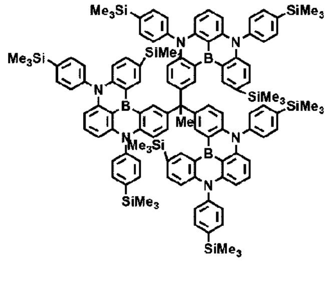

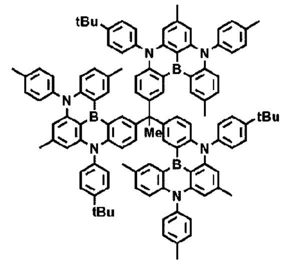
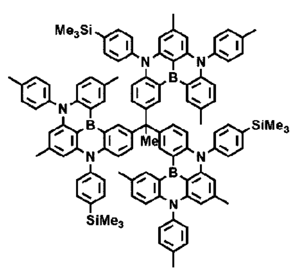
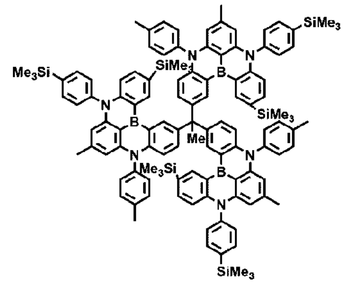

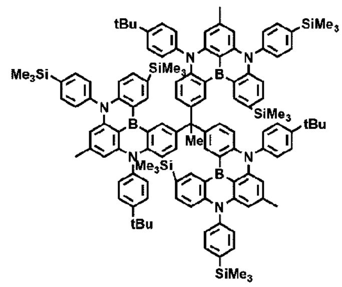
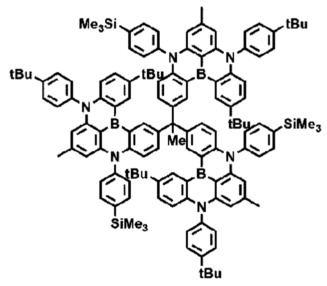
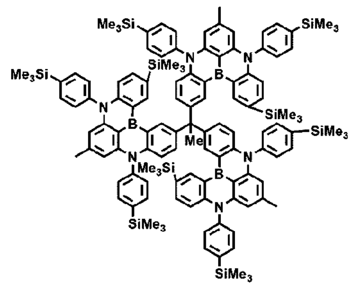

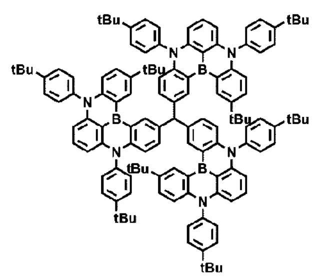
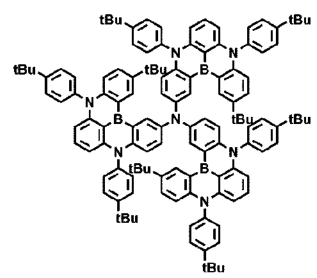
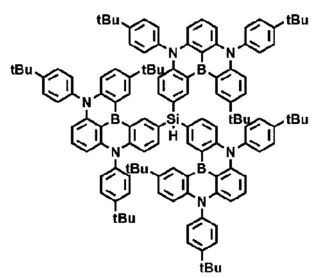

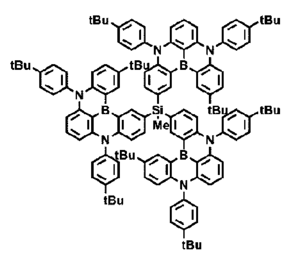
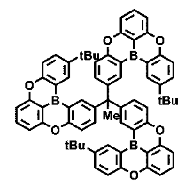
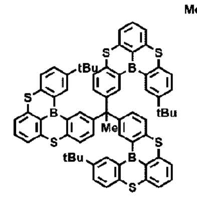
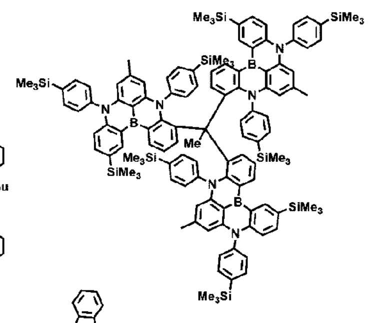

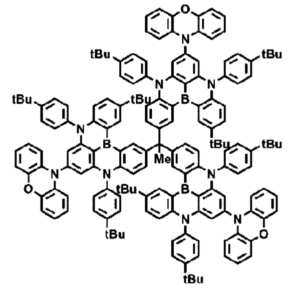
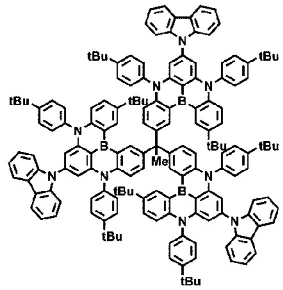
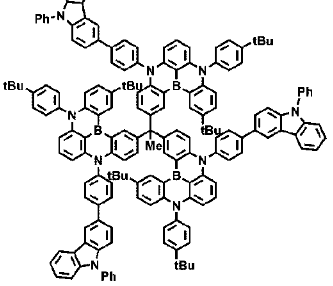

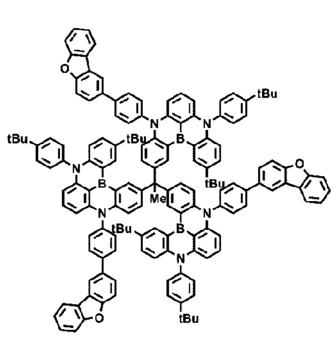

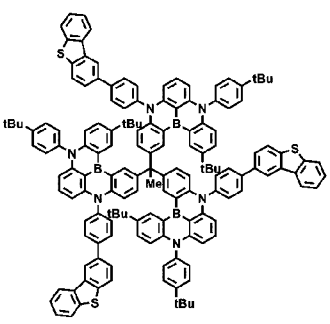

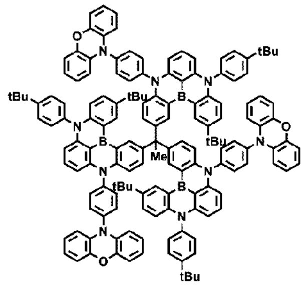

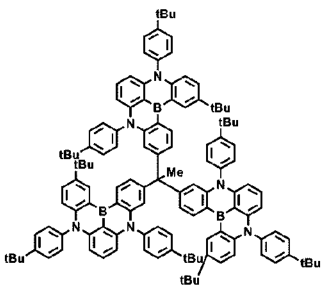

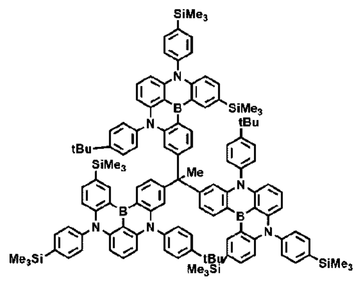

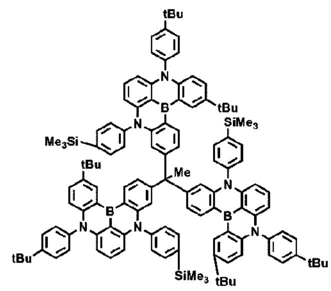

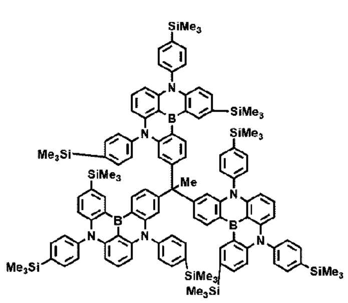

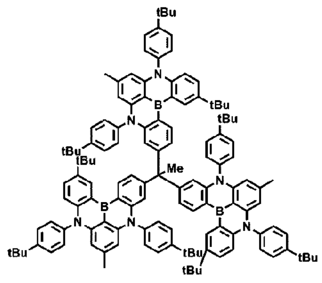

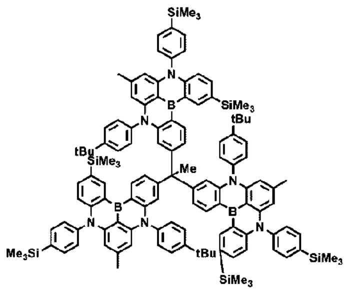

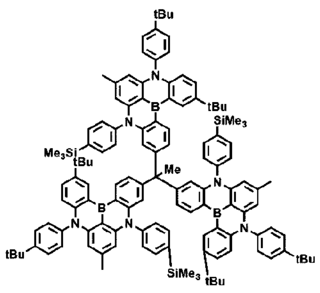

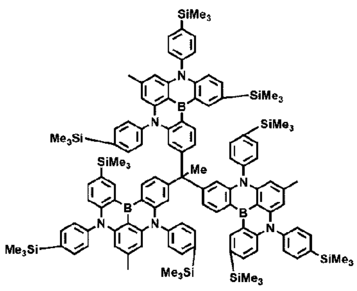

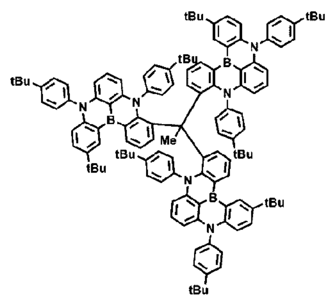

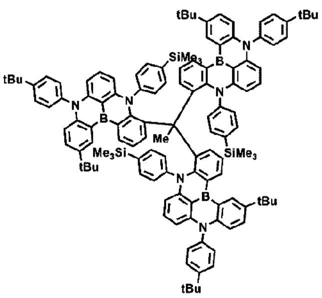

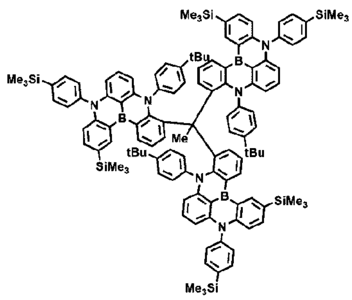

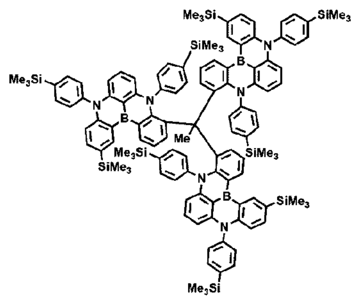

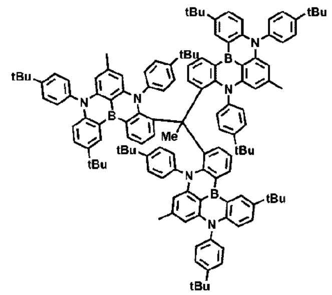
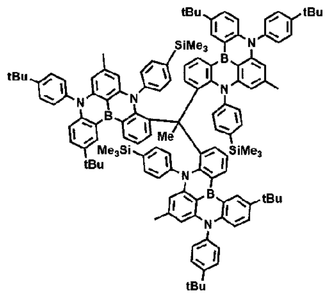
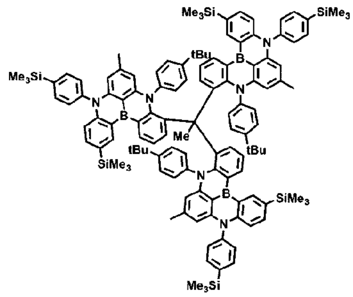

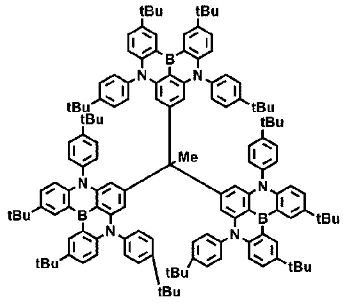
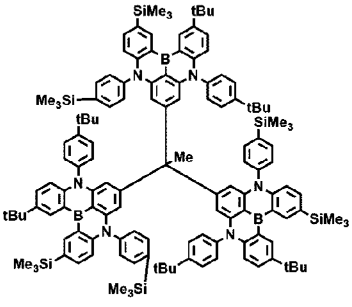
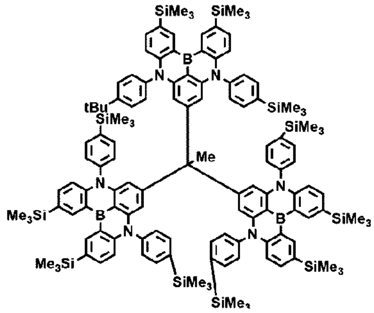

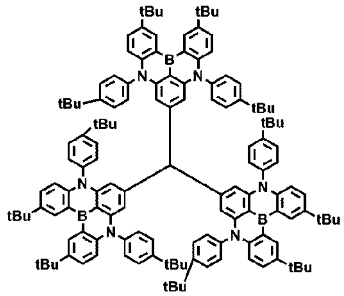
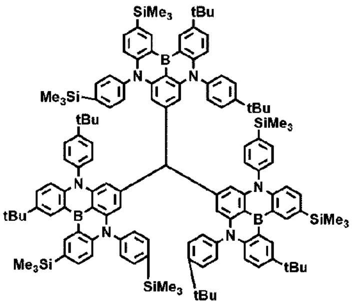
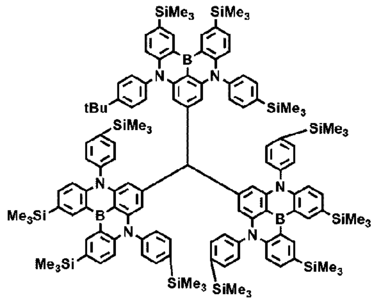

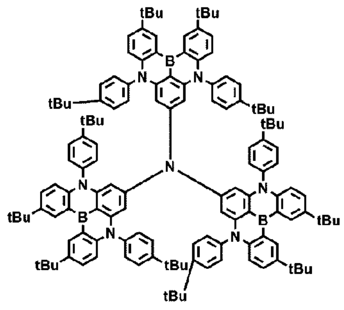
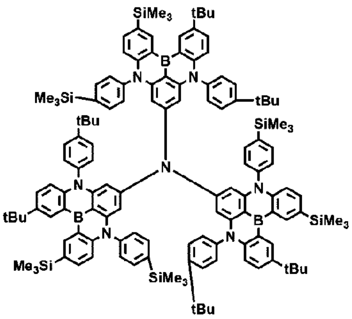
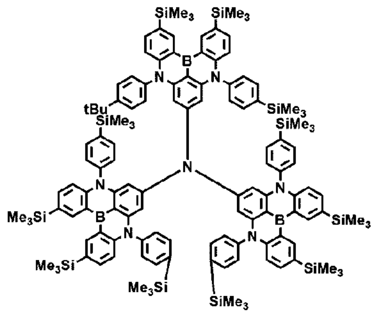

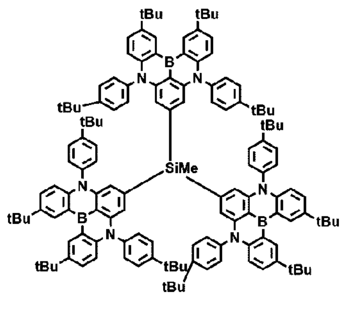
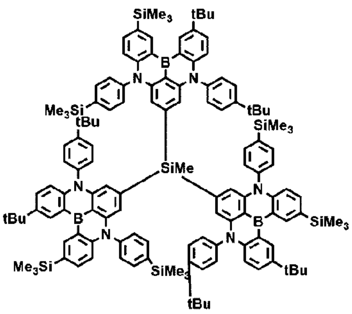
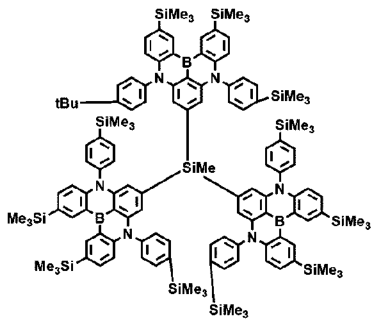

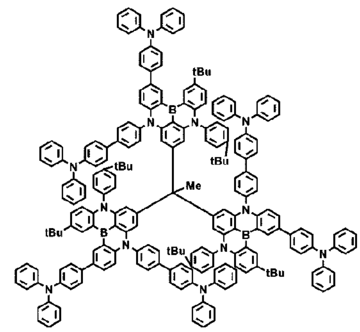

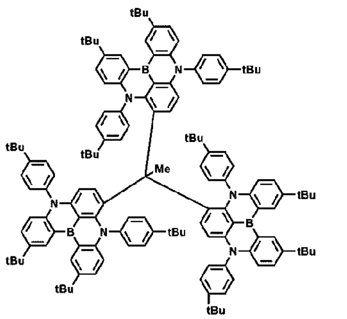

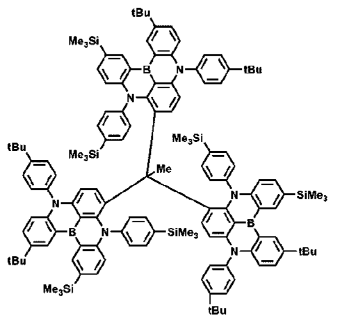

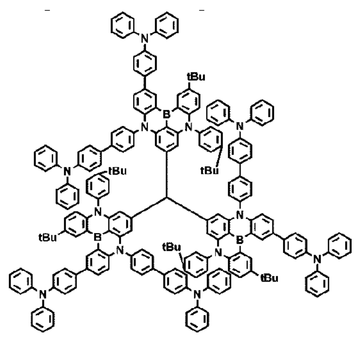

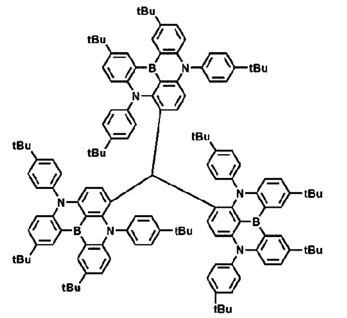

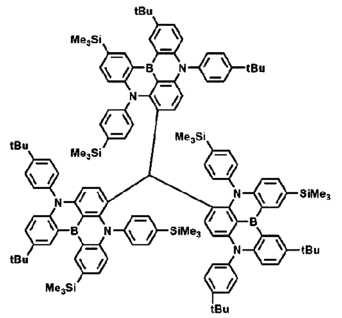

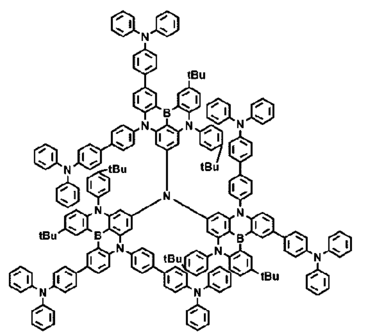

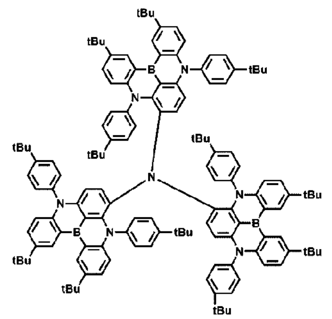

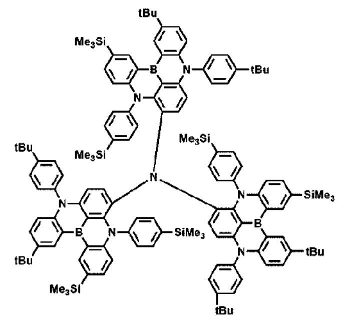

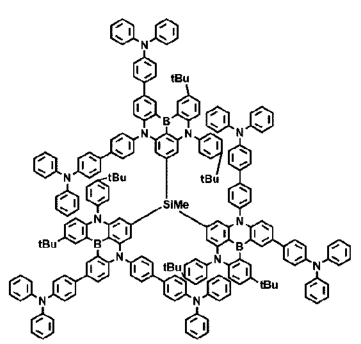

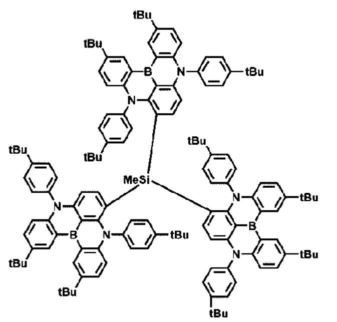

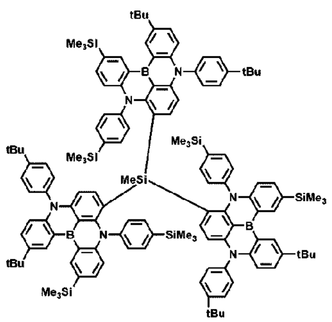

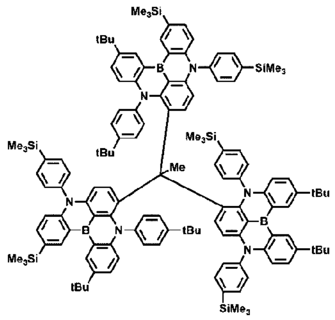
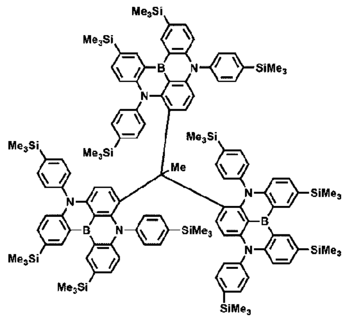
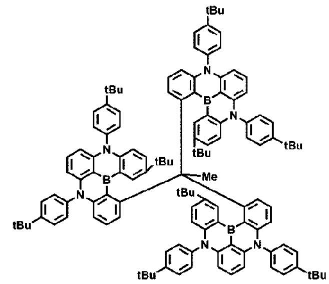
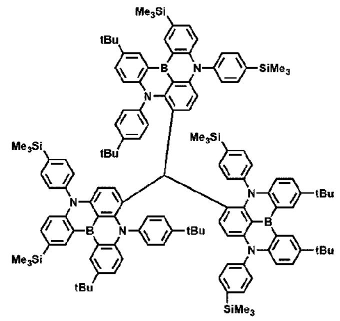
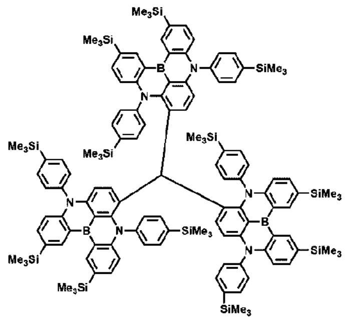
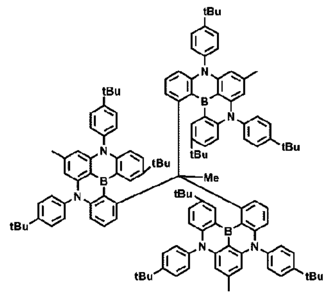
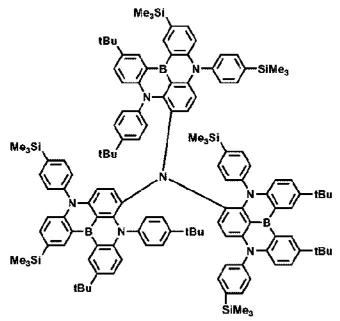
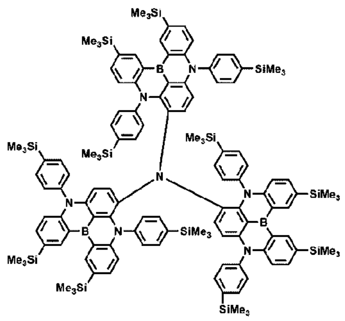
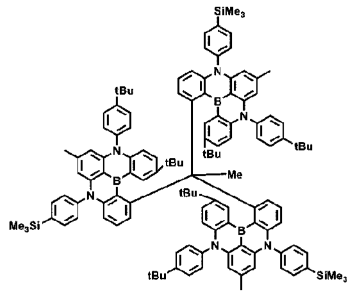
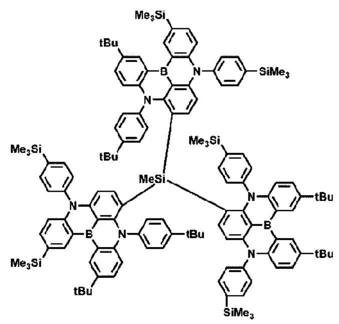
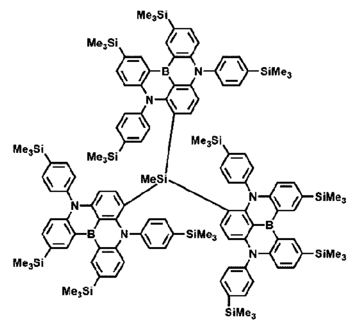
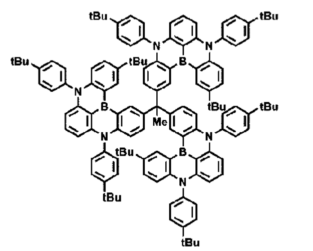
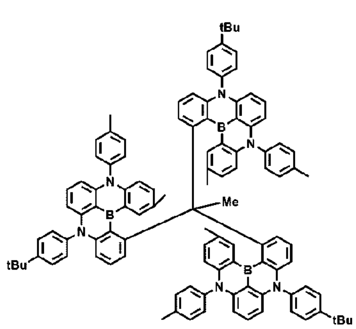
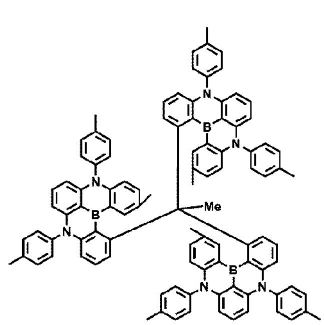
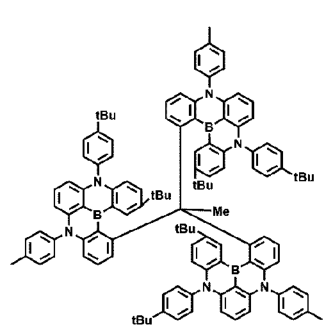

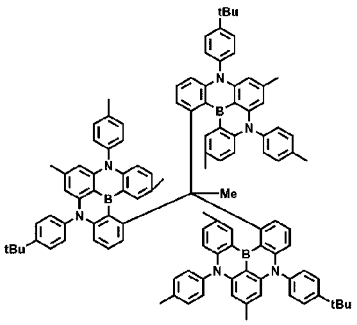
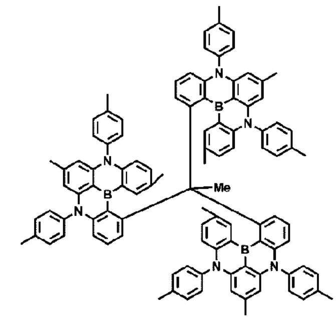
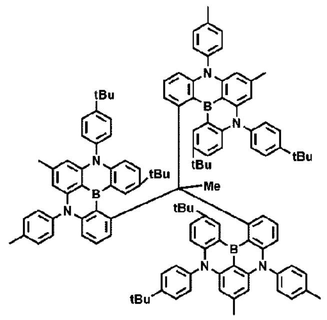

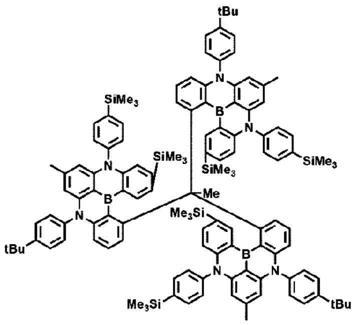
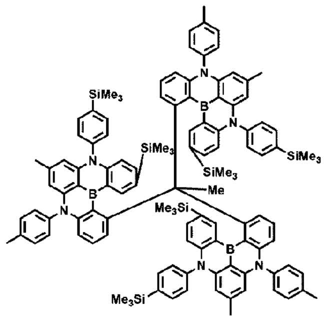
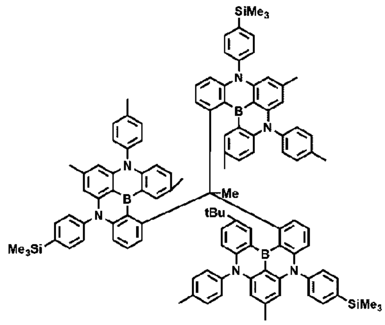

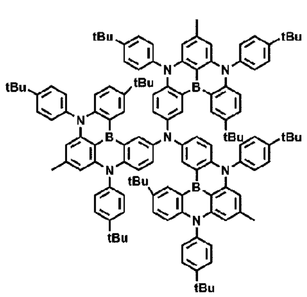
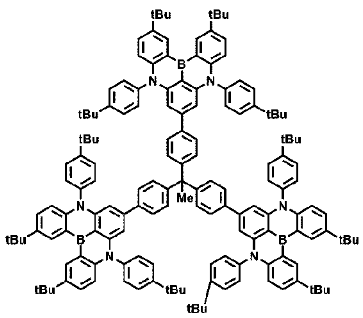

In the structural formulae of the present specification, Ph means a phenyl group, Me means a methyl group, and tBu means a tert-butyl group.

In one embodiment of the present specification, when L is

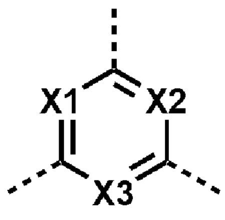
,

L1 is a direct bond.

In one embodiment of the present specification, Chemical Formula 1 may be represented by the following Chemical Formula 10.

[Chemical Formula 10]

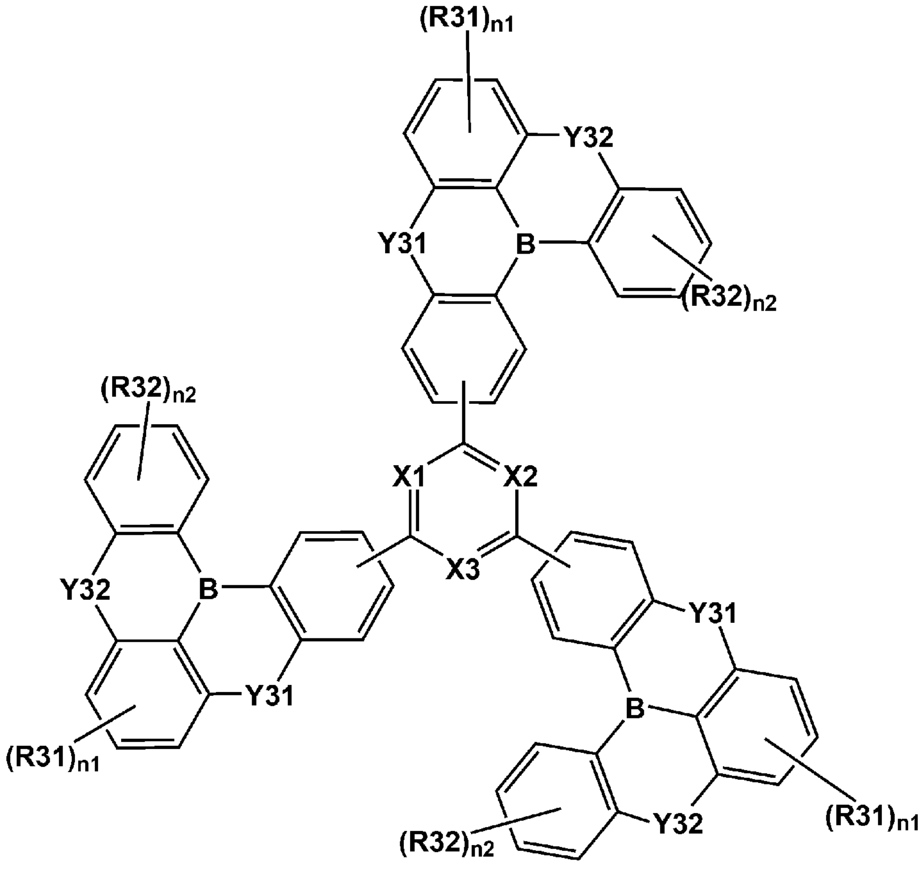

In Chemical Formula 10,

Y31 and Y32 are each independently N(R33), O or S, X1 to X3 are each independently CH or N,
when X1 to X3 are CH, at least one of Y31 and Y32 is N(R33) or S,
R31, R32 and R33 are each independently hydrogen; deuterium; halogen; cyano; substituted or unsubstituted $C_{1-60}$ alkyl; substituted or unsubstituted $C_{1-60}$ alkoxy; substituted or unsubstituted $C_{2-60}$ alkenyl; substituted or unsubstituted $C_{2-60}$ alkynyl; substituted or unsubstituted $C_{3-60}$ cycloalkyl; substituted or unsubstituted $C_{6-60}$ aryl; substituted or unsubstituted $C_{2-60}$ heteroaryl including any one or more heteroatoms selected from the group consisting of N, O and S; substituted or unsubstituted tri ($C_{1-60}$ alkyl) silyl; or substituted or unsubstituted tri ($C_{6-60}$ aryl) silyl,
n1s are each independently an integer of 1 to 3, and
n2s are each independently an integer of 1 to 4.

In one embodiment of the present specification, in Chemical Formula 10, Y31s are preferably the same as each other and Y32s are preferably the same as each other.
In one embodiment of the present specification, in Chemical Formula 10, X1 to X3 are preferably the same as each other.
In one embodiment of the present specification, in Chemical Formula 10, when X1 to X3 are CH, at least one of Y1 and Y2 is preferably N(R33) or S.
In one embodiment of the present specification, in Chemical Formula 10, when X1 to X3 are CH, at least one of Y1 and Y2 is preferably N(R33).
In one embodiment of the present specification, in Chemical Formula 10, X1 to X3 are preferably N.
In one embodiment of the present specification, in Chemical Formula 10, R31 and R32 are each independently preferably hydrogen or $C_{1-10}$ alkyl.
In one embodiment of the present specification, in Chemical Formula 10, R31 and R32 are each independently preferably hydrogen, methyl or tert-butyl.
In one embodiment of the present specification, in Chemical Formula 10, Y31 and Y32 are preferably N(R33).
In one embodiment of the present specification, in Chemical Formula 10, R33s are each independently preferably hydrogen or phenyl, and the phenyl is unsubstituted or substituted with $C_{1-10}$ alkyl, $C_{1-10}$ alkoxy, tri ($C_{1-10}$ alkyl) silyl, 9-phenyl-carbazolyl or carbazol-9-yl.

In one embodiment of the present specification, in Chemical Formula 10, R33s are each independently preferably hydrogen or phenyl, and the phenyl is unsubstituted; or substituted with methyl, tert-butyl, methoxy, trimethylsilyl, tri(isopropyl)silyl, 9-phenyl-carbazolyl or carbazol-9-yl.

In one embodiment of the present specification, Chemical Formula 10 may be represented by any one of the following Chemical Formulae 10-1 to 10-3.

[Chemical Formula 10-1]

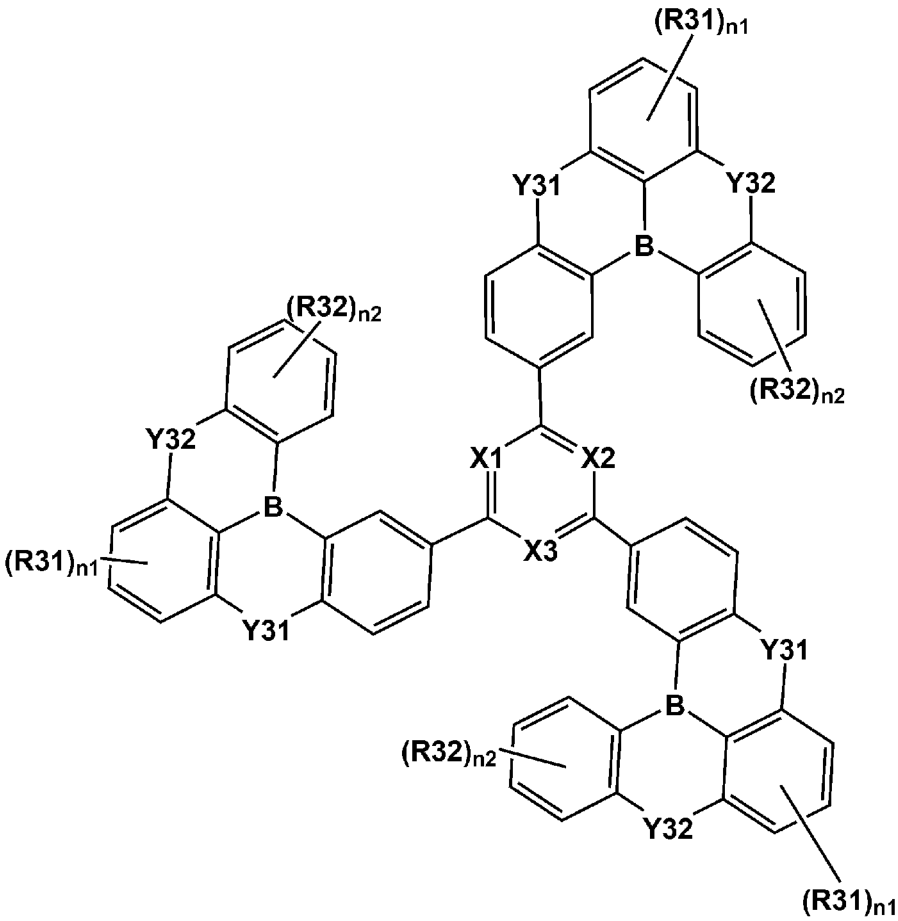

[Chemical Formula 10-2]

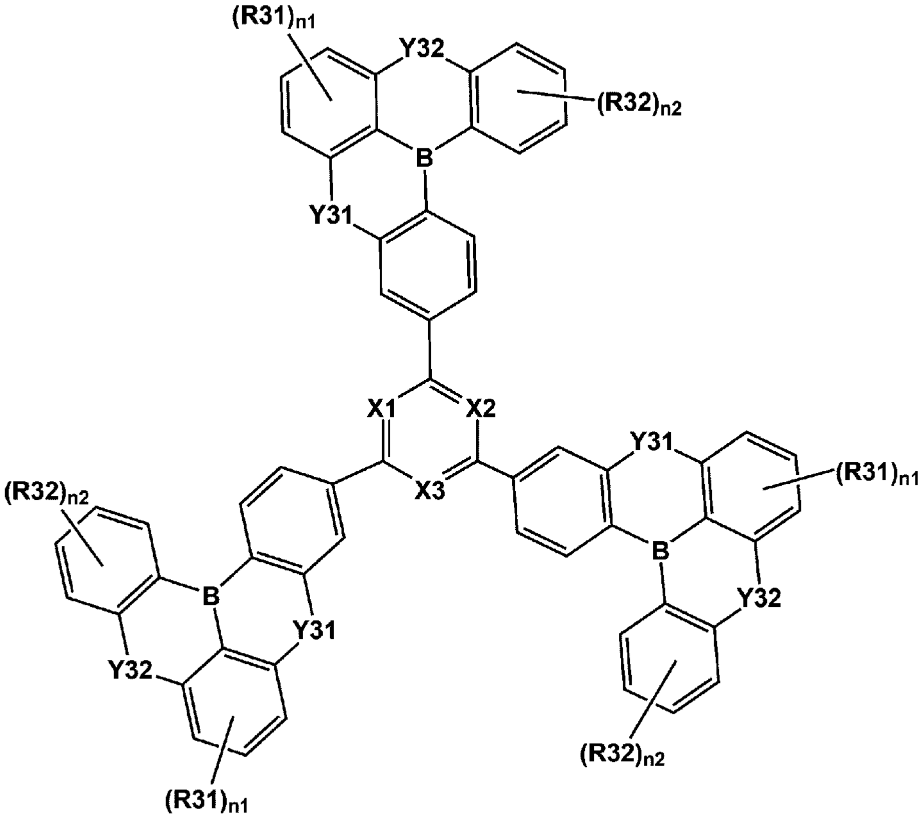

[Chemical Formula 10-3]

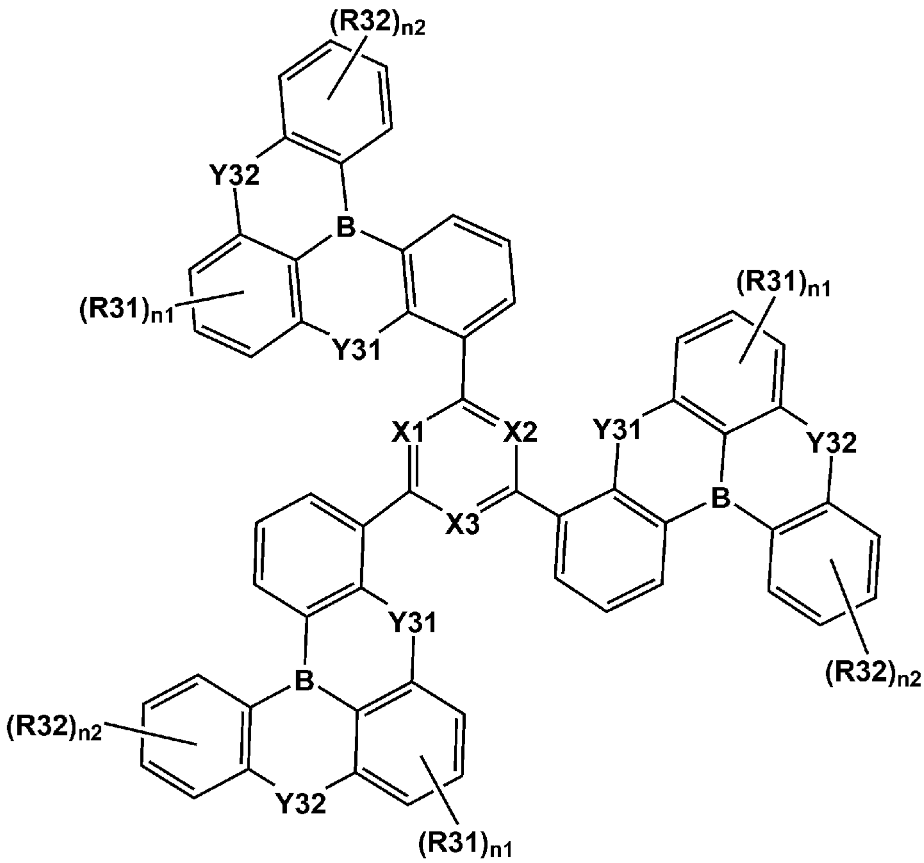

In Chemical Formulae 10-1 to 10-3,
X1 to X3, Y31, Y32, R31, R32, n1 and n2 have the same definitions as in Chemical Formula 10.

In one embodiment of the present specification, Chemical Formula 10 is preferably Chemical Formula 10-1 or 10-3.

In one embodiment of the present specification, the compound of Chemical Formula 1 is selected from among the following structural formulae.

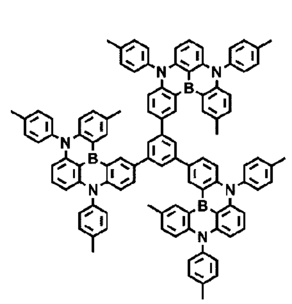

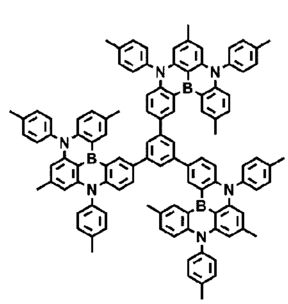

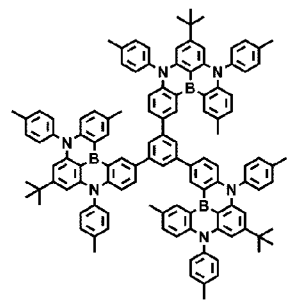

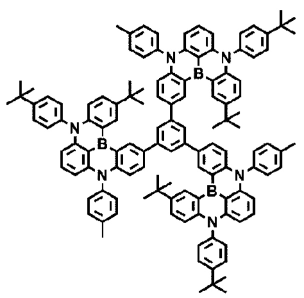

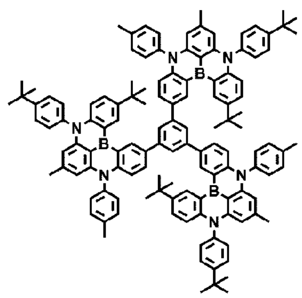

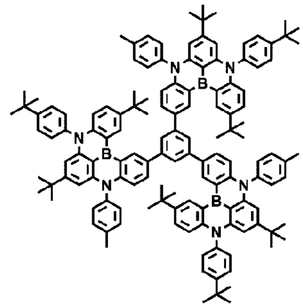

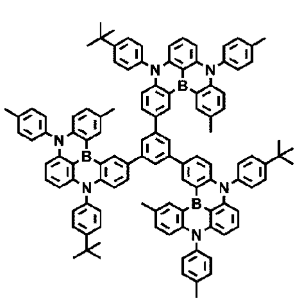
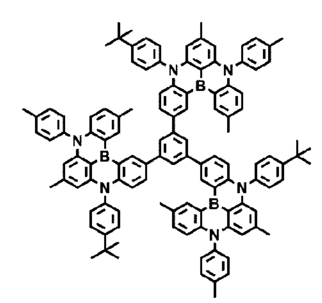
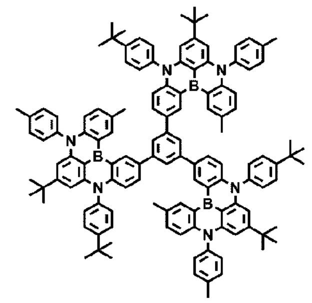

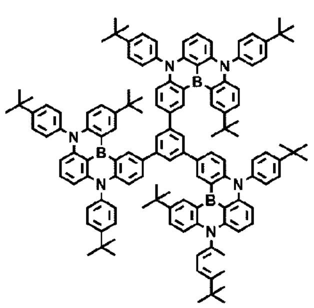
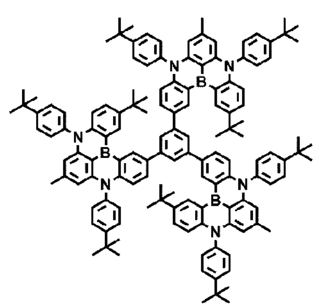
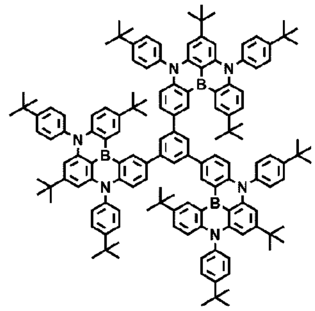

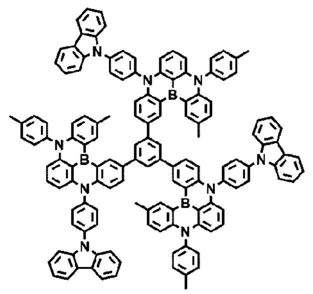
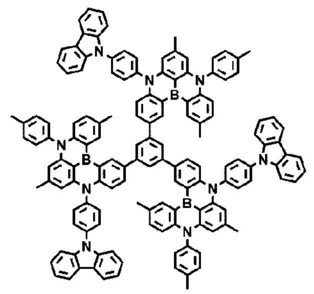
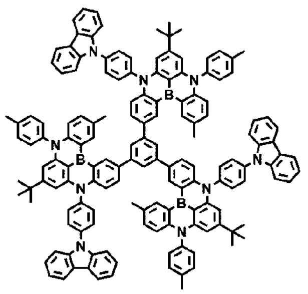

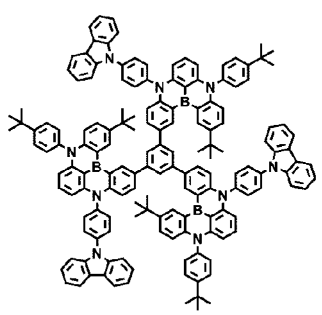
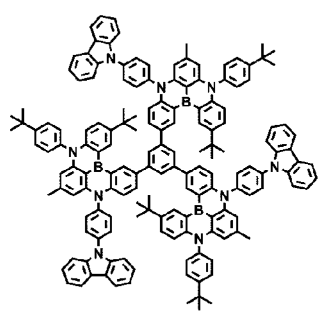
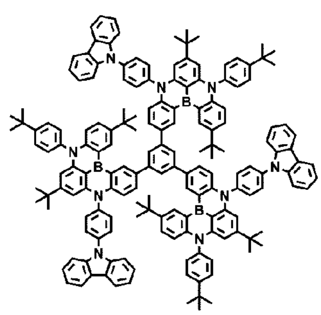

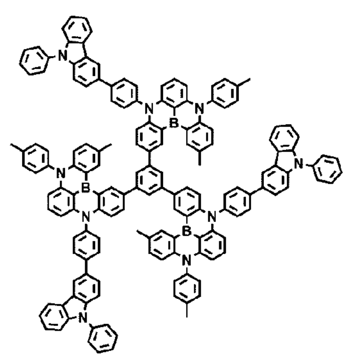
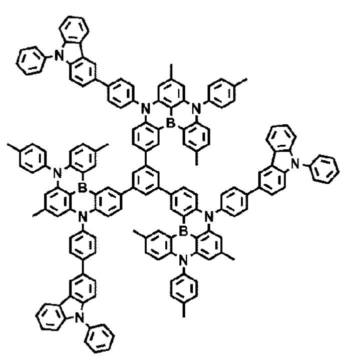
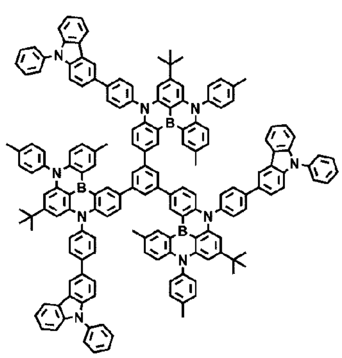

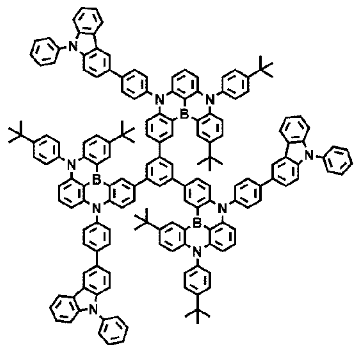
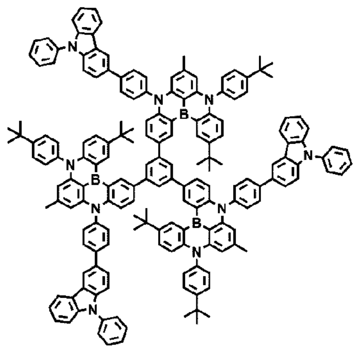
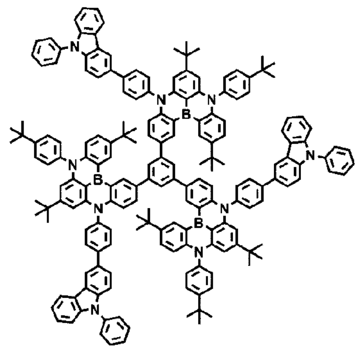

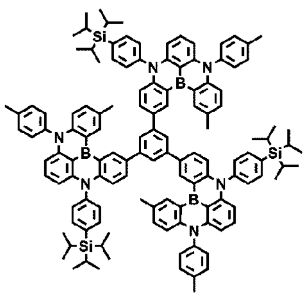
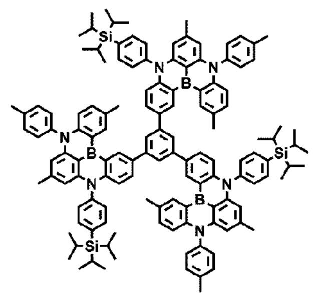
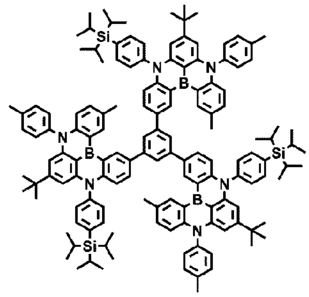

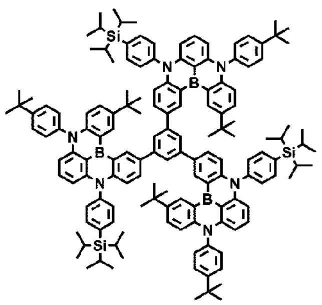
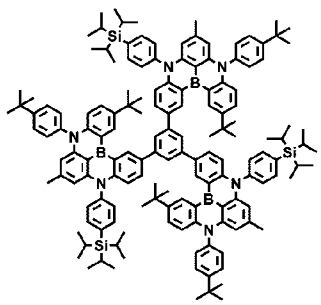
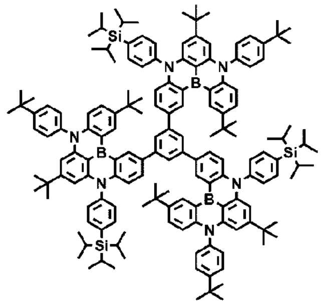

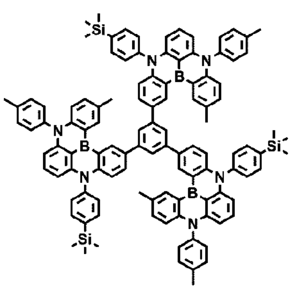
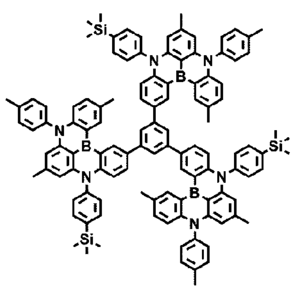
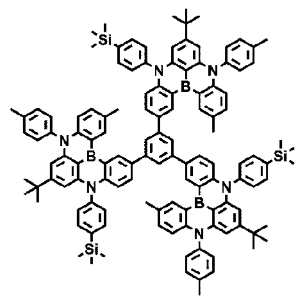

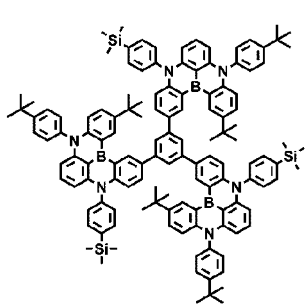
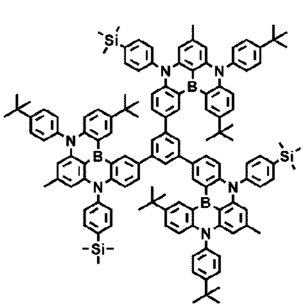
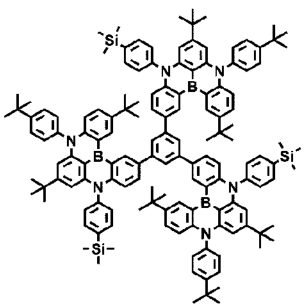

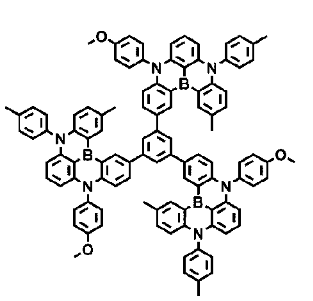
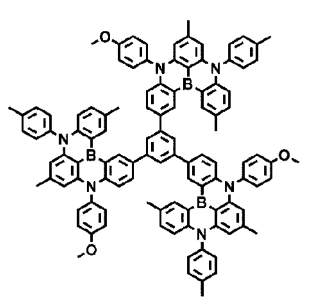
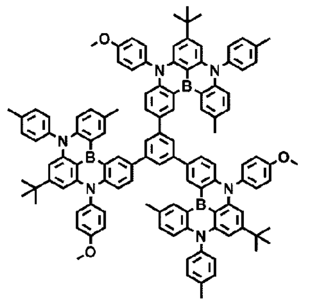

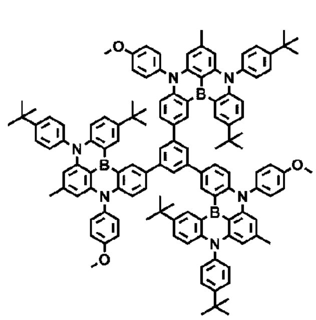
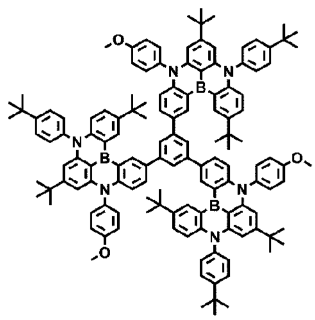
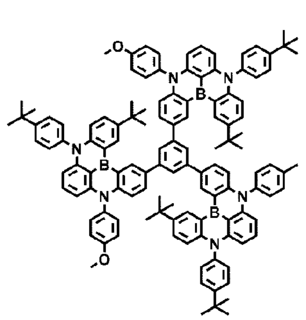

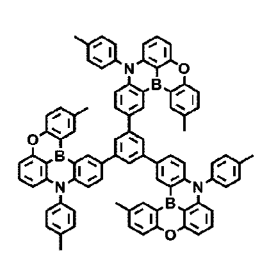
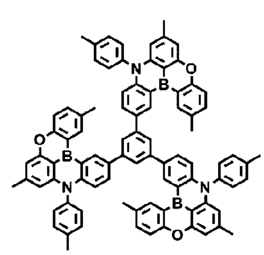
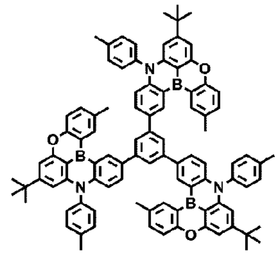

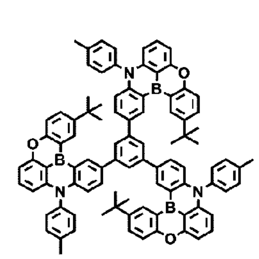
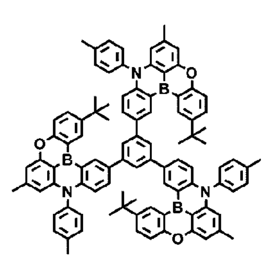
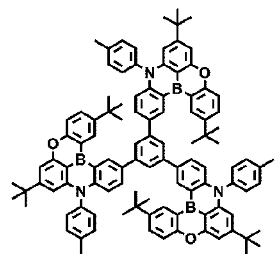

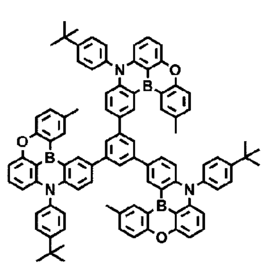
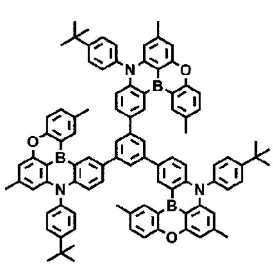
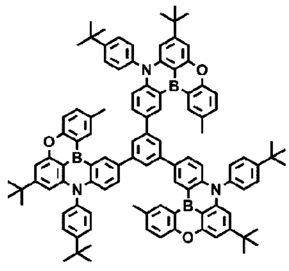

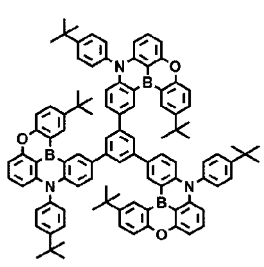
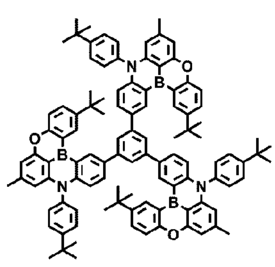
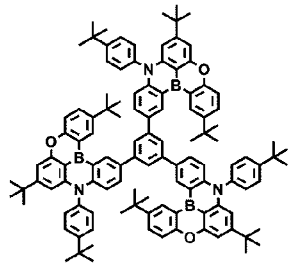

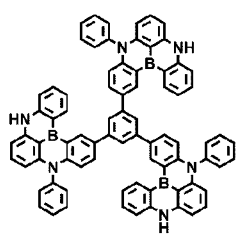
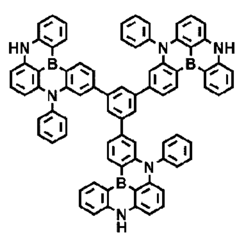
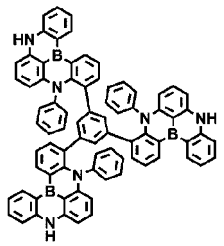

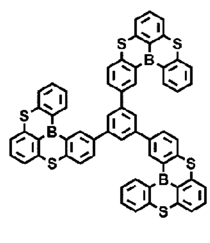
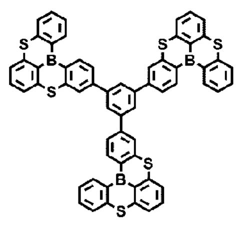
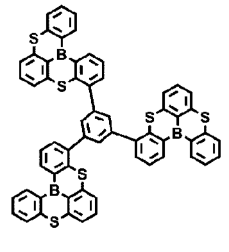

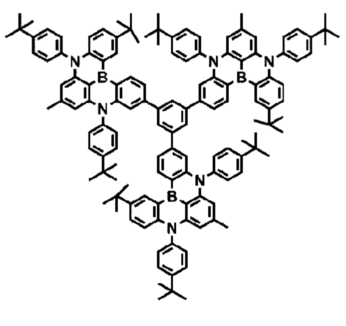
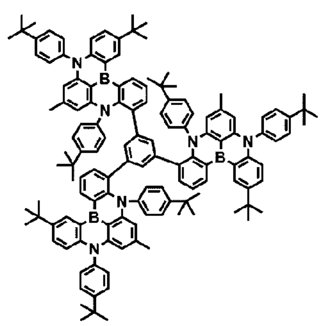

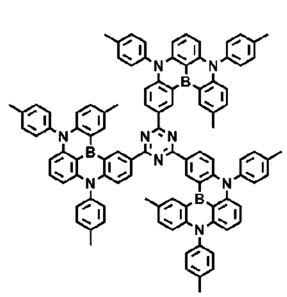
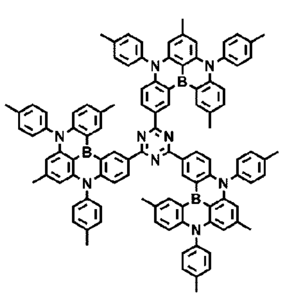
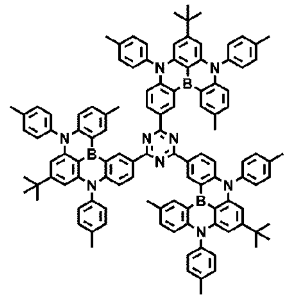

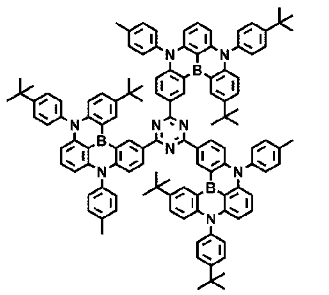
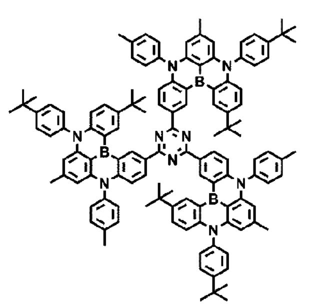
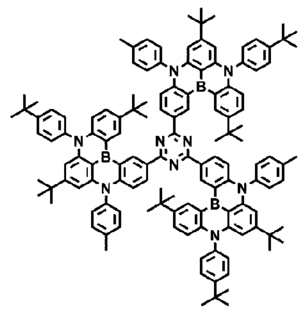

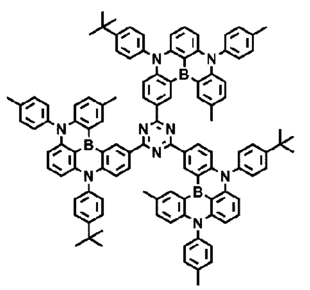
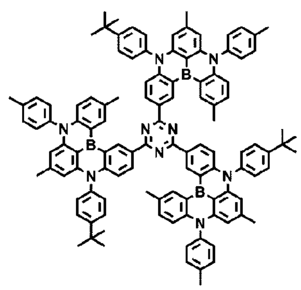
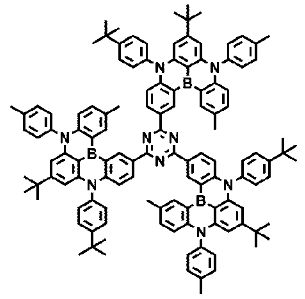

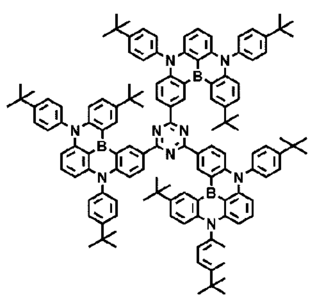
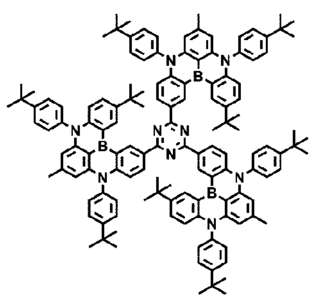
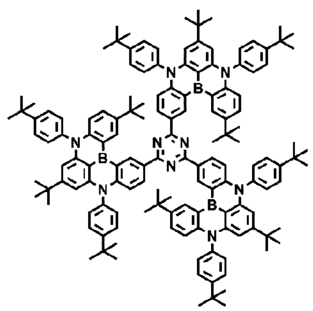

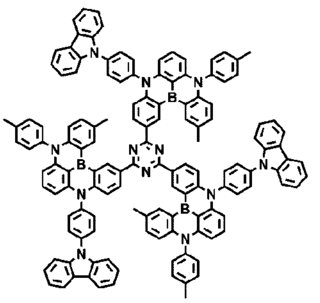
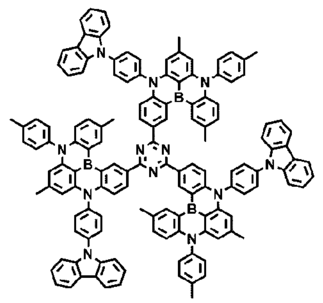
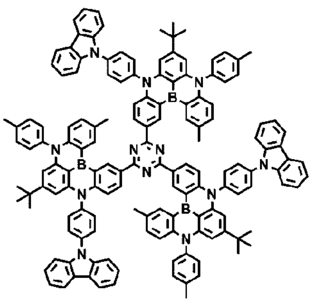

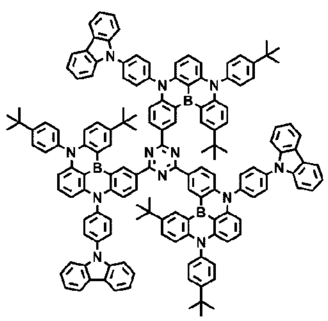
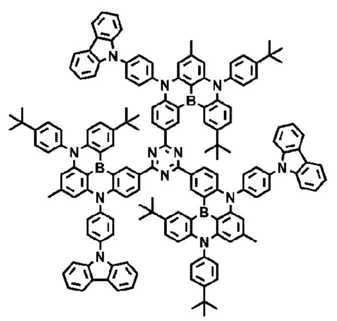
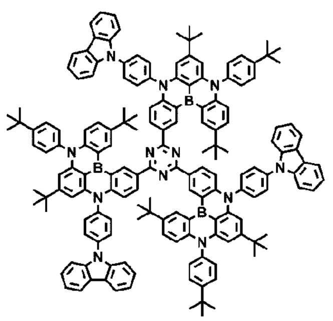

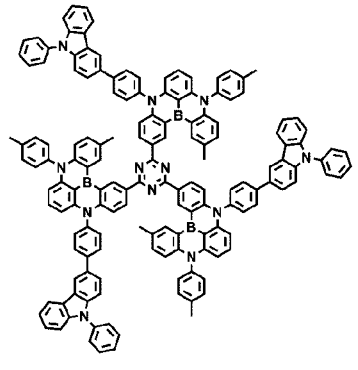

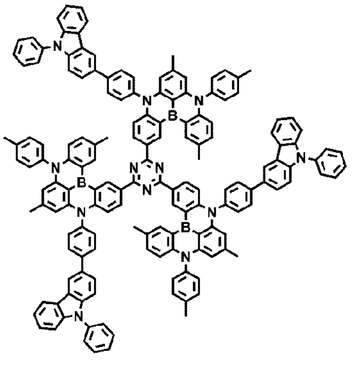

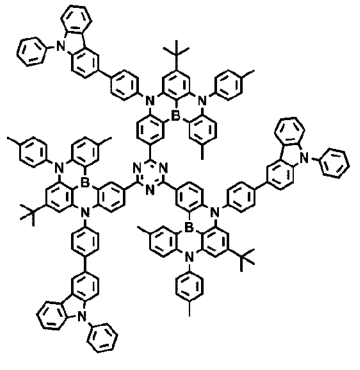

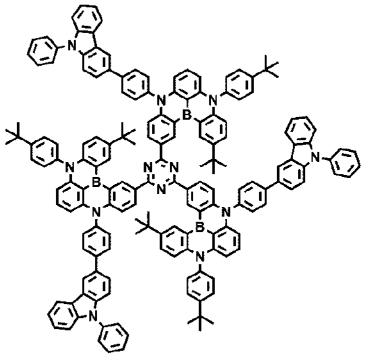

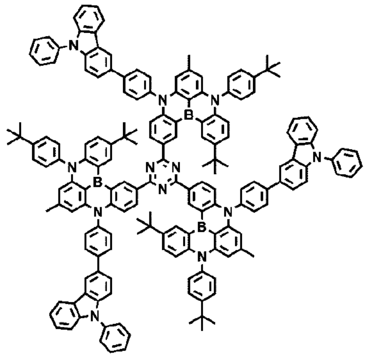

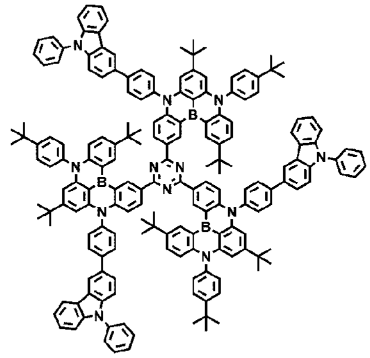

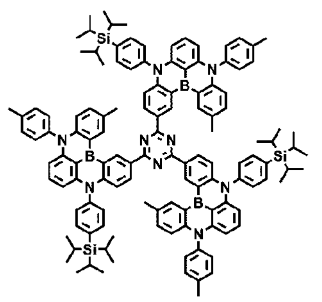

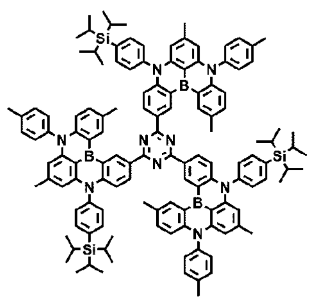

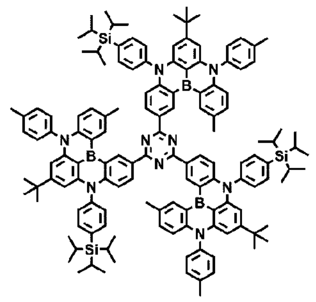

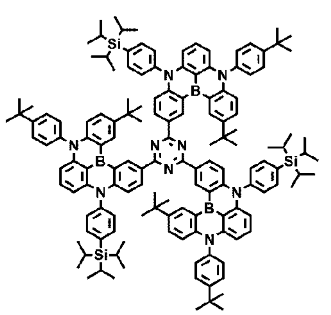

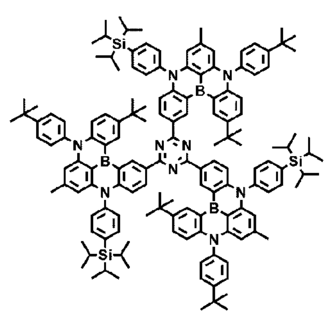

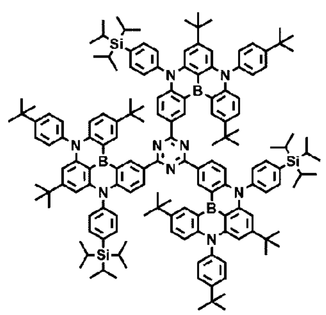

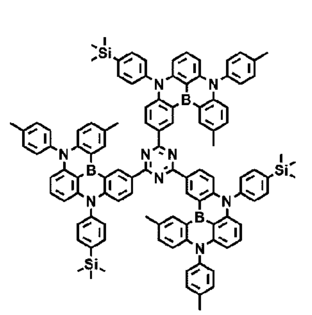

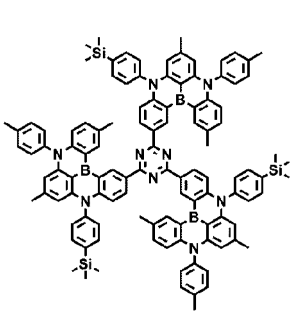

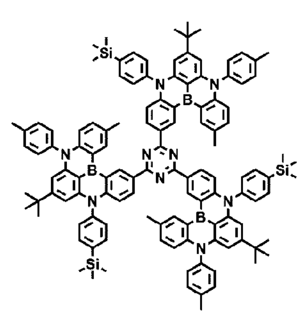

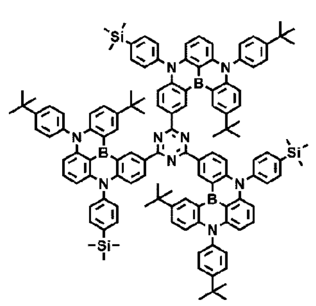
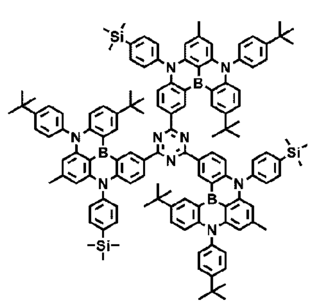
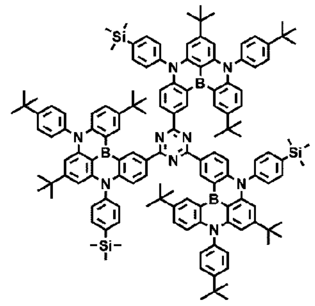

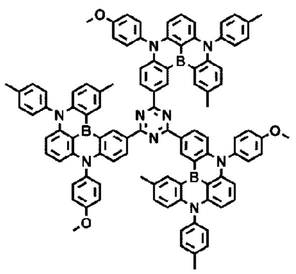
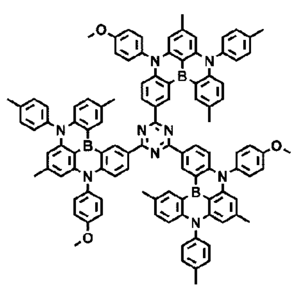
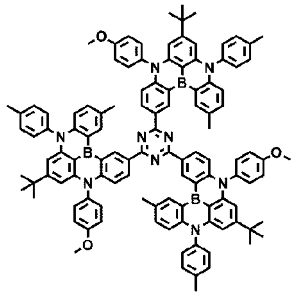

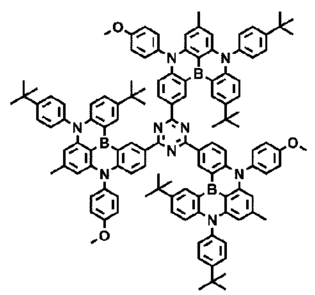
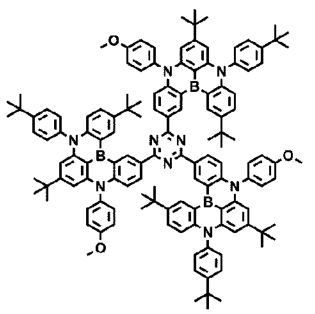
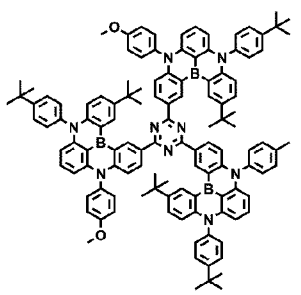

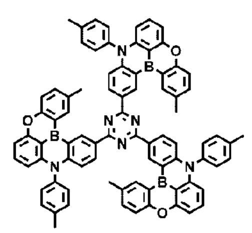
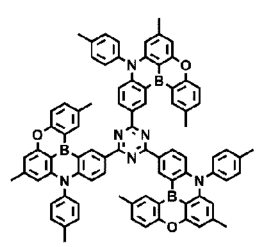
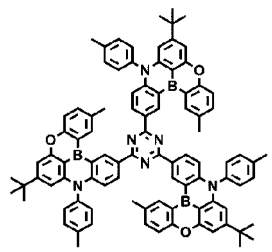

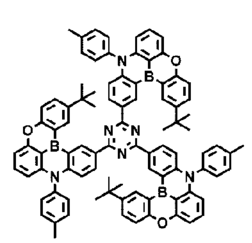
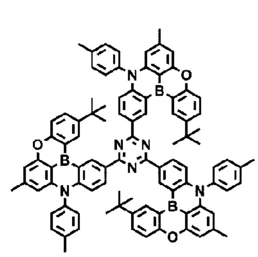
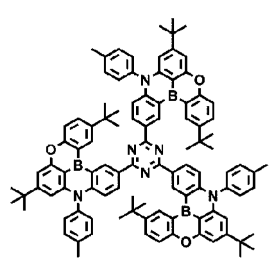

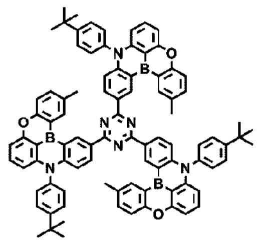
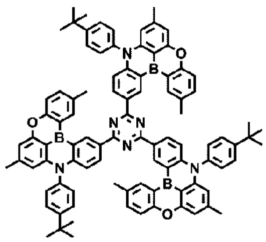
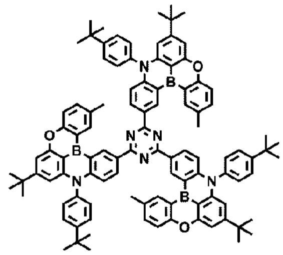

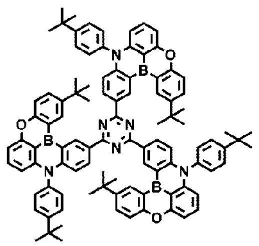
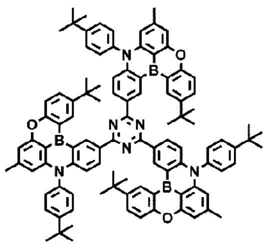
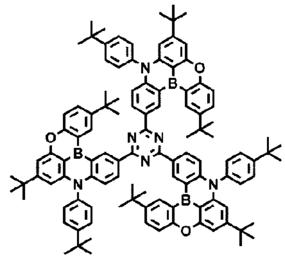

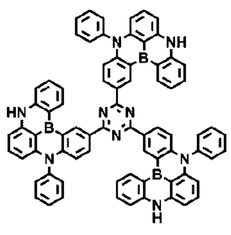
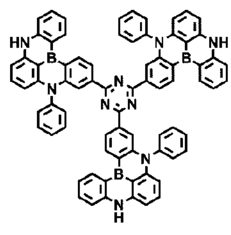
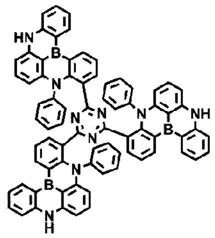

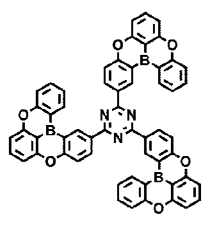
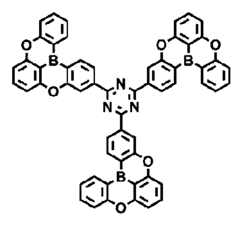
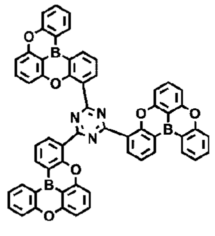

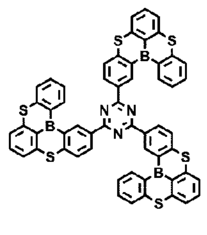
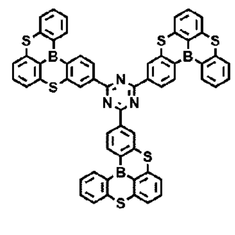
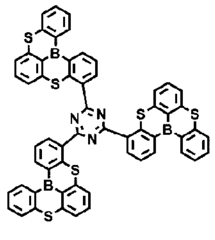

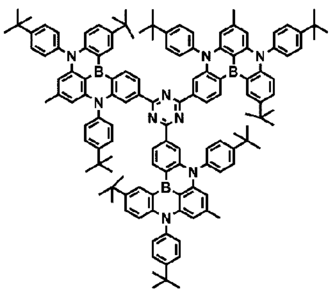
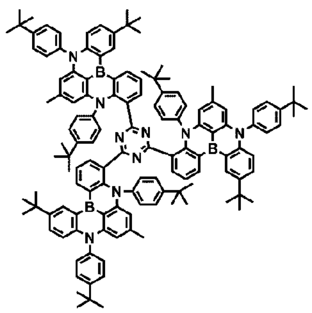
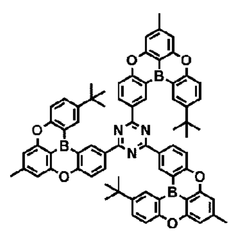

The compound according to one embodiment of the present application may be prepared using preparation methods to describe later.

For example, the compound of Chemical Formula 1 may be prepared as in the following Reaction Formulae 1 and 2. Substituents may bond using methods known in the art, and types, positions and the number of the substituents may vary depending on technologies known in the art.

[Reaction Formula 1]

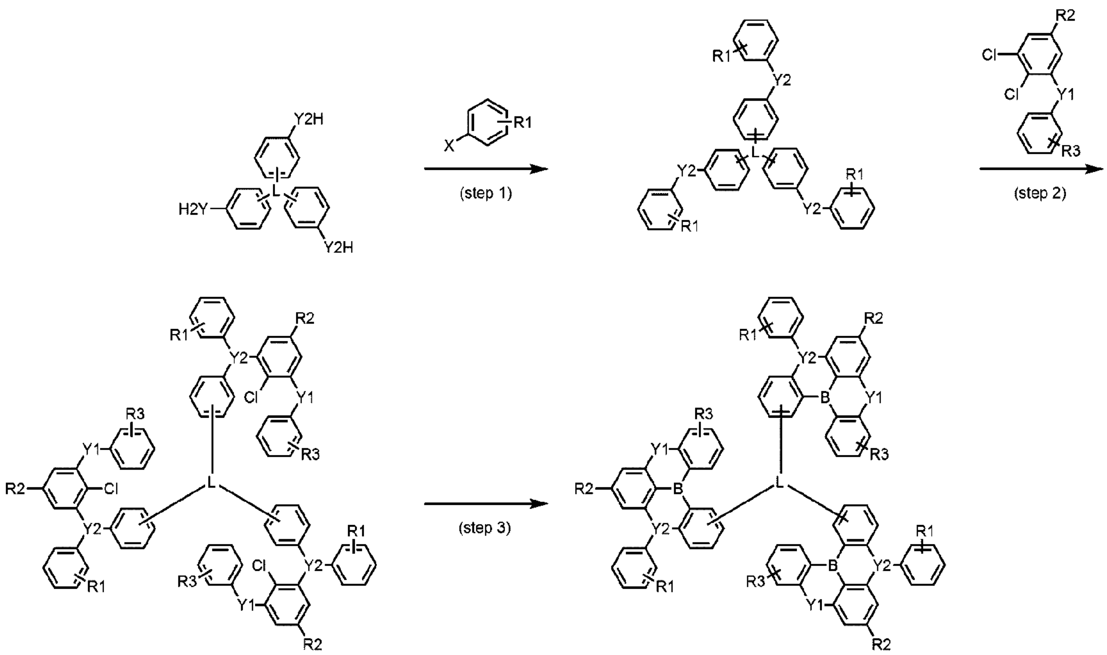


[Reaction Formula 2]

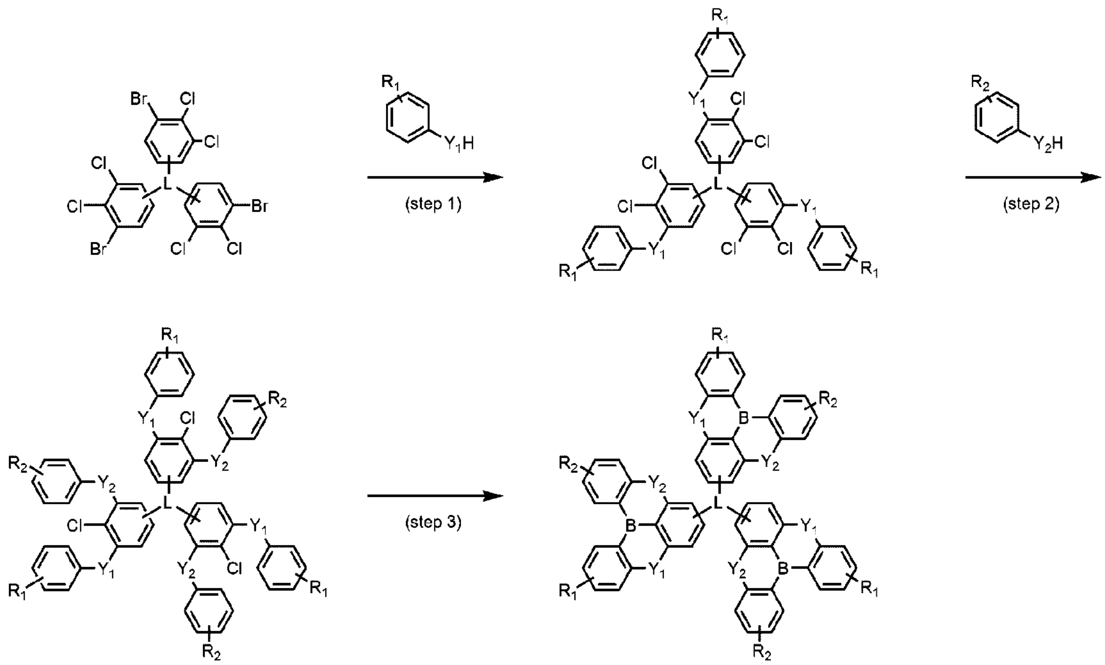


In Reaction Formulae 1 and 2,

Y1, Y2 and L have the same definitions as in Chemical Formula 1,
$R_1$ to $R_3$ have the same definitions as R1 and R2 of Chemical Formula 1, and
X is a halogen group.

Meanwhile, one embodiment of the present disclosure provides a method for preparing the compound represented by Chemical Formula 10 such as the following Reaction Formula 3:

[Reaction Formula 3]

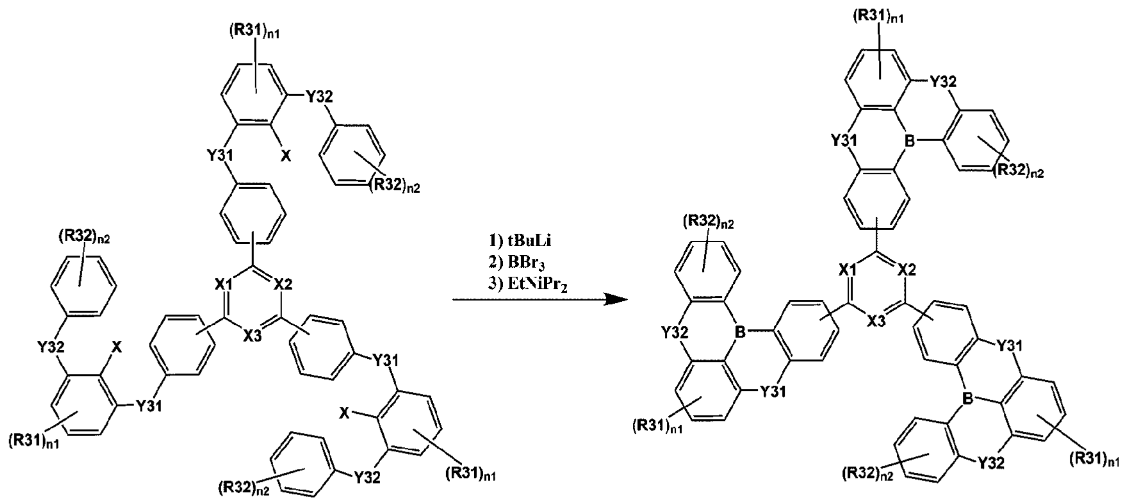


In Reaction Formula 3, the rest other than X have the same definitions as above, and X is halogen and more preferably chloro or bromo. The preparation method may be more specified in preparation examples to describe later.

In addition, one embodiment of the present specification provides an organic light emitting device including the compound described above.

One embodiment of the present specification provides a composition including the compound of Chemical Formula 1.

In one embodiment of the present specification, the composition including the compound is a coating composition for an organic light emitting device.

In one embodiment of the present specification, the coating composition may be a liquid phase. The "liquid phase" means being in a liquid state at room temperature and atmospheric pressure.

In one embodiment of the present specification, examples of the solvent may include chlorine-based solvents such as chloroform, methylene chloride, 1,2-dichloroethane, 1,1,2-trichloroethane, chlorobenzene or o-dichlorobenzene; ether-based solvents such as tetrahydrofuran or dioxane; aromatic hydrocarbon-based solvents such as toluene, xylene, trimethylbenzene or mesitylene; aliphatic hydrocarbon-based solvents such as cyclohexane, methylcyclohexane, n-pentane, n-hexane, n-heptane, n-octane, n-nonane or n-decane; ketone-based solvents such as acetone, methyl ethyl ketone or cyclohexanone; ester-based solvents such as ethyl acetate, butyl acetate or ethyl cellosolve acetate; polyalcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin or 1,2-hexanediol, and derivatives thereof; alcohol-based solvents such as methanol, ethanol, propanol, isopropanol or cyclohexanol; sulfoxide-based solvents such as dimethyl sulfoxide; amide-based solvents such as N-methyl-2-pyrrolidone or N,N-dimethylformamide; benzoate-based solvents such as methyl benzoate, butyl benzoate or 3-phenoxybenzoate; tetraline, and the like, however, the solvent is not limited thereto as long as it is a solvent capable of dissolving or dispersing the compound according to one embodiment of the disclosure of the present application.

In another embodiment, the solvent may be used either alone as one type, or as a mixture of two or more solvent types.

In another embodiment, the solvent preferably has a boiling point of 40°C to 250°C and more preferably 60°C to 230°C, however, the boiling point is not limited thereto.

In another embodiment, viscosity of the single or mixed solvent is preferably from 1 CP to 10 CP and more preferably from 3 CP to 8 CP, but is not limited thereto.

In another embodiment, the coating composition preferably has a concentration of 0.1 wt/v% to 20 wt/v% and more preferably 0.5 wt/v% to 5 wt/v%, however, the concentration is not limited thereto.

In one embodiment of the present specification, the coating composition may further include one, two or more types of additives selected from the group consisting of thermal polymerization initiators and photopolymerization initiators.

Examples of the thermal polymerization initiator may include peroxides such as methyl ethyl ketone peroxide, methyl isobutyl ketone peroxide, acetylacetone peroxide, methylcyclohexanone peroxide, cyclohexanone peroxide, isobutyryl peroxide, 2,4-dichlorobenzoyl peroxide, bis-3,5,5-trimethyl hexanoyl peroxide, lauryl peroxide, benzoyl peroxide, p-chlorobenzoyl peroxide, dicumyl peroxide, 2,5-dimethyl-2,5-(t-butyloxy)-hexane, 1,3-bis(t-butylperoxy-isopropyl)benzene, t-butyl cumyl peroxide, di-t-butyl peroxide, 2,5-dimethyl-2,5-(di-t-butylperoxy)hexane-3, tris-(t-butylperoxy)triazine, 1,1-di-t-butylperoxy-3,3,5-trimethylcyclohexane, 1,1-di-t-butylperoxycyclohexane, 2,2-di(t-butylperoxy)butane, 4,4-di-t-butylperoxy valeric acid n-butyl ester, 2,2-bis(4,4-t-butylperoxycyclohexyl)propane, t-butyl peroxyisobutyrate, di-t-butyl peroxyhexahydroterephthalate, t-butylperoxy-3,5,5-trimethylhexate, t-butyl peroxybenzoate or di-t-butyl peroxytrimethyl adipate; or azo-based such as azobis isobutylnitrile, azobis dimethylvaleronitrile or azobis cyclohexyl nitrile, but are not limited thereto.

Examples of the photopolymerization initiator may include acetophenone-based or ketal-based photopolymerization initiators such as diethoxyacetophenone, 2,2-dimethoxy-1,2-diphenyl ethan-1-one, 1-hydroxy-cyclohexyl-phenyl-ketone, 4-(2-hydroxyethoxy)phenyl-(2-hydroxy-2-propyl)ketone, 2-benzyl-2-dimethylamino-1-(4-morpholinophenyl)butanone-1,2-hydroxy-2-methyl-1-phenylpropan-1-one, 2-methyl-2-morpholino(4-methylthiophenyl)propan-1-one or 1-phenyl-1,2-propanedion-2-(o-ethoxycarbonyl)oxime; benzoin ether-based photopolymerization initiators such as benzoin, benzoin methyl ether, benzoin ethyl ether, benzoin isobutyl ether or benzoin isopropyl ether; benzophenone-based photopolymerization initiators such as benzophenone, 4-hydroxybenzophenone, 2-benzoylnaphthalene, 4-benzoylbiphenyl, 4-benzoyl phenyl ether, acrylated benzophenone or 1,4-benzoylbenzene; thioxanthone-based photopolymerization initiators such as 2-isopropylthioxanthone, 2-chlorothioxanthone, 2,4-dimethylthioxanthone, 2,4-diethylthioxanthone or 2,4-dichlorothioxanthone; and, as other photopolymerization initiators, ethyl anthraquinone, 2,4,6-trimethylbenzoyldiphenylphosphine oxide, 2,4,6-trimethylbenzoylphenylethoxyphosphine oxide, bis(2,4,6-trimethylbenzoyl)phenylphosphine oxide, bis(2,4-dimethoxybenzoyl)-2,4,4-trimethylpentylphosphine oxide, methylphenylglyoxyester, 9,10-phenanthrene, acridine-based compounds, triazine-based compounds, imidazole-based compounds, and the like, but are not limited thereto. In addition, those having a photopolymerization facilitating effect may be used either alone or together with the photopolymerization initiator. Examples thereof may include triethanolamine, methyldiethanolamine, ethyl 4-dimethylaminobenzoate, isoamyl 4-dimethylaminobenzoate, (2-dimethylamino)ethyl benzoate, 4,4'-dimethylaminobenzophenone and the like, but are not limited thereto.

Another embodiment of the present specification provides an organic light emitting device formed using the coating composition.

In one embodiment of the present specification, the organic light emitting device includes a first electrode; a second electrode; and one or more organic material layers provided between the first electrode and the second electrode, wherein one or more layers of the organic material layers is formed using the coating composition including the compound of Chemical Formula 1.

In one embodiment of the present specification, the organic light emitting device includes a first electrode; a second electrode; and one or more organic material layers provided between the first electrode and the second electrode, wherein one or more layers of the organic material layers include the coating composition including the compound of Chemical Formula 1 or a cured material thereof.

In one embodiment of the present specification, a cured material of the coating composition is in a cured state by heat treating or light treating the coating composition.

In the present application, a description of a certain member being placed "on" another member includes not only a case of the one member in contact with the another member but a case of still another member being present between the two members.

In the present application, a description of a certain part "including" certain constituents means capable of further including other constituents, and does not exclude other constituents unless particularly stated on the contrary.

The organic material layer of the organic light emitting device of the present application may be formed in a single layer structure, but may be formed in a multilayer structure in which two or more organic material layers are laminated. For example, a typical example of the organic light emitting device of the present disclosure may have a structure including a hole injection layer, a hole transfer layer, a light emitting layer, an electron transfer layer, an electron injection layer, an electron injection and transfer layer and the like as the organic material layer. However, the structure of the organic light emitting device is not limited thereto, and may include a smaller number of organic material layers.

For example, structures of the organic light emitting device according to one embodiment of the present specification are illustrated in FIG. 1 and FIG. 2.

FIG. 1 illustrates a structure of the organic light emitting device in which an anode (2), a light emitting layer (3) and a cathode (4) are consecutively laminated on a substrate (1).

FIG. 2 illustrates a structure of the organic light emitting device in which an anode (2), a hole injection layer

(5), a hole transfer layer (6), a light emitting layer (3), an electron injection and transfer layer (7) and a cathode (4) are consecutively laminated on a substrate (1).

In FIG. 2, the hole injection layer (5), the hole transfer layer (6) or the light emitting layer (3) is formed using the coating composition including the compound represented by Chemical Formula 1.

FIG. 1 and FIG. 2 are for illustrative purposes only, and the organic light emitting device is not limited thereto.

In one embodiment of the present application, the organic material layer includes a light emitting layer, and the light emitting layer includes the coating composition or a cured material thereof.

In one embodiment of the present application, the light emitting layer is a blue light emitting layer.

In one embodiment of the present application, the light emitting layer has a maximum emission wavelength of 430 nm to 460 nm.

In one embodiment of the present application, the light emitting layer has a maximum absorption wavelength of 430 nm to 460 nm.

In one embodiment of the present application, the coating composition further includes a host material, and includes the compound and the host material in a weight ratio of 1:1 to 1:200.

In one embodiment of the present application, the coating composition further includes a host material, and the host material is represented by the following Chemical Formula A.

[Chemical Formula A]

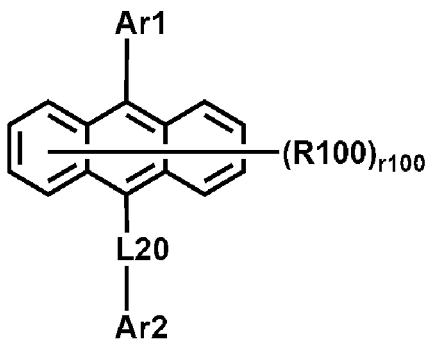

In Chemical Formula A,

Ar1 and Ar2 are the same as or different from each other, and each independently a substituted or unsubstituted aryl group; or a substituted or unsubstituted heteroaryl group,
L20 is a direct bond; or a substituted or unsubstituted arylene group,
R100 is hydrogen, deuterium, a halogen group, a nitrile group, a substituted or unsubstituted alkyl group, a substituted or unsubstituted aryl group, or a substituted or unsubstituted heteroaryl group, and
r100 is an integer of 0 to 8, and when r100 is 2 or greater, R100s are the same as or different from each other.

In one embodiment of the present application, Ar1 and Ar2 are the same as or different from each other, and each independently an aryl group unsubstituted or substituted with an aryl group; or a heteroaryl group unsubstituted or substituted with an aryl group.

In one embodiment of the present application, Ar1 and Ar2 are the same as or different from each other, and each independently a substituted or unsubstituted aryl group having 6 to 20 carbon atoms; or a substituted or unsubstituted heteroaryl group having 2 to 20 carbon atoms.

In one embodiment of the present application, Ar1 and Ar2 are the same as or different from each other, and each independently a substituted or unsubstituted phenyl group; a substituted or unsubstituted biphenyl group; a substituted or unsubstituted naphthyl group; a substituted or unsubstituted anthracene group; a substituted or unsubstituted dibenzofuran group; or a substituted or unsubstituted dibenzothiophene group.

In one embodiment of the present application, Ar1 and Ar2 are the same as or different from each other, and each independently a phenyl group unsubstituted or substituted with an aryl group; a biphenyl group unsubstituted or substituted with an aryl group; a naphthyl group unsubstituted or substituted with an aryl group; an anthracene group unsubstituted or substituted with an aryl group; or a dibenzofuran group unsubstituted or substituted with an aryl group.

In one embodiment of the present application, Ar1 and Ar2 are the same as or different from each other, and each independently a phenyl group unsubstituted or substituted with a naphthyl group; a naphthyl group unsubstituted or substituted with a naphthyl group; an anthracene group unsubstituted or substituted with a naphthyl group; or a

dibenzofuran group.

In one embodiment of the present application, Ar1 and Ar2 are the same as or different from each other, and each independently a 1-naphthyl group; a 2-naphthyl group; an anthracene group substituted with a naphthyl group; or a dibenzofuran group.

In one embodiment of the present application, Ar1 and Ar2 are the same as or different from each other, and each independently a 1-naphthyl group or a 2-naphthyl group.

In one embodiment of the present application, L20 is a direct bond; a phenylene group; or a divalent naphthyl group.

In one embodiment of the present application, L20 is a direct bond.

In one embodiment of the present application, R100 is hydrogen; a substituted or unsubstituted alkyl group; or a substituted or unsubstituted aryl group.

In one embodiment of the present application, R100 is hydrogen; an alkyl group; or an aryl group unsubstituted or substituted with an alkyl group.

In one embodiment of the present application, R100 is hydrogen; an alkyl group having 1 to 10 carbon atoms; or an aryl group having 6 to 20 carbon atoms unsubstituted or substituted with an alkyl group having 1 to 10 carbon atoms.

In one embodiment of the present application, R100 is hydrogen; an alkyl group having 1 to 10 carbon atoms; or a phenyl group having 6 to 20 carbon atoms unsubstituted or substituted with an alkyl group having 1 to 10 carbon atoms.

In one embodiment of the present application, the compound of Chemical Formula A may be selected from among the following structural formulae.

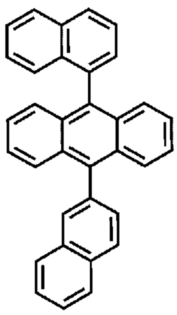
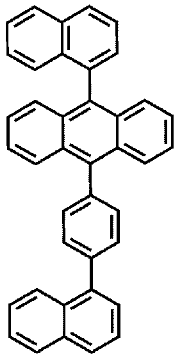
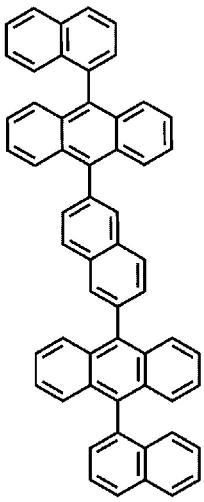
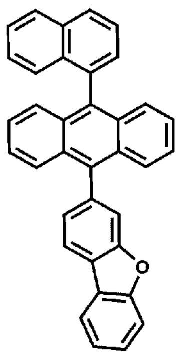
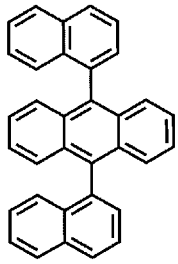
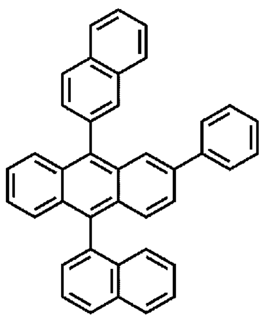
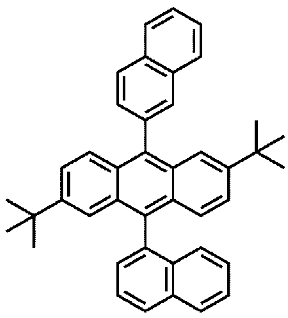
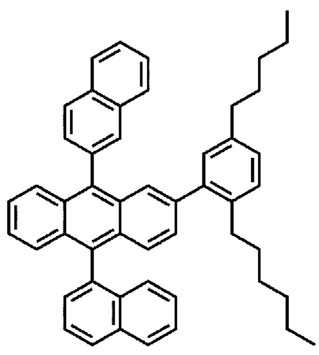

In one embodiment of the present application, the organic material layer includes a hole injection layer or a

hole transfer layer.

In one embodiment of the present application, the organic material layer includes a hole injection layer, a hole transfer layer, or a hole injection and transfer layer.

In one embodiment of the present application, the organic material layer includes a hole injection layer or a hole transfer layer, and the hole injection layer or the hole transfer layer includes the coating composition or a cured material thereof.

In one embodiment of the present application, the organic material layer includes a hole injection layer, a hole transfer layer, or a hole injection and transfer layer, and the hole injection layer, the hole transfer layer, or the hole injection and transfer layer includes the coating composition or a cured material thereof.

In one embodiment of the present application, the organic material layer includes an electron transfer layer or an electron injection layer.

In one embodiment of the present application, the organic material layer includes an electron injection layer, an electron transfer layer, or an electron injection and transfer layer.

In one embodiment of the present application, the organic material layer includes an electron transfer layer or an electron injection layer, and the electron transfer layer or the electron injection layer includes the coating composition or a cured material thereof.

In one embodiment of the present application, the organic material layer includes an electron injection layer, an electron transfer layer, or an electron injection and transfer layer, and the electron injection layer, the electron transfer layer, or the electron injection and transfer layer includes the coating composition or a cured material thereof.

The organic light emitting device of the present specification may be manufactured using materials and methods known in the art, except that one or more layers of the organic material layers are formed using the coating composition including the compound.

The organic light emitting device of the present specification includes a hole injection layer, a hole transfer layer, a light emitting layer, and an electron injection and transfer layer.

The organic light emitting device of the present specification includes a hole injection layer, a hole transfer layer, a light emitting layer, and an electron injection and transfer layer, and

the hole injection layer, the hole transfer layer and the light emitting layer are formed through a solution process.

For example, the organic light emitting device of the present application may be manufactured by consecutively laminating a first electrode, an organic material layer and a second electrode on a substrate. Herein, the organic light emitting device may be manufactured by forming an anode on a substrate by depositing a metal, a metal oxide having conductivity, or an alloy thereof using a physical vapor deposition (PVD) method such as sputtering or e-beam evaporation, forming an organic material layer including a hole injection layer, a hole transfer layer, a light emitting layer and an electron transfer layer thereon, and then depositing a material capable of being used as a cathode thereon. In addition to such a method, the organic light emitting device may also be manufactured by consecutively depositing a cathode material, an organic material layer and an anode material on a substrate.

Another embodiment of the present specification provides a method for manufacturing an organic light emitting device formed using the coating composition.

Specifically, in one embodiment of the present specification, the method for manufacturing an organic light emitting device includes preparing a substrate; forming a cathode or an anode on the substrate; forming one or more organic material layers on the cathode or the anode; and forming an anode or a cathode on the organic material layer, wherein one or more layers of the organic material layers are formed using the coating composition.

In one embodiment of the present specification, the organic material layer formed using the coating composition is formed using spin coating.

In one embodiment of the present specification, the organic light emitting device includes a hole injection layer, a hole transfer layer and a light emitting layer, and the hole injection layer, the hole transfer layer and the light emitting layer are formed using spin coating.

In one embodiment of the present specification, the organic light emitting device includes a hole injection layer, a hole transfer layer and a light emitting layer, the hole injection layer, the hole transfer layer and the light emitting layer are formed using spin coating, and the light emitting layer is formed using the coating composition.

In another embodiment, the organic material layer formed using the coating composition is formed using a printing method.

In an embodiment of the present specification, examples of the printing method include inkjet printing, nozzle printing, offset printing, transfer printing, screen printing or the like, but are not limited thereto.

The coating composition according to one embodiment of the present specification is suited for a solution process due to its structural properties and may be formed using a printing method, and therefore, is economically effective in terms of time and costs when manufacturing a device.

In one embodiment of the present specification, the forming of an organic material layer formed using the coating composition includes coating the coating composition on the cathode or the anode; and heat treating or light

treating the coated coating composition.

In one embodiment of the present specification, the time of heat treating the organic material layer formed using the coating composition is preferably within 1 hour and more preferably within 30 minutes.

In one embodiment of the present specification, the atmosphere of heat treating the organic material layer formed using the coating composition is preferably inert gas such as argon or nitrogen.

In addition, the composition according to one embodiment of the present specification may be thin-filmed through heat treatment or light treatment, or may be included as a copolymer using a coating composition mixed with other monomers. In addition, a copolymer or a mixture may be included using a coating composition mixed with other polymers.

In one embodiment of the present application, the first electrode is an anode, and the second electrode is a cathode.

In another embodiment, the first electrode is a cathode, and the second electrode is an anode.

The anode is an electrode injecting holes, and as the anode material, materials having large work function are normally preferred so that hole injection to an organic material layer is smooth. Specific examples of the anode material capable of being used in the present disclosure include metals such as vanadium, chromium, copper, zinc and gold, or alloys thereof; metal oxides such as zinc oxide, indium oxide, indium tin oxide (ITO) and indium zinc oxide (IZO); combinations of metals and oxides such as ZnO:Al or $SnO_2$:Sb; conductive polymers such as poly (3-methylthiophene), poly[3,4-(ethylene-1,2-dioxy)thiophene] (PEDOT), polypyrrole and polyaniline, and the like, but are not limited thereto.

The cathode is an electrode injecting electrons, and as the cathode material, materials having small work function are normally preferred so that electron injection to an organic material layer is smooth. Specific examples of the cathode material include metals such as magnesium, calcium, sodium, potassium, titanium, indium, yttrium, lithium, gadolinium, aluminum, silver, tin and lead, or alloys thereof; multilayer structure materials such as LiF/Al or $LiO_2$/Al, and the like, but are not limited thereto.

The hole injection layer is a layer performing a role of smoothly injecting holes from an anode to a light emitting layer, and the hole injection material is a material capable of favorably receiving holes from an anode at a low voltage. The highest occupied molecular orbital (HOMO) of the hole injection material is preferably in between the work function of an anode material and the HOMO of surrounding organic material layers. Specific examples of the hole injection material include metal porphyrins, oligothiophene, arylamine-based organic materials, hexanitrile hexaazatriphenylene-based organic materials, quinacridone-based organic materials, perylene-based organic materials, anthraquinone, and polyaniline- and polythiophene-based conductive polymers, and the like, but are not limited thereto. The hole injection layer may have a thickness of 1 nm to 150 nm. The hole injection layer having a thickness of 1 nm or greater has an advantage of preventing hole injection properties from declining, and the thickness being 150 nm or less has an advantage of preventing a driving voltage from increasing to enhance hole migration caused by the hole injection layer being too thick.

In one embodiment of the present specification, the hole injection layer includes an ionic compound.

In one embodiment of the present specification, the hole injection layer includes a coating composition including an ionic compound, or a cured material thereof.

In one embodiment of the present specification, the hole injection layer includes a coating composition including an ionic compound, or a cured material thereof, and the ionic compound is included as a p-doping material.

In the present specification, the p-doping material means a material making a host material to have p-semiconductor properties. The p-semiconductor properties mean properties of receiving or transferring holes to the highest occupied molecular orbital (HOMO) energy level, that is, properties of materials having high hole conductivity.

In one embodiment of the present specification, the hole injection layer includes a coating composition including an arylamine compound, or a cured material thereof.

In one embodiment of the present specification, the hole injection layer includes a coating composition including an arylamine compound, or a cured material thereof, and includes the arylamine compound as a host of the hole injection layer.

In one embodiment of the present specification, the hole injection layer includes the ionic compound and the arylamine compound in a weight ratio of 1:1 to 1:10.

In one embodiment of the present specification, the arylamine compound is a monomer or a polymer.

In one embodiment of the present specification, the hole injection layer further includes an arylamine compound that is a monomer or a polymer as a host.

In one embodiment of the present specification, the arylamine compound includes a curing group.

In one embodiment of the present specification, the host of the hole injection layer has a HOMO level of 4.8 eV to 5.8 eV.

The HOMO level of the present specification is measured using electrochemical cyclic voltammetry (CV). An onset potential ($E_{onset}$) at which oxidation of the host material starts is measured, and ferrocene potential ($E_{1/2(Fc)}$) is measured under the same condition. The ferrocene potential is determined as 4.8 eV compared to the vacuum energy level, and the HOMO level is calculated using the following equation.

$$HOMO\ (eV) = 4.8 + (E_{onset} - E_{1/2(Fc)})$$

The compound of the arylamine group may provide an organic material layer including a thin-filmed structure by forming crosslinkage. In this case, a phenomenon of being dissolved by a solvent deposited on a surface of the organic material layer formed using the coating composition, or being morphologically influenced or decomposed may be prevented.

The hole transfer layer may perform a role of smoothly transferring holes. As the hole transfer material, materials capable of receiving holes from an anode or a hole injection layer, moving the holes to a light emitting layer, and having high mobility for the holes are suited. Specific examples thereof include arylamine-based organic materials, conductive polymers, block copolymers having conjugated parts and nonconjugated parts together, and the like, but are not limited thereto.

An electron blocking layer may be provided between the hole transfer layer and a light emitting layer. As the electron blocking layer, materials known in the art may be used.

The light emitting layer may emit red light, green light or blue light, and may be formed with a phosphorescence material or a fluorescence material. The light emitting material is a material capable of emitting light in a visible region by receiving holes and electrons from a hole transfer layer and an electron transfer layer, respectively, and binding the holes and the electrons, and is preferably a material having favorable quantum efficiency for fluorescence or phosphorescence. Specific examples thereof include 8-hydroxyquinoline aluminum complexes ($Alq_3$); carbazole-based compounds; dimerized styryl compounds; BAlq; 10-hydroxybenzoquinoline-metal compounds; benzoxazole-, benzothiazole- and benzimidazole-based compounds; poly(p-phenylenevinylene) (PPV)-based polymers; spiro compounds; polyfluorene, rubrene, and the like, but are not limited thereto.

A host material of the light emitting layer may include fused aromatic ring derivatives, heteroring-containing compounds or the like. Specifically, as the fused aromatic ring derivative, anthracene derivatives, pyrene derivatives, naphthalene derivatives, pentacene derivatives, phenanthrene compounds, fluoranthene compounds and the like may be included, and as the heteroring-containing compound, carbazole derivatives, dibenzofuran derivatives, ladder-type furan compounds, pyrimidine derivatives and the like may be included, however, the host material is not limited thereto.

When the light emitting layer emits red light, phosphorescence materials such as bis(1-phenylisoquinoline)acetylacetonate iridium (PIQIr(acac)), bis(1-phenylquinoline)acetylacetonate iridium (PQIr(acac)), tris(1-phenylquinoline)iridium (PQIr) or octaethylporphyrin platinum (PtOEP), or fluorescence materials such as tris(8-hydroxyquinolino) aluminum ($Alq_3$) may be used as the light emitting dopant, however, the light emitting dopant is not limited thereto. When the light emitting layer emits green light, phosphorescence materials such as fac tris(2-phenylpyridine)iridium ($Ir(ppy)_3$), or fluorescence materials such as tris(8-hydroxyquinolino)aluminum ($Alq_3$), anthracene-based compounds, pyrene-based compounds or boron-based compounds may be used as the light emitting dopant, however, the light emitting dopant is not limited thereto. When the light emitting layer emits blue light, phosphorescence materials such as $(4,6\text{-}F_2ppy)_2Irpic$, or fluorescence materials such as spiro-DPVBi, spiro-6P, distyrylbenzene (DSB), distyrylarylene (DSA), PFO-based polymers, PPV-based polymers, anthracene-based compounds, pyrene-based compounds or boron-based compounds may be used as the light emitting dopant, however, the light emitting dopant is not limited thereto.

The electron transfer layer may perform a role of smoothly transferring electrons. As the electron transfer material, materials capable of favorably receiving electrons from a cathode, moving the electrons to a light emitting layer, and having high mobility for the electrons are suited. Specific examples thereof include Al complexes of 8-hydroxyquinoline; complexes including $Alq_3$; organic radical compounds; hydroxyflavon-metal complexes, and the like, but are not limited thereto. The electron transfer layer may have a thickness of 1 nm to 50 nm. The electron transfer layer having a thickness of 1 nm or greater has an advantage of preventing electron transfer properties from declining, and the thickness being 50 nm or less has an advantage of preventing a driving voltage from increasing to enhance electron migration caused by the electron transfer layer being too thick.

The electron injection layer may perform a role of smoothly injecting electrons. As the electron injection material, compounds having an electron transferring ability, having an electron injection effect from a cathode, having an excellent electron injection effect for a light emitting layer or light emitting material, and preventing excitons generated in the light emitting layer from moving to a hole injection layer, and, in addition thereto, having an excellent thin film forming ability are preferred. Specific examples thereof may include fluorenone, anthraquinodimethane, diphenoquinone, thiopyran dioxide, oxazole, oxadiazole, triazole, imidazole, perylene tetracarboxylic acid, fluorenylidene methane, anthrone or the like, and derivatives thereof, metal complex compounds, nitrogen-containing 5-membered ring derivatives, and the like, but are not limited thereto.

The metal complex compound includes 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium and the like, but is not limited thereto.

The hole blocking layer is a layer blocking holes from reaching a cathode, and may be generally formed under the same condition as the hole injection layer. Specific examples thereof may include oxadiazole derivatives, triazole derivatives, phenanthroline derivatives, BCP, aluminum complexes and the like, but are not limited thereto.

The organic light emitting device according to the present disclosure may be a top-emission type, a bottom-emission type or a dual-emission type depending on the materials used.

Mode for Invention

Hereinafter, the present specification will be described in detail with reference to examples. However, the examples according to the present specification may be modified to various other forms, and the scope of the present application is not to be construed as being limited to the examples described below. Examples of the present application are provided in order to more fully describe the present specification to those having average knowledge in the art.

**Preparation Example 1: Preparation of Compound 1**

**Step 1-1: Synthesis of Intermediate Compound 1-c**

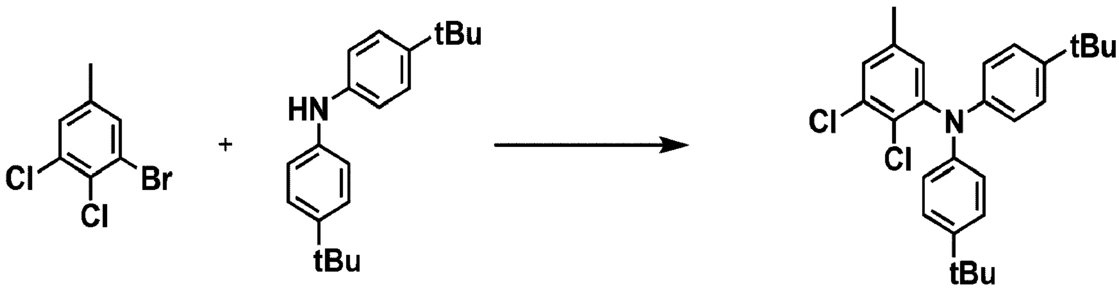

1-a 1-b 1-c

Compound 1-a (10.0 g, 1.0 eq.), Compound 1-b (1.2 eq.) and NaOt-Bu (3.0 eq.) were introduced to a round bottom flask, and dissolved in anhydrous toluene. After that, the result was stirred for 10 minutes at room temperature while charging the flask with nitrogen gas, and the oil container temperature was raised from room temperature to 110°C. When the inner temperature became 60°C, $Pd((t\text{-}Bu)_3P)_2$ (3 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 1-c (15.0 g).
m/z $[M+H]^+$ $C_{27}H_{32}Cl_2N^+$ 440.2

**Step 1-2: Synthesis of Intermediate Compound 1-f**

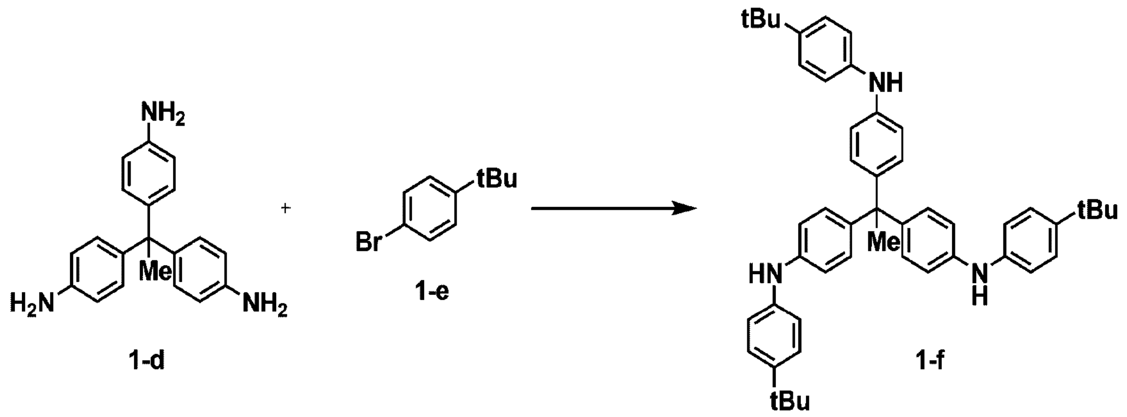

1-d 1-e 1-f

Compound 1-d (20.0 g, 1.0 eq.), Compound 1-e (3.3 eq.) and NaOt-Bu (6.0 eq.) were introduced to a round bottom flask, and dissolved in anhydrous toluene. After that, the result was stirred for 10 minutes at room temperature while charging the flask with nitrogen gas, and the oil container temperature was raised from room temperature to 110°C. When the inner temperature became 60°C, $Pd((t\text{-}Bu)_3P)_2$ (9 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 1-f (40.0 g).
m/z $[M+H]^+$ $C_{50}H_{58}N_3^+$ 700.5

**Step 1-3: Synthesis of Intermediate Compound 1-g**

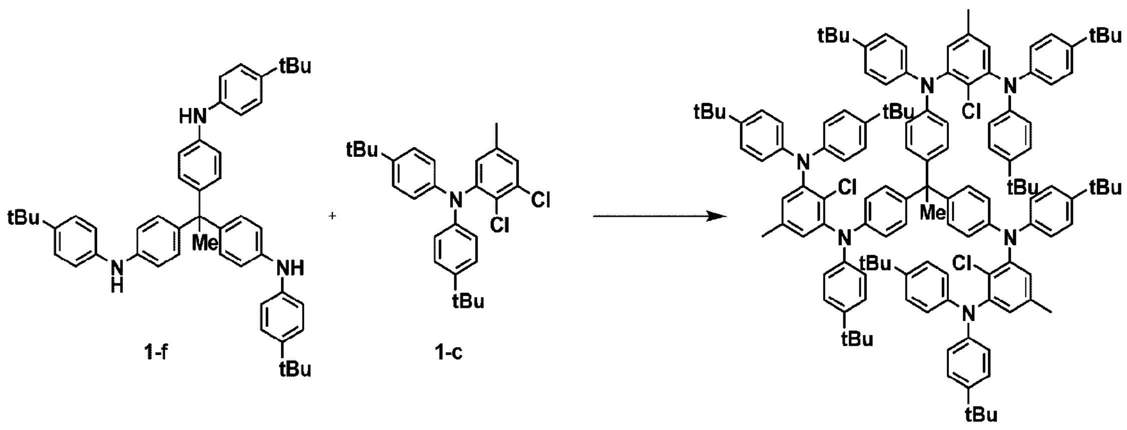

1-f 1-c 1-g

Compound 1-f (3.0 g, 1.0 eq.), Compound 1-c (3.3 eq.) and NaOt-Bu (6.0 eq.) were introduced to a round bottom flask, and dissolved in anhydrous toluene. After that, the result was stirred for 10 minutes at room temperature while charging the flask with nitrogen gas, and the oil container temperature was raised from room temperature to 110°C. When the inner temperature became 60°C, $Pd((t\text{-}Bu)_3P)_2$ (9 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 1-g (5.5 g).
m/z $[M+H]^+$ $C_{131}H_{148}Cl_3N_6^+$ 1910.1

**Step 1-4: Synthesis of Final Compound 1**

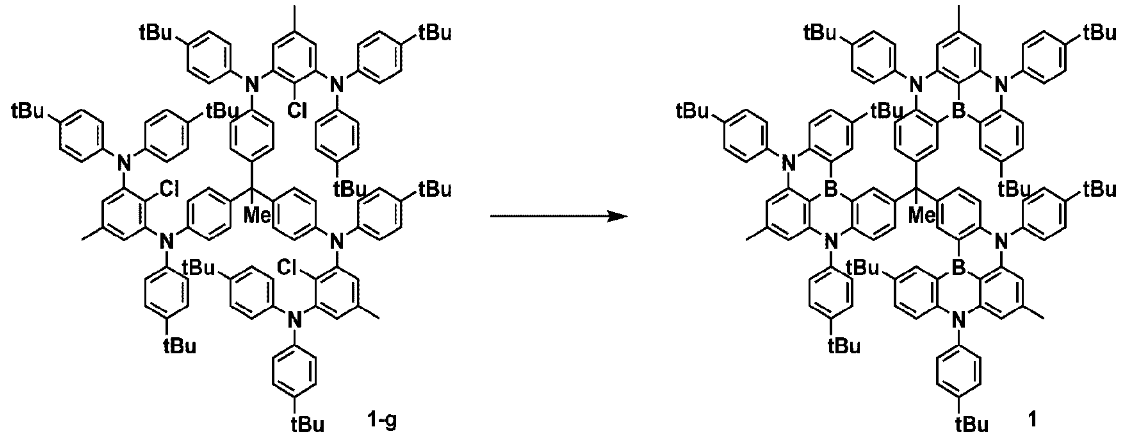

1-g 1

Compound 1-g (3.0 g, 1.0 eq.) was introduced to a round bottom flask, and dissolved in 1,2-dichlorobenzene (0.02 M). To the reaction material stirred under room temperature, $BI_3$ (2.0 eq.) was slowly added dropwise, and the result was stirred overnight after raising the bath temperature to 80°C. After the reaction, the reaction material was sufficiently cooled at room temperature, and diluted with $CH_2Cl_2$. Sat. $Na_2S_2O_3$ (aq.) and EtN*i*-$Pr_2$ (15 eq.) were consecutively added dropwise to the reaction material to terminate the reaction, and the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 1 (2.1 g).

m/z $[M+H]^+$ $C_{131}H_{142}B_3N_6^+$ 1832.16

**Preparation Example 2: Preparation of Compound 2**

**Step 2-1: Synthesis of Intermediate Compound 2-b**

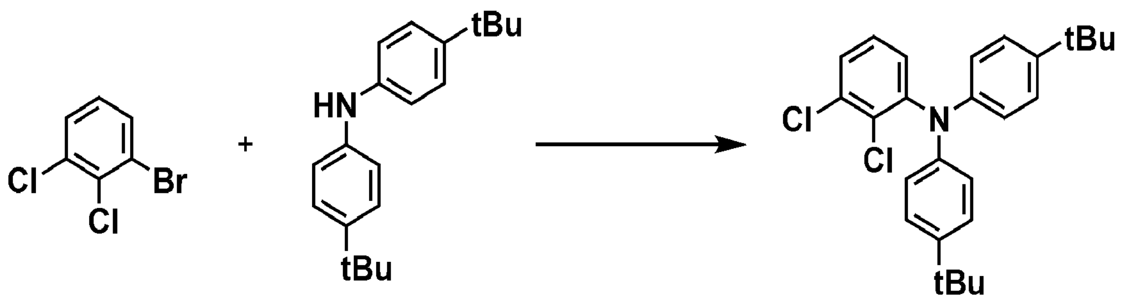

2-a 1-b 2-b

Compound 2-b was prepared in the same manner as Compound 1-c except that Compound 2-a was used instead of Compound 1-a.

m/z $[M+H]^+$ $C_{26}H_{30}Cl_2N^+$ 426.2

**Step 2-2: Synthesis of Intermediate Compound 2-c**

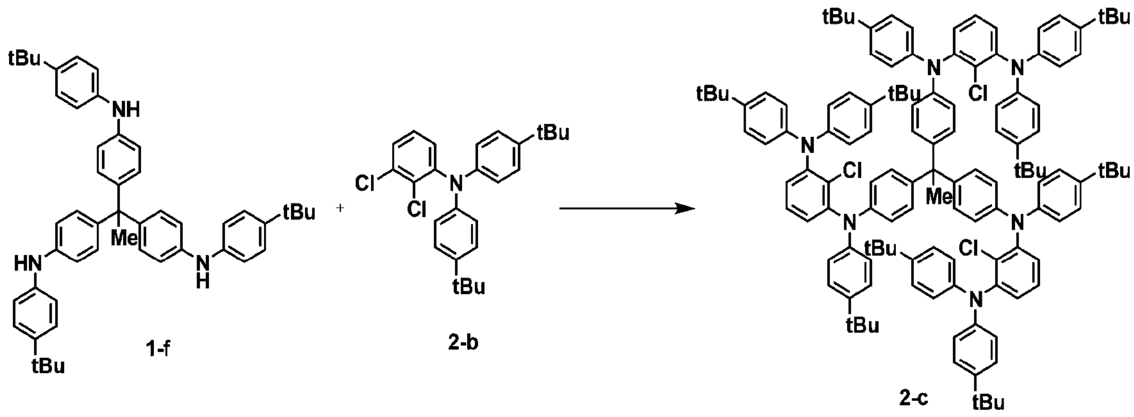

1-f 2-b 2-c

Compound 2-c was prepared in the same manner as Compound 1-g except that Compound 2-b was used instead of Compound 1-c.
m/z $[M+H]^+$ $C_{128}H_{142}Cl_3N_6^+$ 1868.1

**Step 2-3: Synthesis of Final Compound 2**

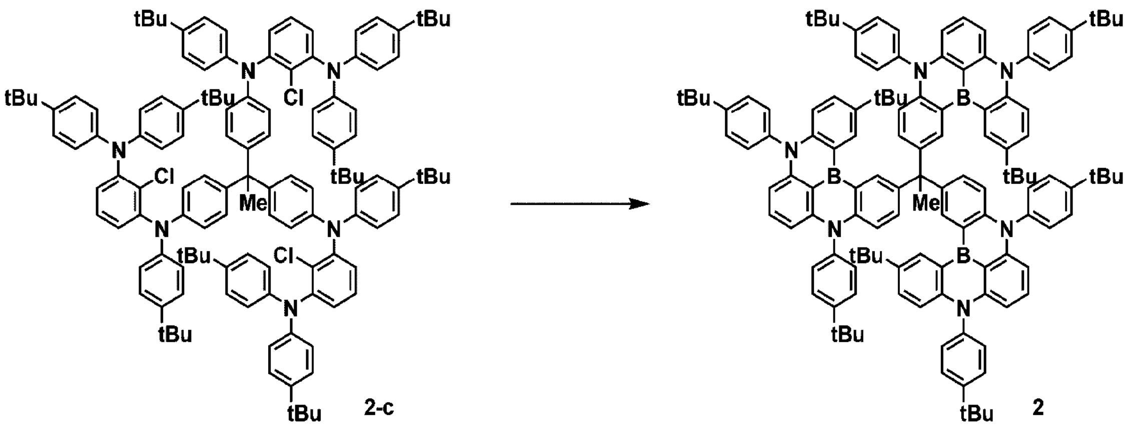

2-c 2

Compound 2 was prepared in the same manner as Compound 1 except that Compound 2-c was used instead of Compound 1-g.
m/z $[M+H]^+$ $C_{128}H_{136}B_3N_6^+$ 1790.3

**Preparation Example 3: Preparation of Compound 3**

**Step 3-1: Synthesis of Intermediate Compound 3-b**

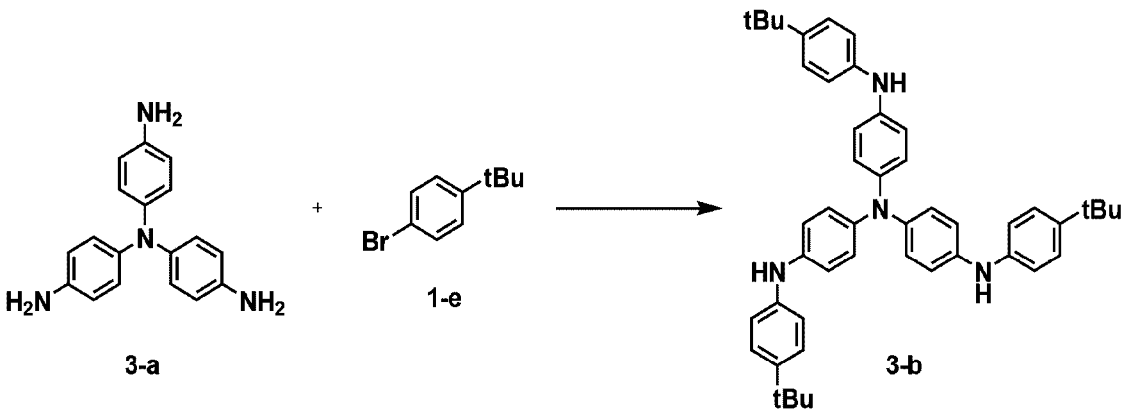

3-a 1-e 3-b

Compound 3-b was prepared in the same manner as Compound 1-f except that Compound 3-a was used instead of Compound 1-d.
m/z $[M+H]^+$ $C_{48}H_{55}N_4^+$ 687.4

**Step 3-2: Synthesis of Intermediate Compound 3-c**

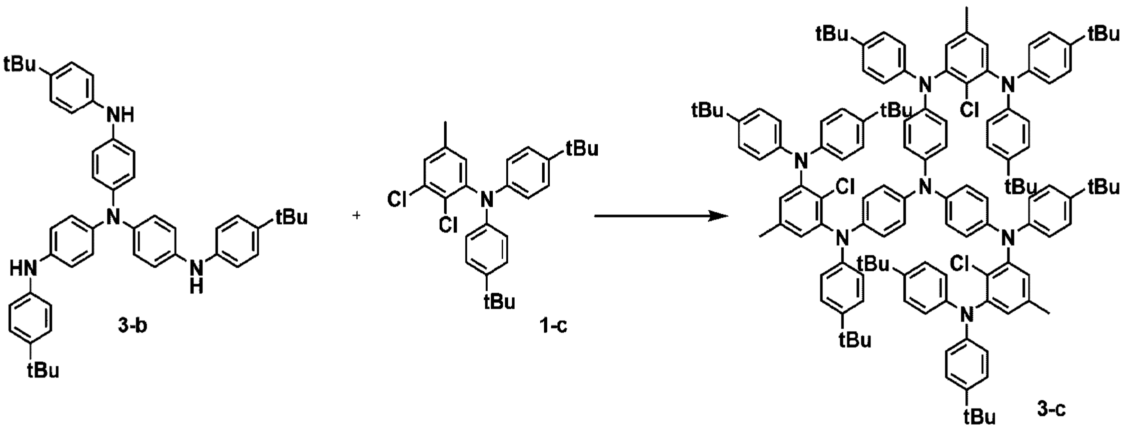

3-b 1-c 3-c

Compound 3-c was prepared in the same manner as Compound 1-g except that Compound 3-b was used instead of Compound 1-f.
m/z $[M+H]^+$ $C_{129}H_{145}Cl_3N_7^+$ 1897.1

**Step 3-3: Synthesis of Final Compound 3**

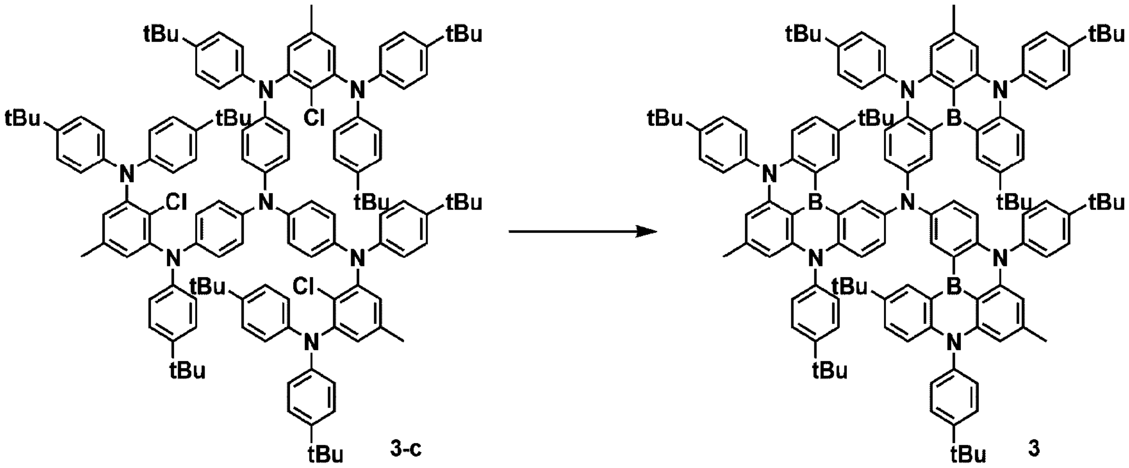

3-c 3

Compound 3 was prepared in the same manner as Compound 1 except that Compound 3-c was used instead of Compound 1-g.
m/z $[M+H]^+$ $C_{129}H_{139}B_3N_7^+$ 1819.1

**Preparation Example 4: Preparation of Compound 4**

**Step 4-1: Synthesis of Compound 4-c**

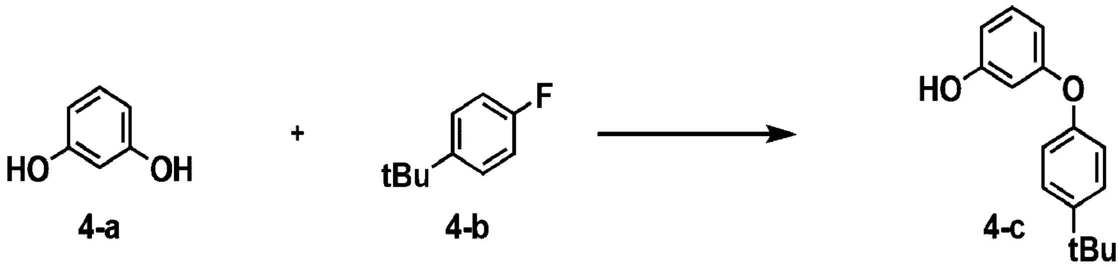

4-a 4-b 4-c

Compound 4-a (3.0 g, 1.0 eq.), Compound 4-b (1.03 eq.) and $K_2CO_3$ (2.0 eq.) were introduced to a round bottom flask, and dissolved in methylpyrrolidone (NMP) (0.3 M). CuI (5 mol%) and iron(III) acetylacetonate ($Fe(acac)_3$) (10 mol%) were added thereto under the nitrogen atmosphere, and the result was stirred for 4 hours after raising the temperature to 150°C. After the reaction, the reaction solution was cooled to room temperature, and washed with EtOAc/sat. $NH_4Cl$ (aq.) to separate the organic layer. Water was removed using $MgSO_4$, and the result was passed through a Celite-Florisil-Silica pad. The passed solution was concentrated under vacuum, and then purified using column chromatography to obtain Compound 4-c (8.3 g).
m/z $[M+H]^+$ $C_{16}H_{19}O_2^+$ 243.2

**Step 4-2: Synthesis of Intermediate Compound 4-e**

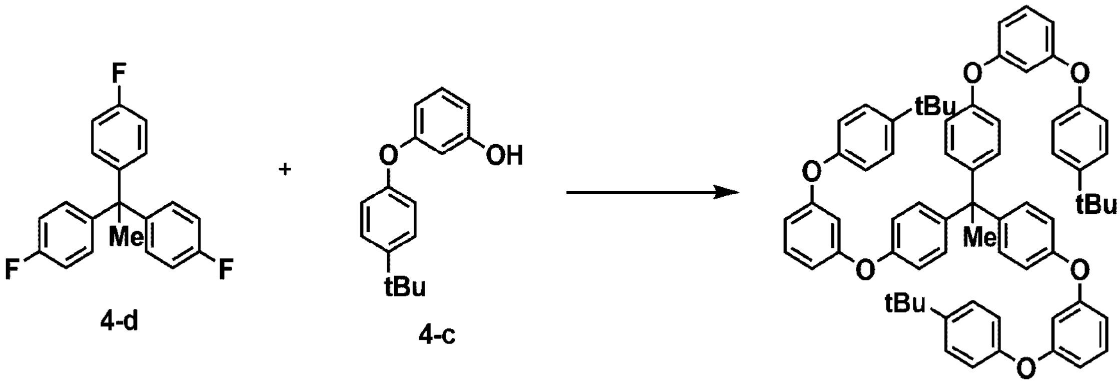

4-d 4-c 4-e

Compound 4-d (5.0 g, 1.0 eq.), Compound 4-c (3.6 eq.) and $K_2CO_3$ (2.0 eq.) were introduced to a round bottom flask, and dissolved in methylpyrrolidone (NMP) (0.3 M). CuI (15 mol%) and iron(III) acetylacetonate ($Fe(acac)_3$) (30 mol%) were added thereto under the nitrogen atmosphere, and the result was stirred for 4 hours after raising the temperature to 150°C. After the reaction, the reaction solution was cooled to room temperature, and washed with EtOAc/sat. $NH_4Cl$ (aq.) to separate the organic layer. Water was removed using $MgSO_4$, and the result was passed through a Celite-Florisil-Silica pad. The passed solution was concentrated under vacuum, and then purified using column chromatography to obtain Compound 4-e (11.6 g).
m/z $[M+H]^+$ $C_{68}H_{67}O_6^+$ 979.5

**Step 4-3: Synthesis of Final Compound 4**

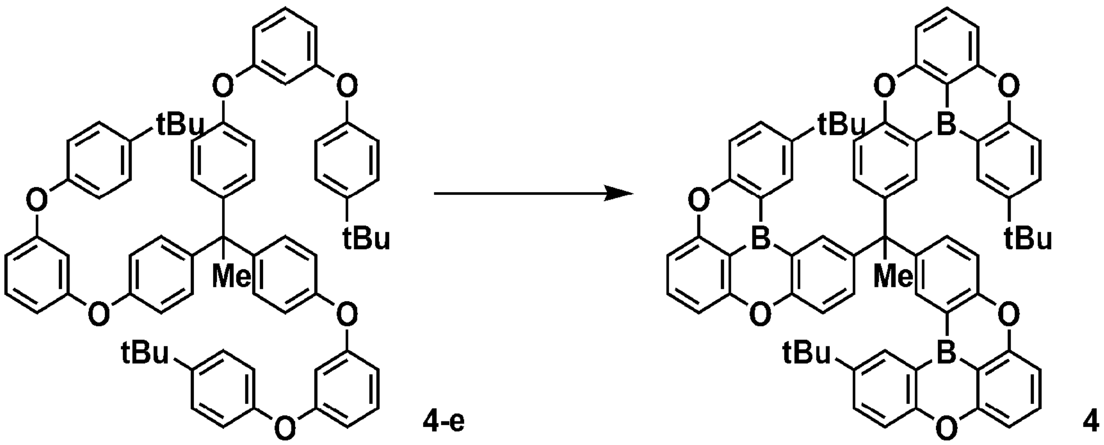

4-e 4

Compound 4-e (3.0 g, 1.0 eq.) was introduced to a round bottom flask, and dissolved in anhydrous 1,2-dichlorobenzene (0.02 M). To the reaction material stirred under room temperature, $BI_3$ (2.0 eq.) was slowly added dropwise, and the result was stirred overnight after raising the bath temperature to 130°C. After the reaction, the reaction material was sufficiently cooled at room temperature, and diluted with $CH_2Cl_2$. Sat. $Na_2S_2O_3$ (aq.) and EtN*i*-$Pr_2$ (15 eq.) were consecutively added dropwise to the reaction material to terminate the reaction, and the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Final Compound 4 (2.2 g).
m/z $[M+H]^+$ $C_{68}H_{58}B_3O_6^+$ 1003.5

**Preparation Example 5: Preparation of Compound 5**

**Step 5-1: Synthesis of Intermediate Compound 5-b**

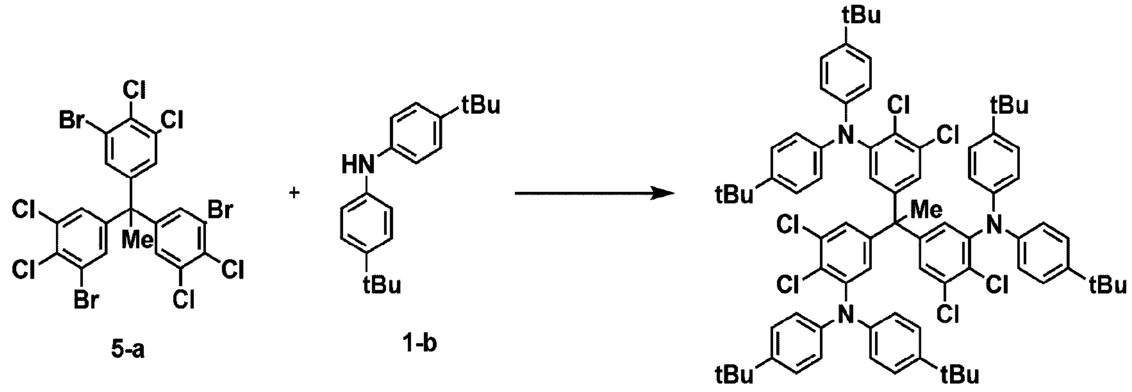

5-a 1-b 5-b

Compound 5-a (5.0 g, 1.0 eq.), Compound 1-b (3.3 eq.) and NaOt-Bu (6.0 eq.) were introduced to a round bottom flask, and dissolved in toluene (0.3 M). Under a bath temperature of 110°C, $Pd(P(t\text{-}Bu)_3)_2$ (9 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 5-b (8.1 g).
m/z $[M+H]^+$ $C_{80}H_{88}Cl_6N_3^+$ 1300.5

**Step 5-2: Synthesis of Intermediate Compound 5-d**

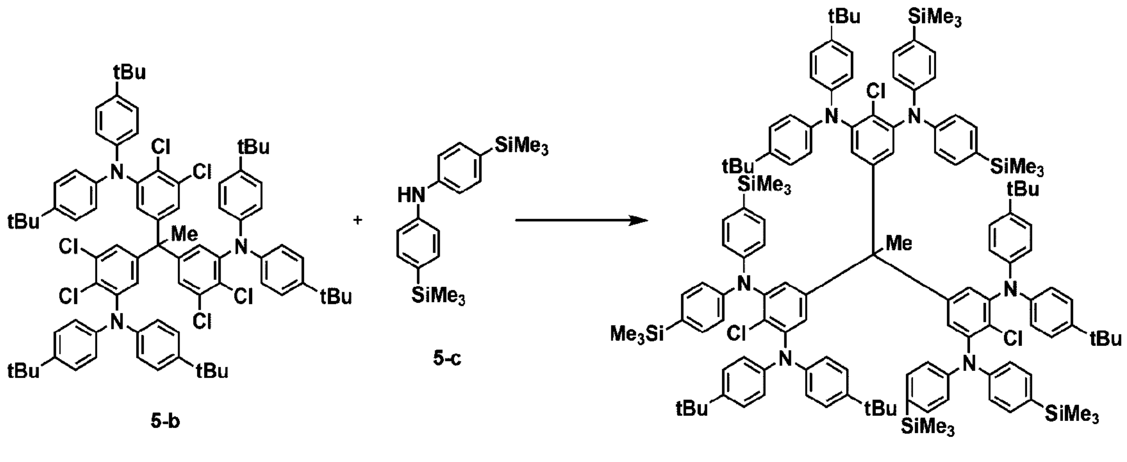

5-b 5-c 5-d

Compound 5-b (5.0 g, 1.0 eq.), Compound 5-c (3.3 eq.) and NaOt-Bu (6.0 eq.) were introduced to a round bottom flask, and dissolved in toluene (0.3 M). Under a bath temperature of 110°C, $Pd(P(t\text{-}Bu)_3)_2$ (9 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 5-d (7.3 g).
m/z $[M+H]^+$ $C_{134}H_{166}Cl_3N_6Si_6^+$ 2132.1

**Step 5-3: Synthesis of Final Compound 5**

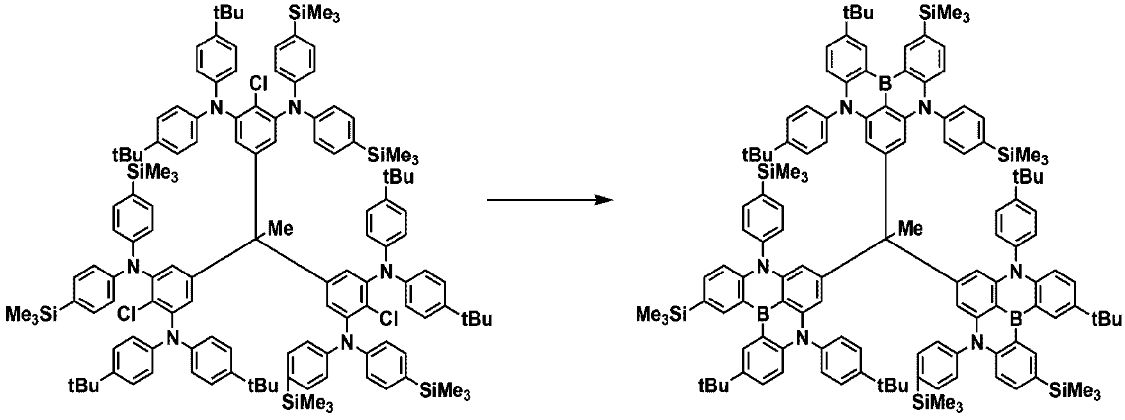

5-d 5

Compound 5 was prepared in the same manner as Compound 1 except that Compound 5-d was used instead of Compound 1-g.

m/z $[M+H]^+$ $C_{134}H_{160}B_3N_6Si_6^+$ 2054.2

**Preparation Example 6: Preparation of Compound 6**

**Step 6-1: Synthesis of Intermediate Compound 6-b**

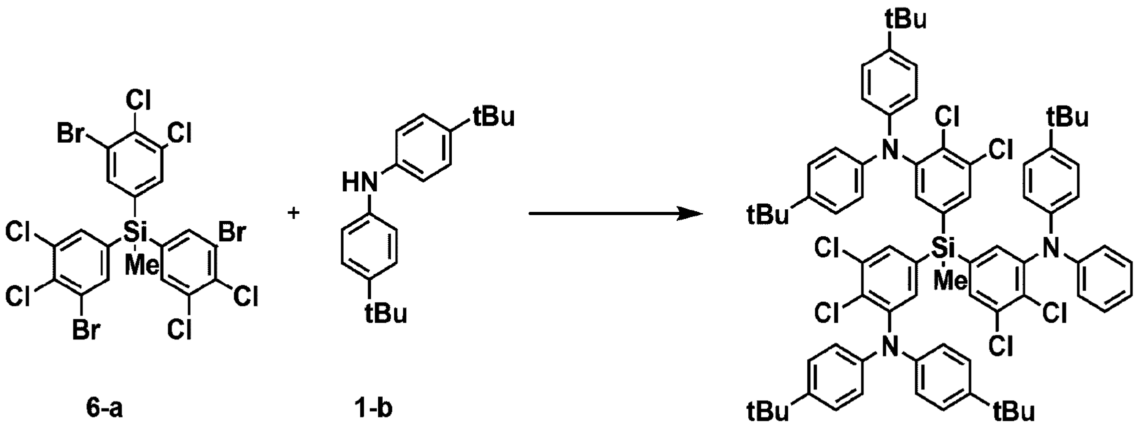

6-a 1-b 6-b

Compound 6-b was prepared in the same manner as Compound 5-b except that Compound 6-a was used instead of Compound 5-a.

m/z $[M+H]^+$ $C_{79}H_{88}Cl_6N_3Si^+$ 1316.49

**Step 6-2: Synthesis of Intermediate Compound 6-c**

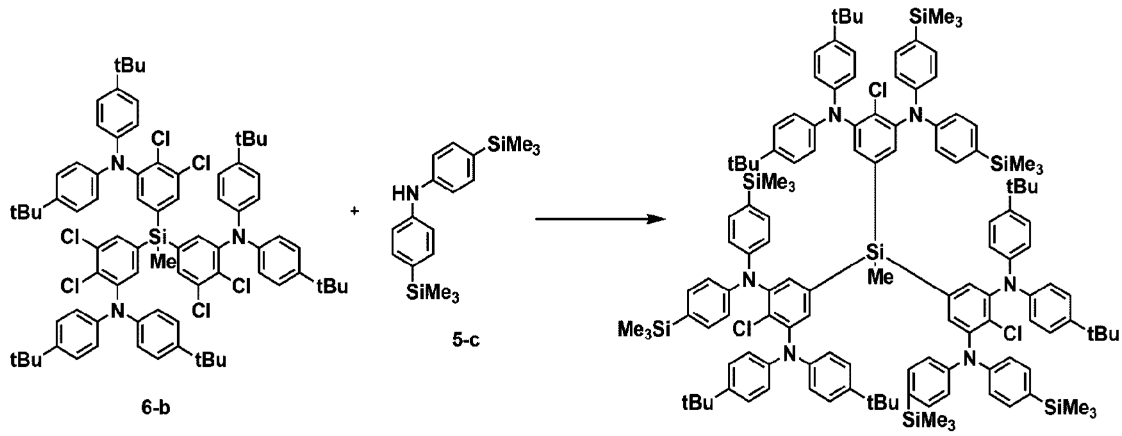

6-b 5-c

6-c

Compound 6-c was prepared in the same manner as Compound 5-d except that Compound 6-b was used instead of Compound 5-b.

m/z $[M+H]^+$ $C_{133}H_{166}Cl_3N_6Si_7^+$ 2148.1

**Step 6-3: Synthesis of Final Compound 6**

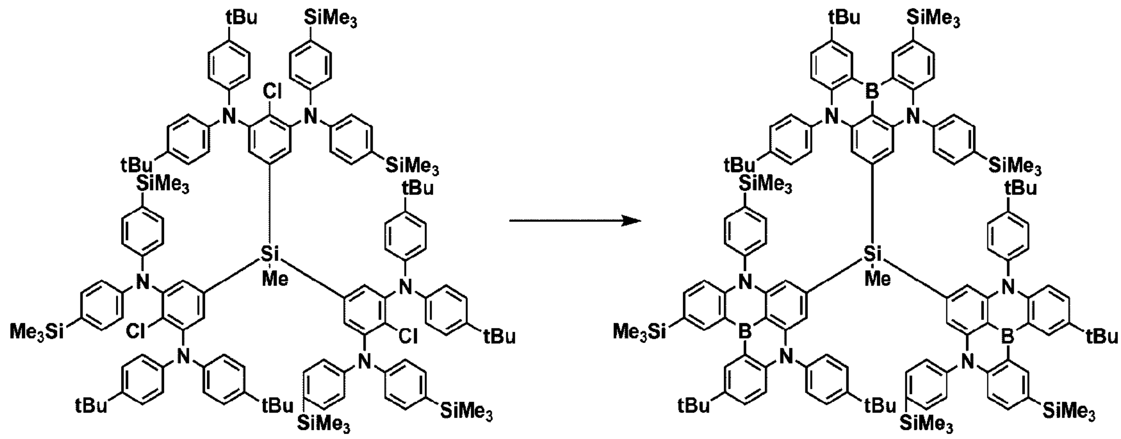

6-c 6

Compound 6 was prepared in the same manner as Compound 1 except that Compound 6-c was used instead of Compound 1-g.

m/z $[M+H]^+$ $C_{133}H_{160}B_3N_6Si_7^+$ 2070.1

**Preparation Example 7: Preparation of Compound 7**

**Step 7-1: Synthesis of Intermediate Compound 7-c**

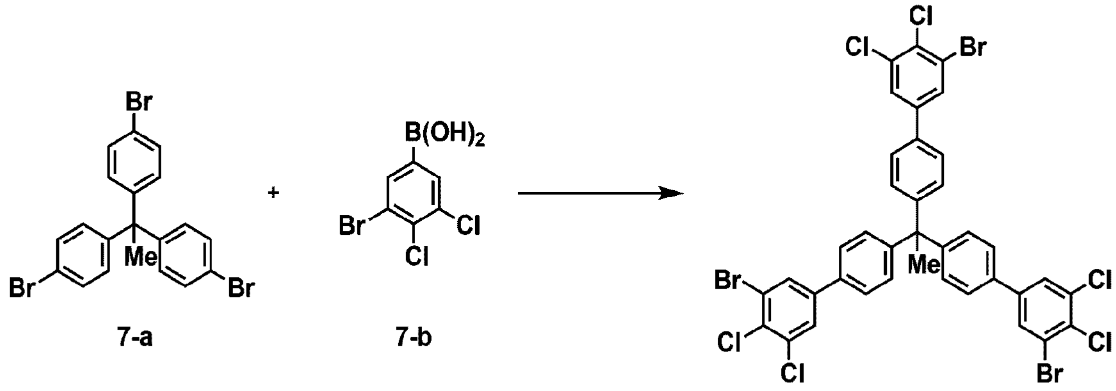

7-a 7-b

7-c

Compound 7-a (5.0 g, 1.0 eq.) and Compound 7-b (3.3 eq.) were introduced to a round bottom flask, and dissolved in anhydrous tetrahydrofuran (THF) (0.3 M). $K_2CO_3$ (3.3 eq.) dissolved in water was injected thereto. Under a bath temperature of 80°C, $Pd(PPh_3)_4$ (9 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 7-c (7.3 g).
m/z $[M+H]^+$ $C_{38}H_{22}Br_3Cl_6^+$ 924.7

**Step 7-2: Synthesis of Intermediate Compound 7-d**

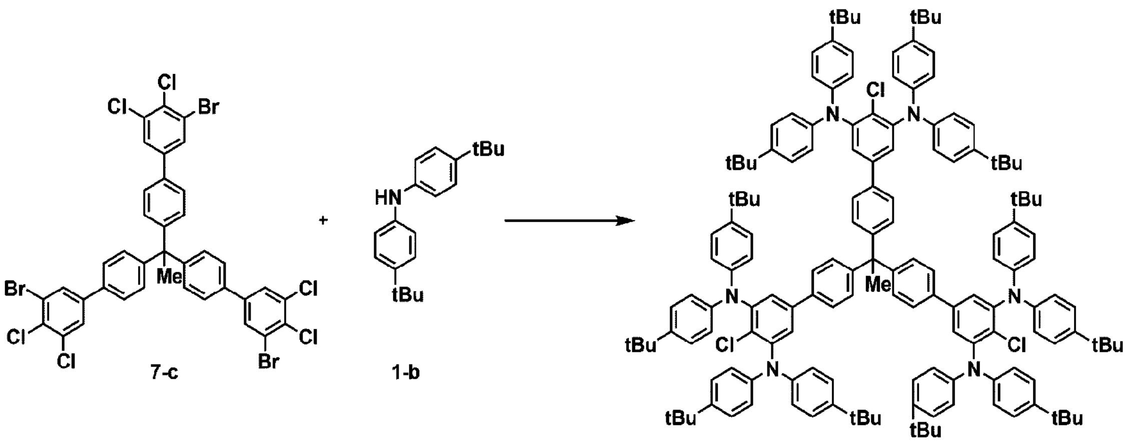

7-c 1-b

7-d

Compound 7-c (2.0 g, 1.0 eq.), Compound 1-b (6.6 eq.) and NaOt-Bu (12.0 eq.) were introduced to a round bottom flask, and dissolved in toluene (0.3 M). Under a bath temperature of 110°C, $Pd(P(t\text{-Bu})_3)_2$ (18 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 7-d (3.7 g).
m/z $[M+H]^+$ $C_{158}H_{178}Cl_3N_6^+$ 2264.3

**Step 7-3: Synthesis of Final Compound 7**

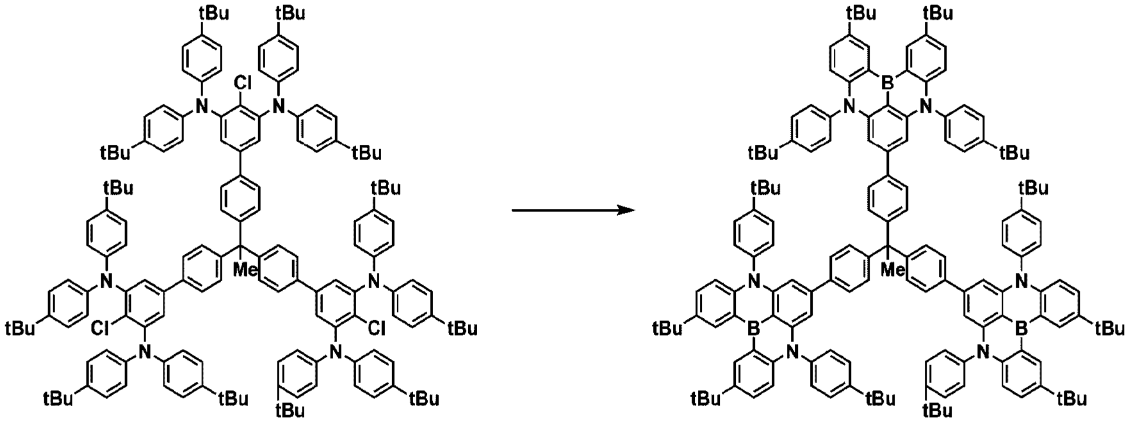

7-d 7

Compound 7 was prepared in the same manner as Compound 1 except that Compound 7-d was used instead of Compound 1-g.
m/z $[M+H]^+$ $C_{158}H_{172}B_3N_6^+$ 2186.4

**Preparation Example 8: Preparation of Compound 8**

**Step 8-1: Synthesis of Intermediate Compound 8-c**

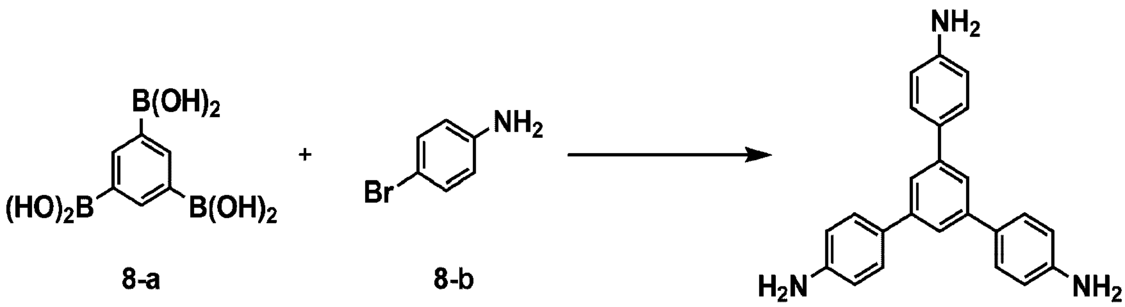

8-a 8-b 8-c

Compound 8-a (5.0 g, 1.0 eq.) and Compound 8-b (3.3 eq.) were introduced to a round bottom flask, and dissolved in anhydrous THF (0.3 M). $K_2CO_3$ (3.3 eq.) dissolved in water was injected thereto. Under a bath temperature of 80°C, $Pd(PPh_3)_4$ (9 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 8-c (8.0 g, 95% yield).
m/z $[M+H]^+$ $C_{24}H_{22}N_3^+$ 352.2

**Step 8-2: Synthesis of Intermediate Compound 8-e**

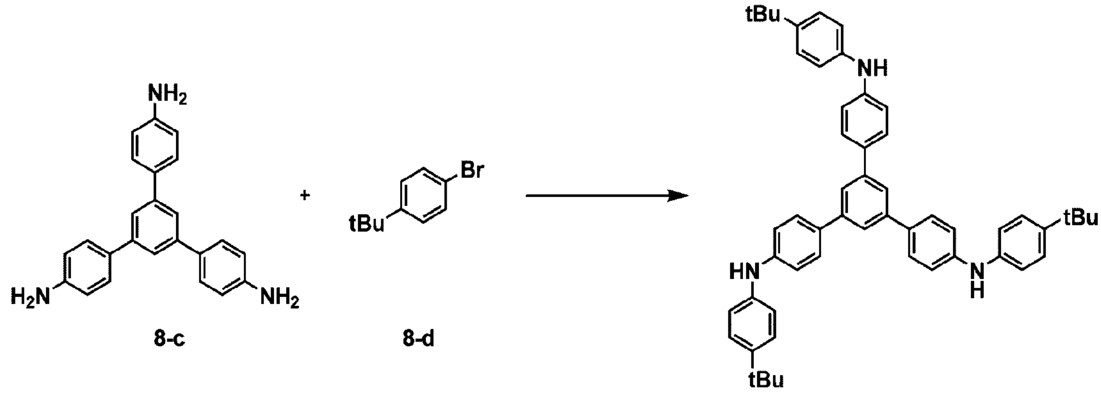

8-c 8-d 8-e

Compound 8-c (6.0 g, 1.0 eq.), Compound 8-d (3.3 eq.) and NaOt-Bu (6.0 eq.) were introduced to a round bottom flask, and dissolved in PhMe (0.3 M). Under a bath temperature of 110°C, $Pd(P(t\text{-}Bu)_3)_2$ (9 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 8-e (9.5 g, 74% yield).
m/z $[M+H]^+$ $C_{54}H_{58}N_3^+$ 748.6

**Step 8-3: Synthesis of Intermediate Compound 8-f**

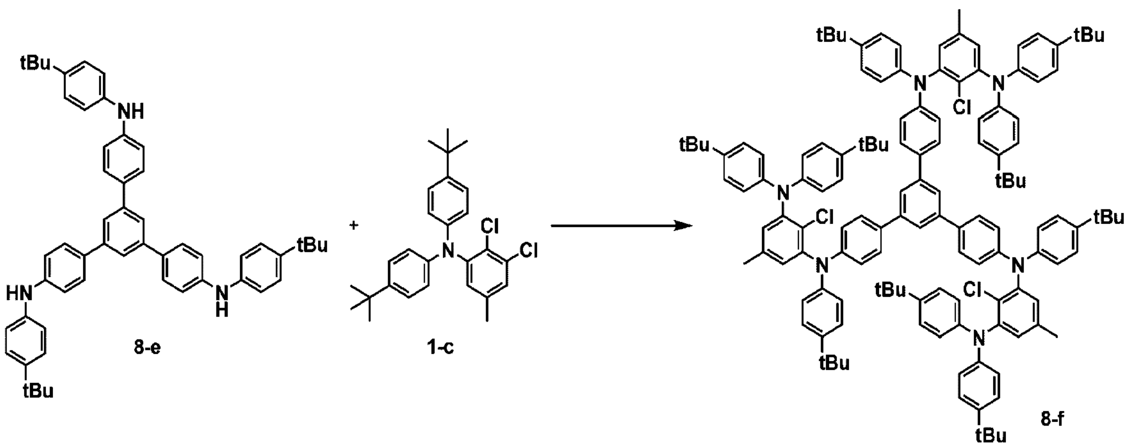

8-e 1-c 8-f

Compound 8-e (3.0 g, 1.0 eq.), Compound 1-c (3.3 eq.) and NaOt-Bu (6.0 eq.) were introduced to a round bottom flask, and dissolved in PhMe (0.3 M). Under a bath temperature of 110°C, $Pd(P(t\text{-}Bu)_3)_2$ (9 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 8-f (5.0 g, 64% yield).
m/z $[M+H]^+$ $C_{135}H_{148}Cl_3N_6^+$ 1958.1

**Step 8-4: Synthesis of Final Compound 8**

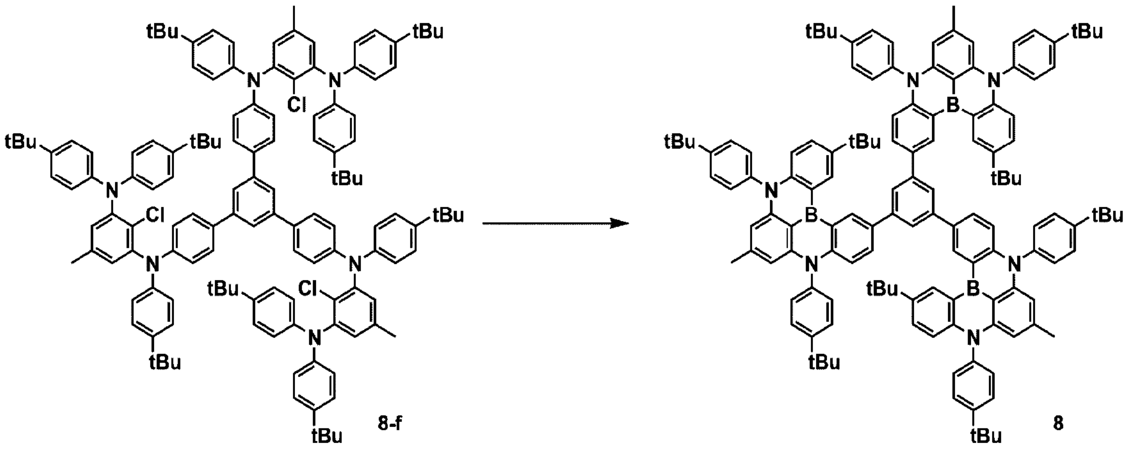

8-f 8

Compound 8 was prepared in the same manner as Compound 1 except that Compound 8-f was used instead of Compound 1-g.
m/z $[M+H]^+$ $C_{135}H_{142}B_3N_6^+$ 1880.2

**Preparation Example 9: Preparation of Compound 9**

**Step 9-1: Synthesis of Intermediate Compound 9-b**

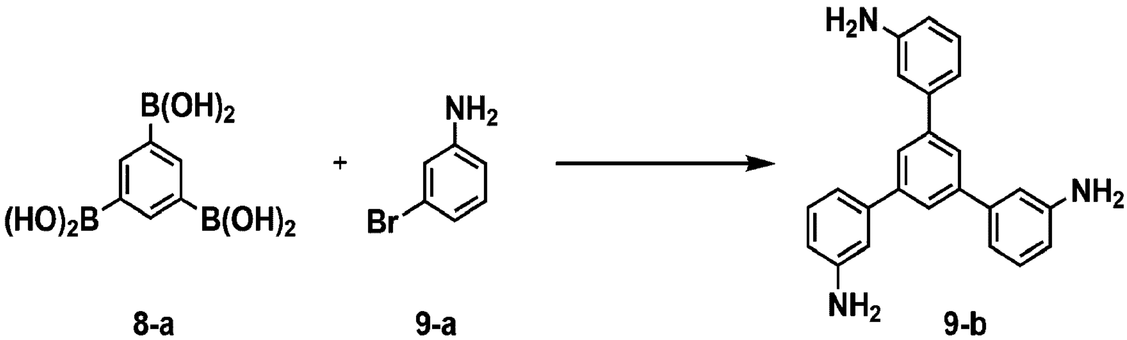

8-a 9-a 9-b

Compound 9-b was prepared in the same manner as Compound 8-c except that Compound 9-a was used instead of Compound 8-b.
m/z $[M+H]^+$ $C_{24}H_{22}N_3^+$ 352.2

**Step 9-2: Synthesis of Intermediate Compound 9-c**

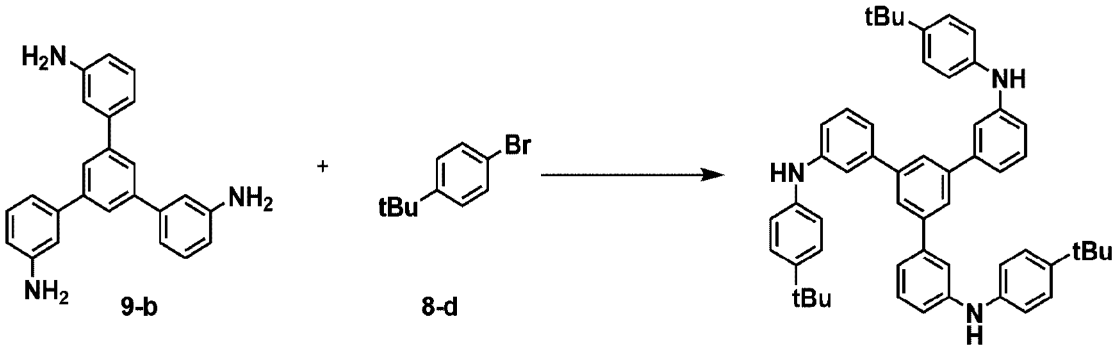

9-b 8-d 9-c

Compound 9-c was prepared in the same manner as Compound 8-e except that Compound 9-b was used instead of Compound 8-c.

m/z $[M+H]^+$ $C_{54}H_{58}N_3^+$ 748.6

**Step 9-3: Synthesis of Intermediate Compound 9-d**

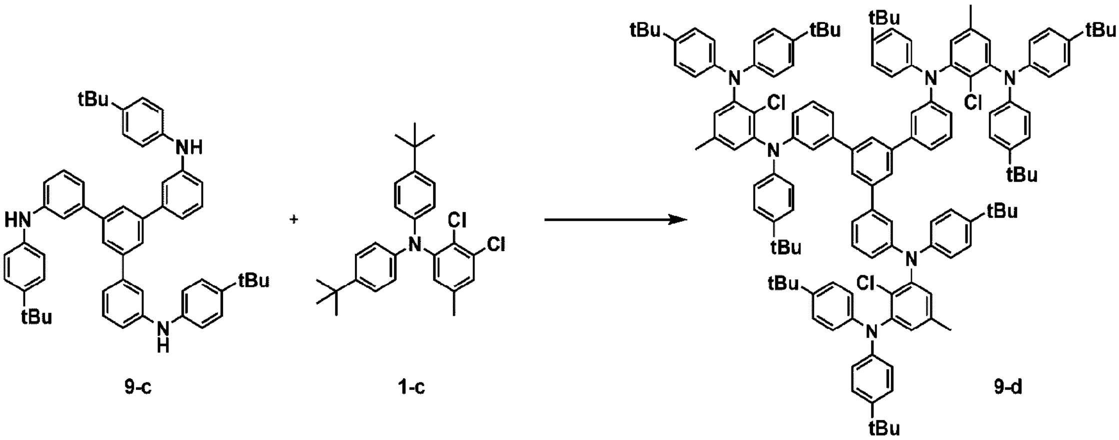

9-c 1-c 9-d

Compound 9-d was prepared in the same manner as Compound 8-f except that Compound 9-c was used instead of Compound 8-e.

m/z $[M+H]^+$ $C_{135}H_{149}Cl_3N_6^+$ 1958.1

**Step 9-4: Synthesis of Final Compound 9**

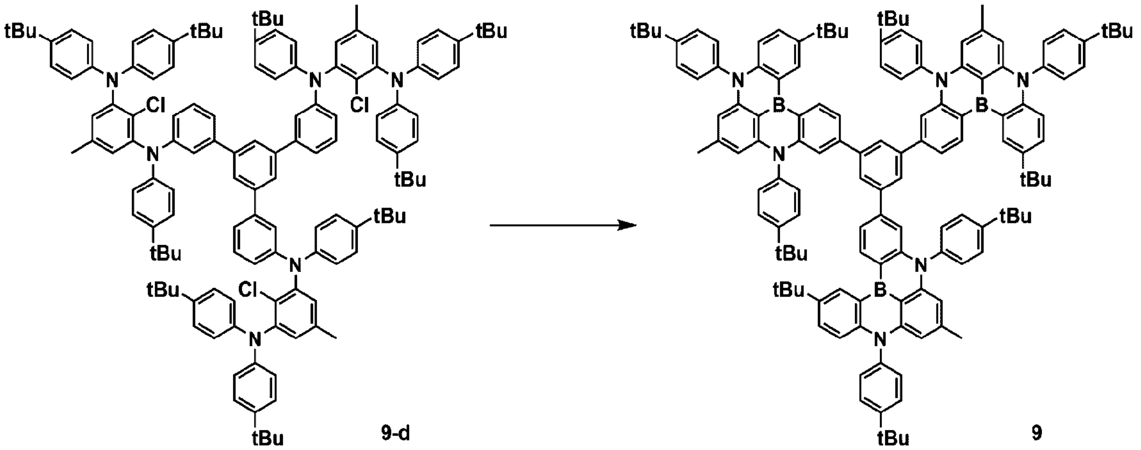

9-d

9

Compound 9 was prepared in the same manner as Compound 1 except that Compound 9-d was used instead of Compound 1-g.
m/z $[M+H]^+$ $C_{135}H_{142}B_3N_6^+$ 1880.2

**Preparation Example 10: Preparation of Compound 10**

**Step 10-1: Synthesis of Intermediate Compound 10-b**

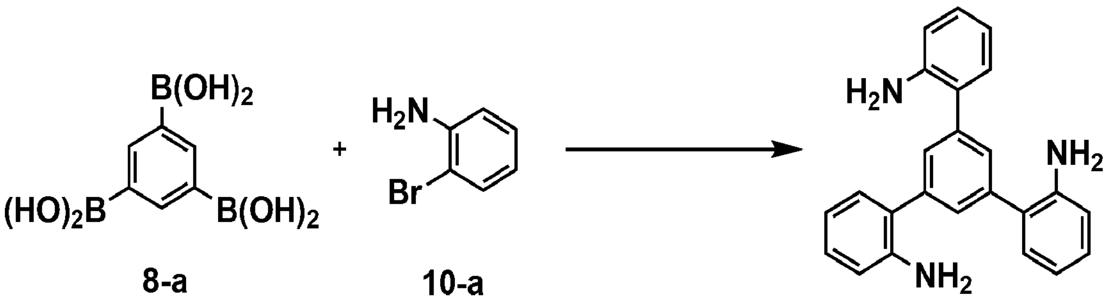

8-a

10-a

10-b

Compound 10-b was prepared in the same manner as Compound 8-c except that Compound 10-a was used instead of Compound 8-b.
m/z $[M+H]^+$ $C_{24}H_{22}N_3^+$ 352.2

**Step 10-2: Synthesis of Intermediate Compound 10-c**

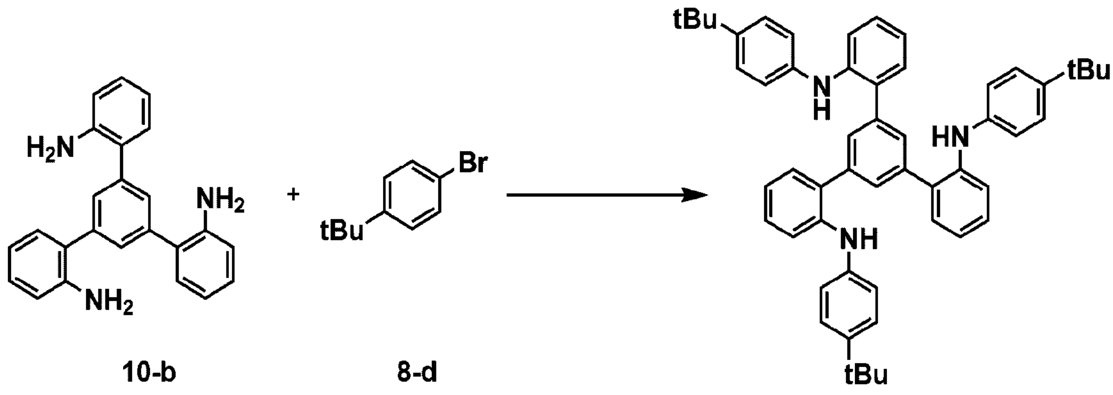

10-b 8-d 10-c

Compound 10-c was prepared in the same manner as Compound 8-e except that Compound 10-b was used instead of Compound 8-c.
m/z $[M+H]^+$ $C_{54}H_{58}N_3^+$ 748.6

**Step 10-3: Synthesis of Intermediate Compound 10-d**

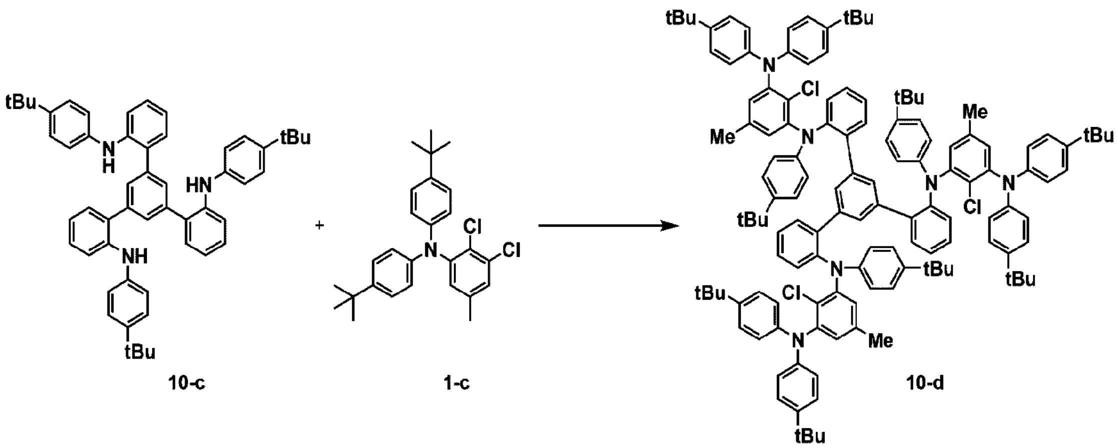

10-c 1-c 10-d

Compound 10-d was prepared in the same manner as Compound 8-f except that Compound 10-c was used instead of Compound 8-e.
m/z $[M+H]^+$ $C_{135}H_{148}Cl_3N_6^+$ 1958.1

**Step 10-4: Synthesis of Final Compound 10**

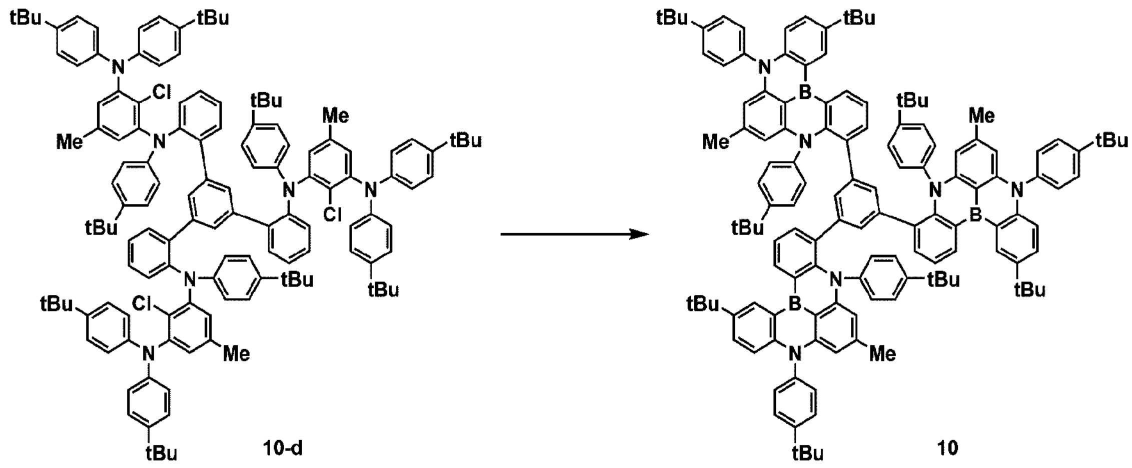

Compound 10 was prepared in the same manner as Compound 1 except that Compound 10-d was used instead of Compound 1-g.
m/z $[M+H]^+$ $C_{135}H_{142}B_3N_6^+$ 1880.2

**Preparation Example 11: Preparation of Compound 11**

**Step 11-1: Synthesis of Intermediate Compound 11-b**

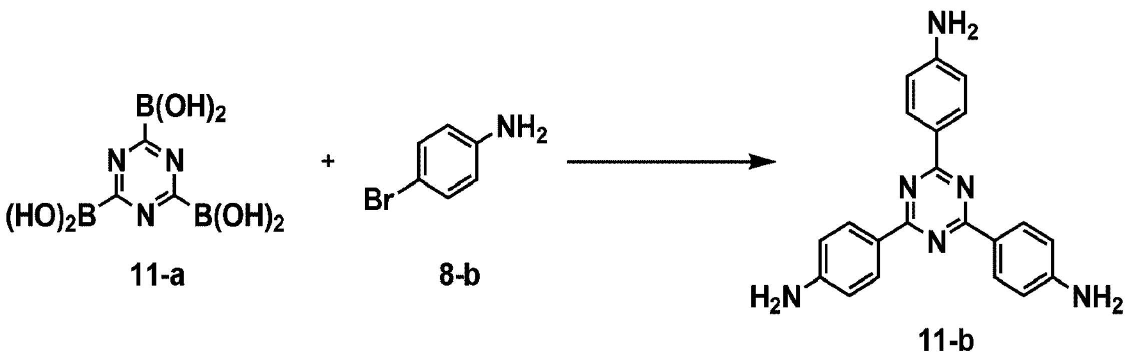

Compound 11-b was prepared in the same manner as Compound 8-c except that Compound 11-a was used instead of Compound 8-a.
m/z $[M+H]^+$ $C_{21}H_{19}N_6^+$ 355.2

**Step 11-2: Synthesis of Intermediate Compound 11-c**

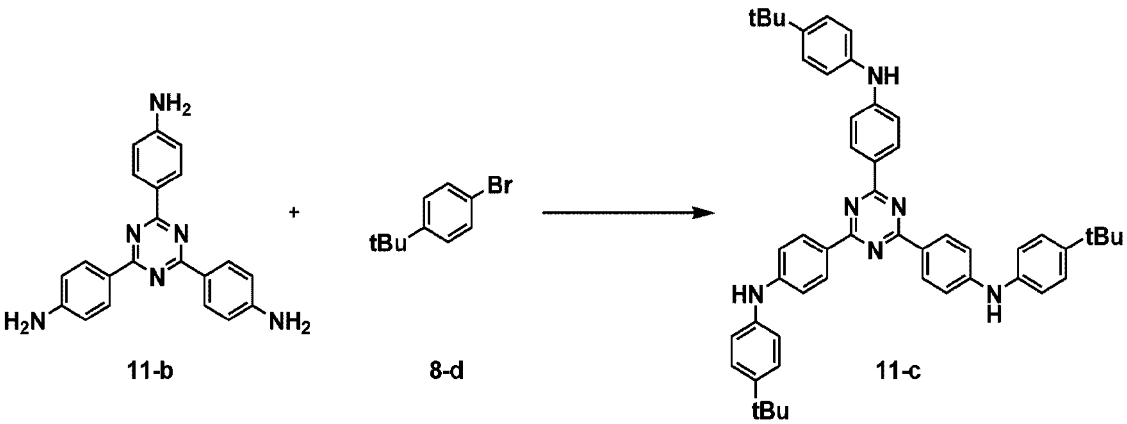

11-b 8-d 11-c

Compound 11-c was prepared in the same manner as Compound 8-e except that Compound 11-b was used instead of Compound 8-c.
m/z $[M+H]^+$ $C_{51}H_{55}N_6^+$ 751.5

**Step 11-3: Synthesis of Intermediate Compound 11-d**

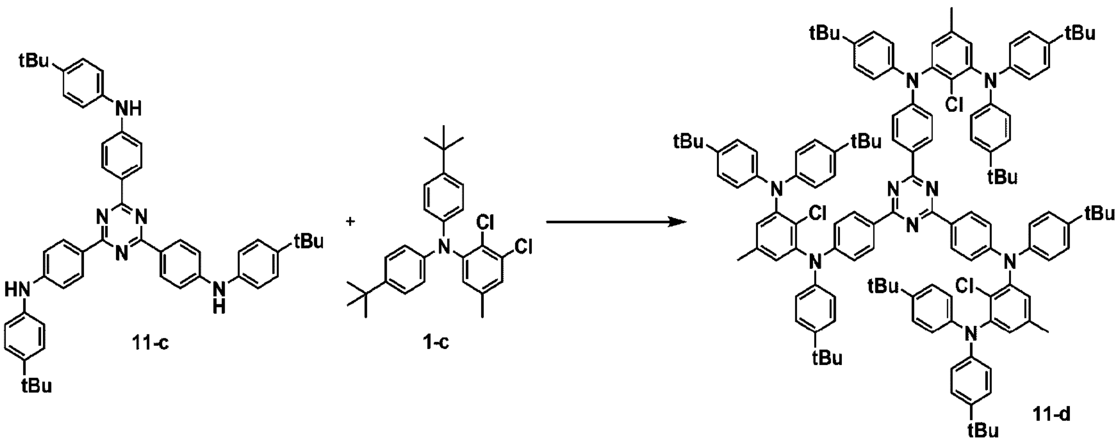

11-c 1-c 11-d

Compound 11-d was prepared in the same manner as Compound 8-f except that Compound 11-c was used instead of Compound 8-e.
m/z $[M+H]^+$ $C_{132}H_{145}Cl_3N_9^+$ 1961.1

**Step 11-4: Synthesis of Final Compound 11**

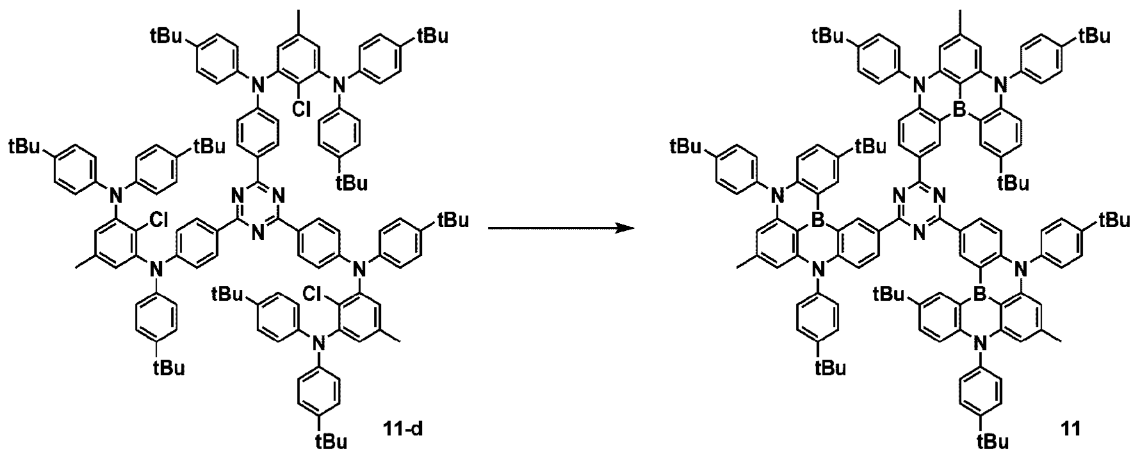

11-d

11

Compound 11 was prepared in the same manner as Compound 8 except that Compound 11-d was used instead of Compound 8-f.
m/z $[M+H]^+$ $C_{132}H_{139}B_3N_9^+$ 1883.2

**Preparation Example 12: Preparation of Compound 12**

**Step 12-1: Synthesis of Compound 12-b**

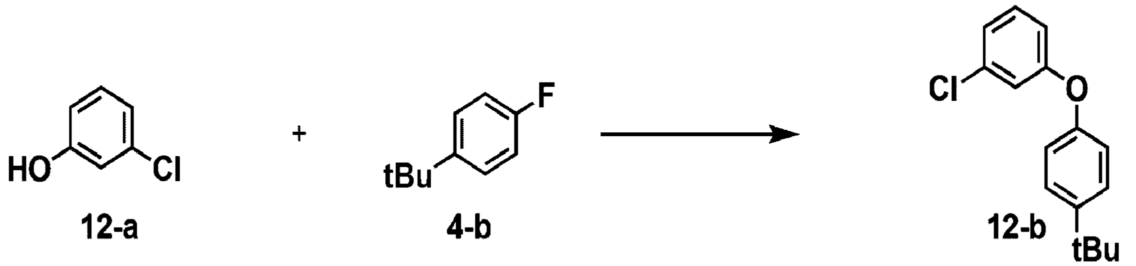

12-a

4-b

12-b

Compound 12-a (3.0 g, 1.0 eq.), Compound 4-b (1.03 eq.) and $K_2CO_3$ (2.0 eq.) were introduced to a round bottom flask, and dissolved in methylpyrrolidone (NMP) (0.3 M). CuI (5 mol%) and iron(III) acetylacetonate ($Fe(acac)_3$) (10 mol%) were added thereto under the nitrogen atmosphere, and the result was stirred for 4 hours after raising the temperature to 150°C. After the reaction, the reaction solution was cooled to room temperature, and washed with EtOAc/sat. $NH_4Cl$ (aq.) to separate the organic layer. Water was removed using $MgSO_4$, and the result was passed through a Celite-Florisil-Silica pad. The passed solution was concentrated under vacuum, and then purified using column chromatography to obtain Compound 12-b (5.1 g).
m/z $[M+H]^+$ $C_{16}H_{19}O_2^+$ 243.2

**Step 12-2: Synthesis of Intermediate Compound 12-c**

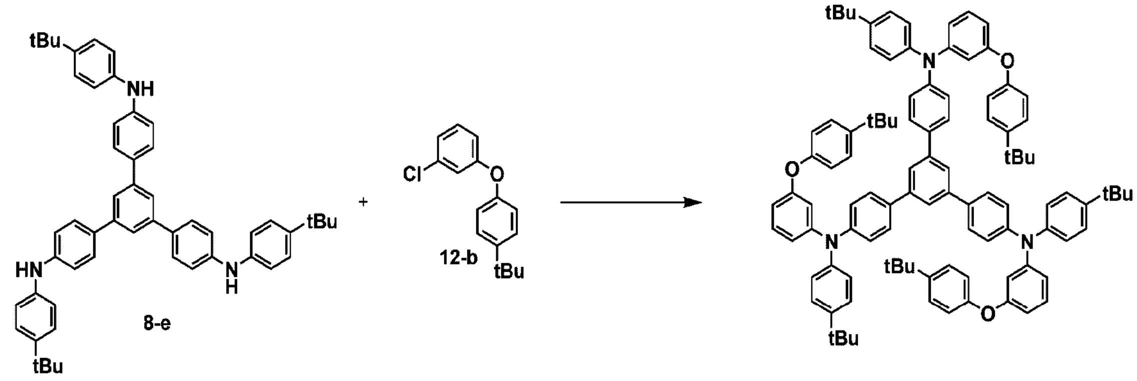

8-e 12-b 12-c

Compound 8-e (1.0 eq.), Compound 12-b (3.3 eq.) and NaOt-Bu (6.0 eq.) were introduced to a round bottom flask, and dissolved in anhydrous toluene. After that, the result was stirred for 10 minutes at room temperature while charging the flask with nitrogen gas, and the oil container temperature was raised from room temperature to 110°C. When the inner temperature became 60°C, Pd((*t*-Bu)$_3$P)$_2$ (9 mol%) was added dropwise thereto, and the result was stirred overnight. After the reaction, the result was washed with $CH_2Cl_2/H_2O$ to separate the organic layer. Water was removed using $MgSO_4$, and the result was passed through a Celite-Florisil-Silica pad. The passed solution was concentrated under vacuum, and then purified using column chromatography to obtain Compound 12-c (5.2 g).
m/z $[M+H]^+$ $C_{102}H_{106}N_3O_3^+$ 1420.8

**Step 12-3: Synthesis of Final Compound 12**

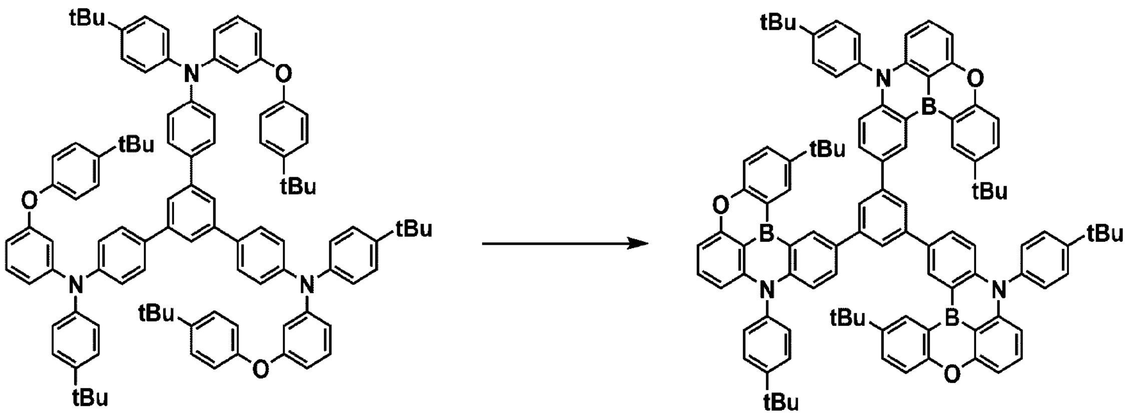

12-c 12

Compound 12 was prepared in the same manner as Compound 4 except that Compound 12-c was used instead of Compound 4-e.
m/z $[M+H]^+$ $C_{102}H_{97}B_3N_3O_3^+$ 1444.8

**[Comparative Preparation Example]**

**Comparative Preparation Example 1: Preparation of Comparative Compound E**

**Step E-1: Synthesis of Intermediate Compound E-b**

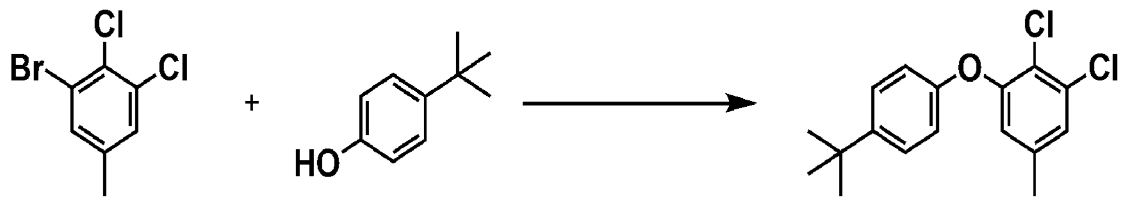

1-a E-a E-b

Compound 1-a (3.0 g, 1.0 eq.), Compound E-a (1.03 eq.) and $K_2CO_3$ (2.0 eq.) were introduced to a round bottom flask, and dissolved in NMP (0.3 M). CuI (5 mol%) and $Fe(acac)_3$ (10 mol%) were added thereto under the nitrogen atmosphere, and the result was stirred for 4 hours after raising the temperature to 150°C. After the reaction, the reaction solution was cooled to room temperature, and washed with EtOAc/sat. $NH_4Cl$ (aq.) to separate the organic layer. Water was removed using $MgSO_4$, and the result was passed through a Celite-Florisil-Silica pad. The passed solution was concentrated under vacuum, and then purified using column chromatography to obtain Compound E-b (28.0 g, 87% yield).
m/z $[M+H]^+$ $C_{16}H_{18}ClO^+$ 260.1

**Step E-2: Synthesis of Intermediate Compound E-d**

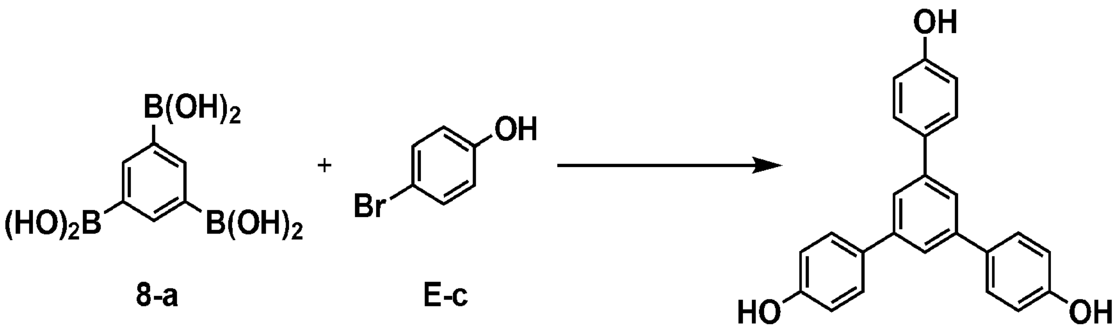

8-a E-c E-d

Compound E-d was prepared in the same manner as Compound 8-c except that Compound E-c was used instead of Compound 8-b.
m/z $[M+H]^+$ $C_{24}H_{19}O_3^+$ 355.2

**Step E-3: Synthesis of Intermediate Compound E-e**

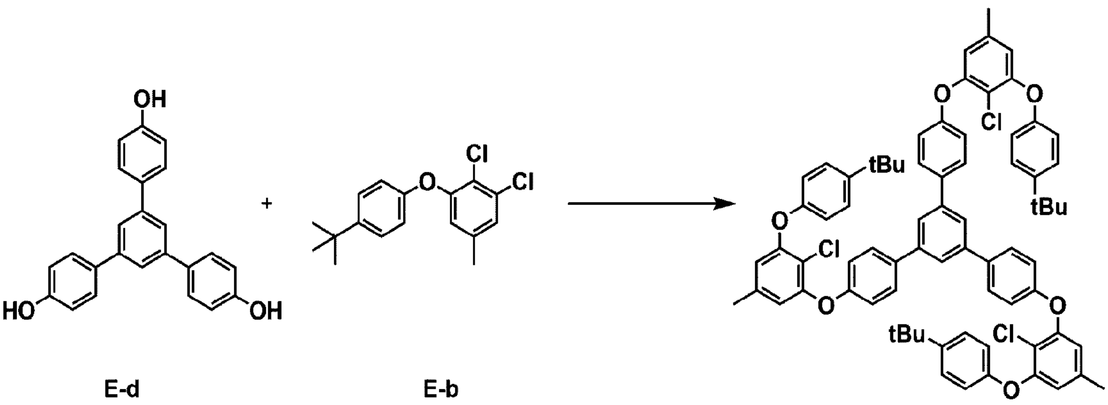

E-d E-b E-e

Compound E-d (3.0 g, 1.0 eq.), Compound E-b (3.6 eq.) and $K_2CO_3$ (6.0 eq.) were introduced to a round bottom flask, and dissolved in NMP (0.3 M). CuI (15 mol%) and $Fe(acac)_3$ (30 mol%) were added thereto under the nitrogen atmosphere, and the result was stirred overnight after raising the temperature to 150°C. After the reaction, the reaction solution was cooled to room temperature, and washed with EtOAc/sat. $NH_4Cl$ (aq.) to separate the organic layer. Water was removed using $MgSO_4$, and the result was passed through a Celite-Florisil-Silica pad. The passed solution was concentrated under vacuum, and then purified using column chromatography to obtain Compound E-e (9.8 g, 59% yield).
m/z $[M+H]^+$ $C_{75}H_{70}Cl_3O_6^+$ 1171.4

**Step E-4: Synthesis of Final Compound E**

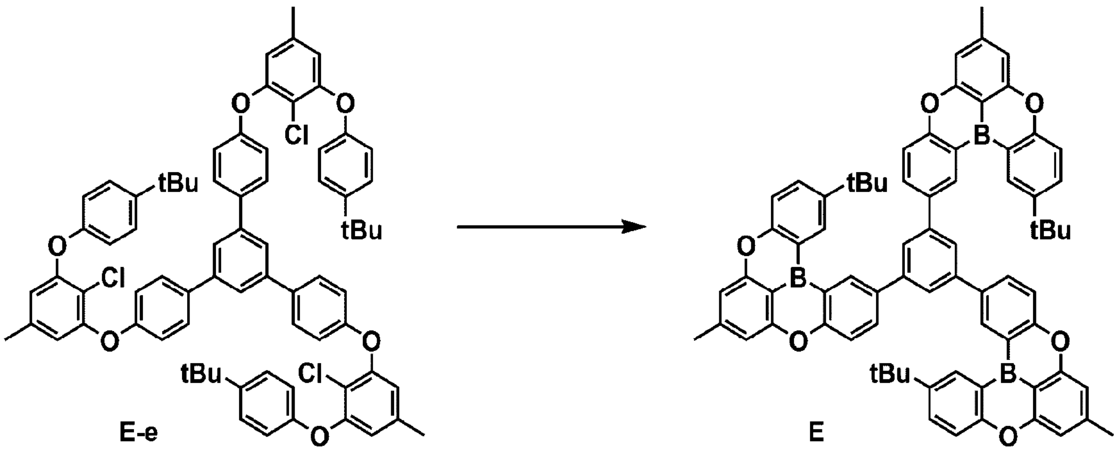

E-e

E

Compound E was prepared in the same manner as Compound 1 except that Compound E-e was used instead of Compound 1-g.
m/z $[M+H]^+$ $C_{75}H_{64}B_3O_6^+$ 1093.7

**Example 1: Manufacture of Organic Light Emitting Device**

A glass substrate on which indium tin oxide (ITO) was coated as a thin film to a thickness of 500 Å was placed in detergent-dissolved distilled water and ultrasonic cleaned. Herein, a product of Fischer Co. was used as the detergent, and as the distilled water, distilled water filtered twice with a filter manufactured by Millipore Co. was used. After the ITO was cleaned for 30 minutes, ultrasonic cleaning was repeated twice using distilled water for 10 minutes. After the cleaning with distilled water was finished, the substrate was ultrasonic cleaned with solvents of isopropyl alcohol and acetone, then dried, and then the substrate was transferred to a glove box after washing the substrate for 5 minutes.

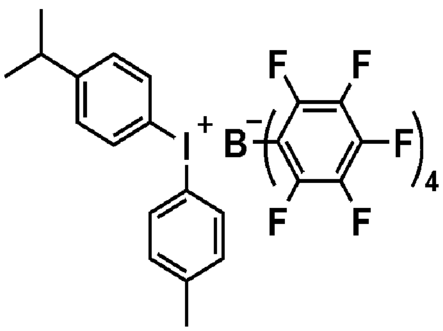

O

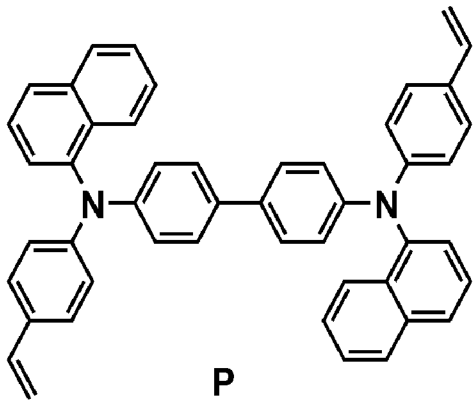

P

On the transparent ITO electrode, a coating composition obtained by dissolving Compound O and Compound P (weight ratio of 2:8) in cyclohexanone (20 wt/v%) was spin coated (4000 rpm), and heat treated (cured) for 30 minutes at 200 °C to form a hole injection layer having a thickness of 400 Å.

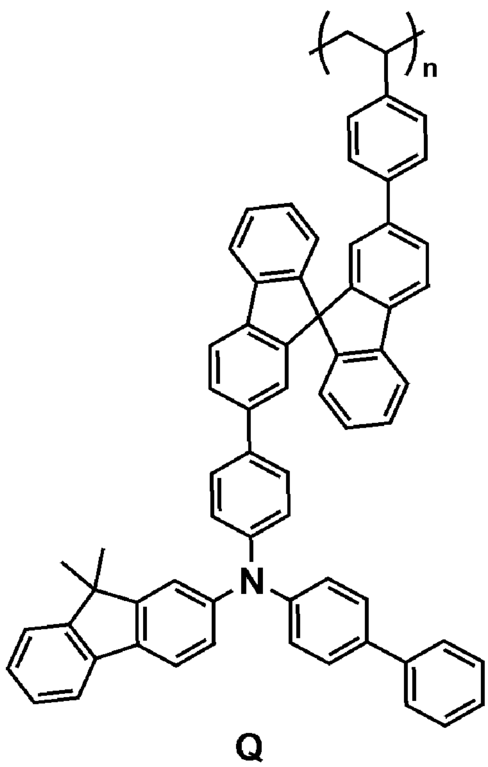

Q

On the hole injection layer, a coating composition obtained by dissolving Compound Q (Mn: 27,900; Mw: 35,600; measured by GPC with a PC standard using Agilent 1200 series) in toluene (6 wt/v%) was spin coated (4000 rpm), and heat treated for 30 minutes at 200°C to form a hole transfer layer having a thickness of 200 Å.

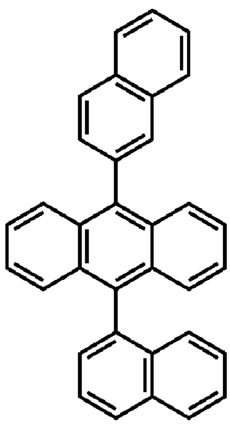

R

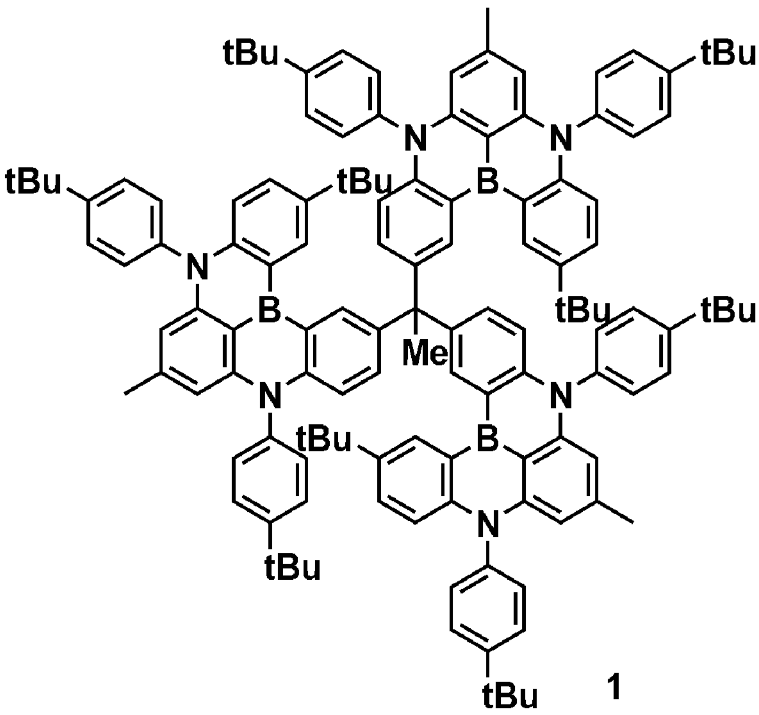

1

On the hole transfer layer, a coating composition obtained by dissolving Compound 1 prepared above and Compound R (weight ratio of 2:98) in cyclohexanone (2 wt/v%) was spin coated (4000 rpm), and heat treated for 30 minutes at 180°C to form a light emitting layer having a thickness of 400 Å.

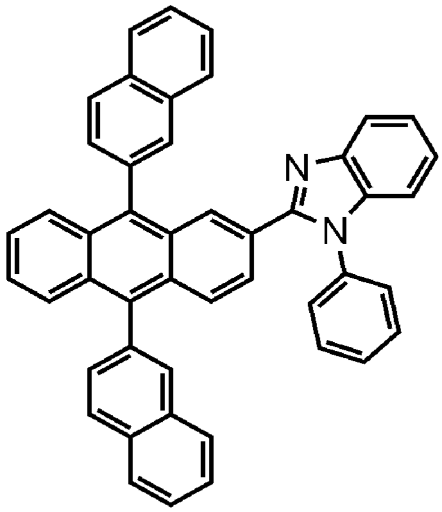

S

After transferring the result to a vacuum deposition apparatus, Compound S was vacuum deposited on the light emitting layer to a thickness of 350 Å to form an electron injection and transfer layer. On the electron injection and transfer layer, a cathode was formed by consecutively depositing LiF to a thickness of 10 Å and aluminum to a thickness of 1000 Å.

In the above-mentioned process, the deposition rates of the organic materials were maintained at 0.4 Å/sec to 0.7 Å/sec, the deposition rates of the LiF and the aluminum were maintained at 0.3 Å/sec and 2 Å/sec, respectively, and the degree of vacuum during the deposition was maintained at $2x10^{-7}$ torr to $5x10^{-8}$ torr.

**Examples 2 to 12**

Organic light emitting devices were manufactured in the same manner as in Example 1 except that compounds described in the following Table 1 (following compounds) were used instead of Compound 1 as a dopant of the light emitting layer.

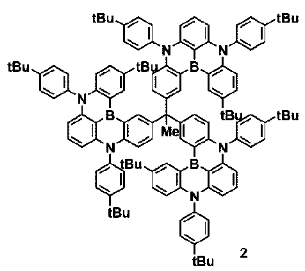

2

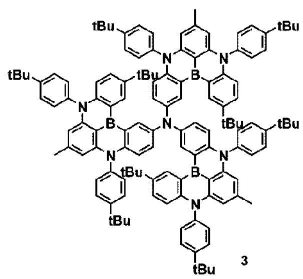

3

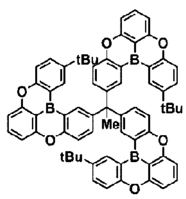

4

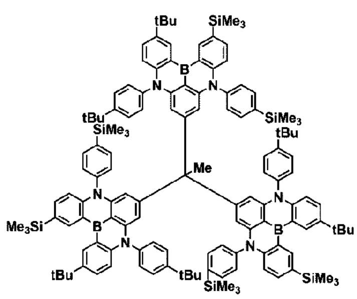

5

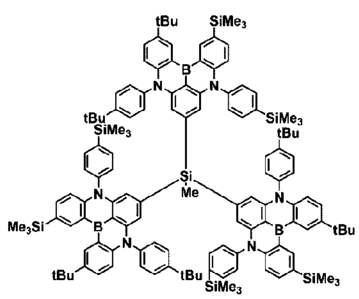

6

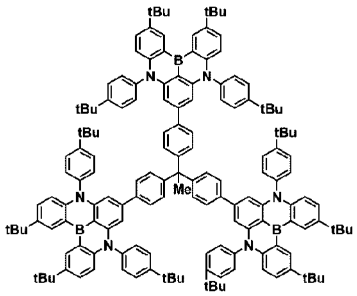

7

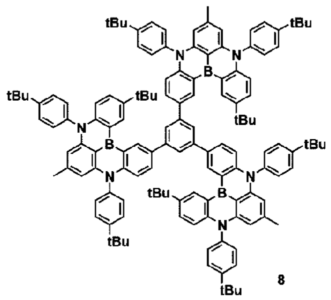

8

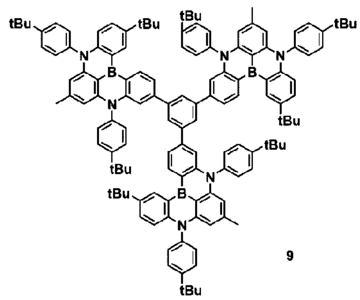

9

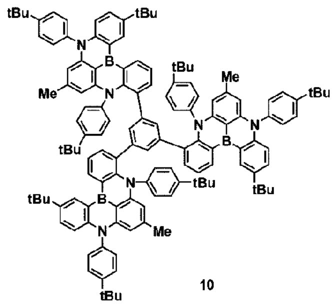

10

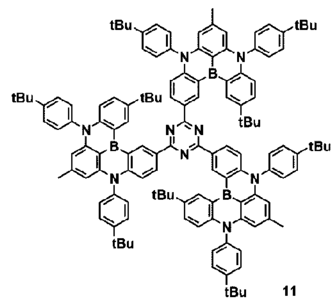

11

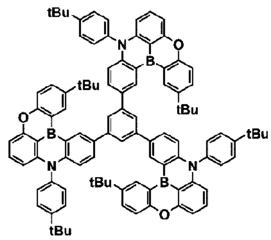

12

## Comparative Examples 1 to 5

Organic light emitting devices were manufactured in the same manner as in Example 1 except that compounds described in the following Table 1 (following compounds) were used instead of Compound 1 as a dopant of the light emitting layer.

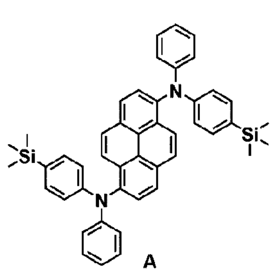

A

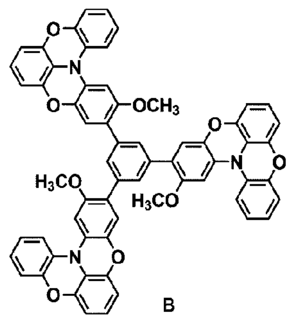

B

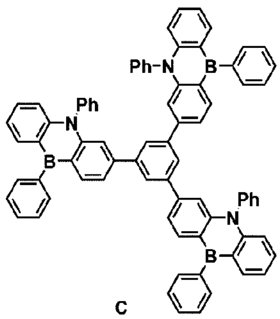

C

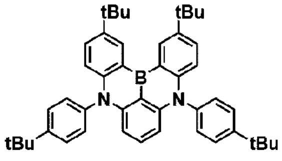

D

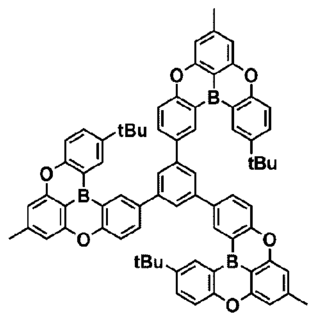

E

## Experimental Example 1: Evaluation of Organic Light Emitting Device Properties

When applying a current to each of the organic light emitting devices manufactured in the examples and the

comparative examples, results of measuring driving voltage, external quantum efficiency (EQE) and lifetime at current density of 10 $mA/cm^2$ are shown in the following Table 1. Herein, the external quantum efficiency (EQE) was calculated by "(the number of photons emitted)/(the number of charge carriers injected)*100", and T90 means time taken for luminance to decrease to 90% from initial luminance (500 nit).

[Table 1]

| | Compound (Light Emitting Layer Dopant) | Driving Voltage ($V@10 mA/cm^2$ ) | EQE (%@10 $mA/cm^2$ ) | Lifetime (hr) (T90@500 nit) |
|---|---|---|---|---|
| Example 1 | Compound 1 | 4.52 | 9.23 | 139 |
| Example 2 | Compound 2 | 4.58 | 9.18 | 129 |
| Example 3 | Compound 3 | 4.56 | 9.19 | 130 |
| Example 4 | Compound 4 | 4.63 | 9.01 | 119 |
| Example 5 | Compound 5 | 4.57 | 9.18 | 132 |
| Example 6 | Compound 6 | 4.55 | 9.10 | 129 |
| Example 7 | Compound 7 | 4.59 | 9.12 | 127 |
| Example 8 | Compound 8 | 4.61 | 9.03 | 123 |
| Example 9 | Compound 9 | 4.60 | 9.02 | 121 |
| Example 10 | Compound 10 | 4.59 | 9.12 | 125 |
| Example 11 | Compound 11 | 4.60 | 9.02 | 122 |
| Example 12 | Compound 12 | 4.58 | 8.99 | 120 |
| Comparative Example 1 | Compound A | 4.61 | 6.72 | 60 |
| Comparative Example 2 | Compound B | 4.60 | 6.89 | 58 |
| Comparative Example 3 | Compound C | 4.59 | 6.99 | 52 |
| Comparative Example 4 | Compound D | 4.58 | 6.23 | 49 |
| Comparative Example 5 | Compound E | 4.67 | 8.34 | 100 |

As shown in Table 1, it was seen that the organic light emitting device using the compound of the present disclosure as a light emitting layer dopant exhibited very superior properties in terms of lifetime compared to the organic light emitting device using the comparative example compound as a light emitting layer dopant.

Specifically, it was identified that the organic light emitting devices of Comparative Example 1 of the present application had an enhanced lifetime compared to Examples 1 to 11 using a general dopant.

In addition, the compound of Comparative Example 2 is different in that a nitrogen atom bonds to a boron atom position. The compound of Comparative Example 3 has a structure different from the boron heteroring of the present disclosure. Comparative Example 4 is different in that it is a monomer including only one boron heteroring of the present disclosure. The compound of Comparative Example 5 is different in that L is phenylene, and Y1 and Y2 are all O. Accordingly, from such differences, it was identified that an effect of long lifetime was obtained when using the compound of Chemical Formula 1 of the present disclosure in an organic light emitting device.

In addition, when comparing Example 1 with the compounds of Examples 1 to 7, the compound in which Y1 and Y2 are NR" had superior effects in terms of efficiency and lifetime compared to Compound 4 in which Y1 and Y2 are O.

Particularly, the compounds of Examples 1, 3, 8 and 11 are different in L, and it was identified that Compounds 1 and 3 in which L is CR and N had superior effects in terms of voltage, efficiency and lifetime compared to the compound in which L is

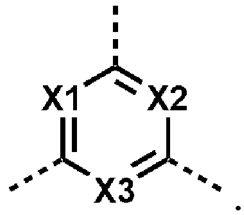

## Claims

**1.** A compound represented by the following Chemical Formula 1:

[Chemical Formula 1]

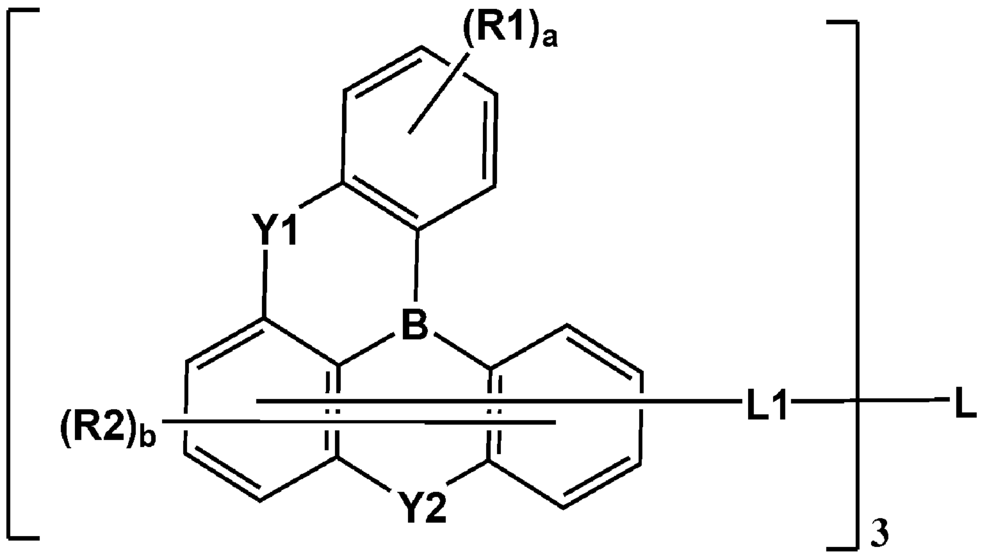

wherein, in Chemical Formula 1,

L is CR, N, SiR' or

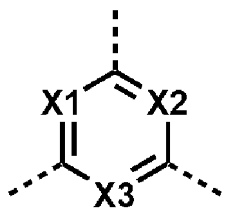
;

X1 to X3 are the same as or different from each other, and each independently CH or N;
L1 is a direct bond; or a substituted or unsubstituted arylene group;
Y1 and Y2 are the same as or different from each other, and each independently NR", O or S;
R1, R2, R, R' and R" are the same as or different from each other, and each independently hydrogen; deuterium; a halogen group; a nitrile group; a substituted or unsubstituted alkyl group; a substituted or unsubstituted alkoxy group; a substituted or unsubstituted cycloalkyl group; a substituted or unsubstituted silyl group; a substituted or unsubstituted amine group; a substituted or unsubstituted aryl group; a substituted or unsubstituted heteroaryl group; substituted or unsubstituted $C_{2-60}$ alkynyl; substituted or unsubstituted tri ($C_{1-60}$ alkyl) silyl; or substituted or unsubstituted tri($C_{6-60}$ aryl)silyl;
a is an integer of 0 to 4, and when a is 2 or greater, R1s are the same as or different from each other;
b is an integer of 0 to 6, and when b is 2 or greater, R2s are the same as or different from each other;

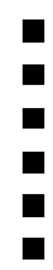

means a bond linked to Chemical Formula 1;
when X1 to X3 are CH, at least one of Y1 and Y2 is NR" or S; and
structures in the square bracket [] are the same as or different from each other.

2. The compound of Claim 1, wherein structures in the square bracket [] of Chemical Formula 1 are the same as each other.

3. The compound of Claim 1, wherein L is CR, N or SiR’.

4. The compound of Claim 1, wherein L is

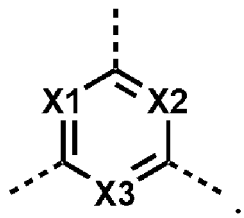

5. The compound of Claim 1, wherein the structure of Chemical Formula 1 is represented by any one of the following Chemical Formulae 2 to 5:

[Chemical Formula 2]

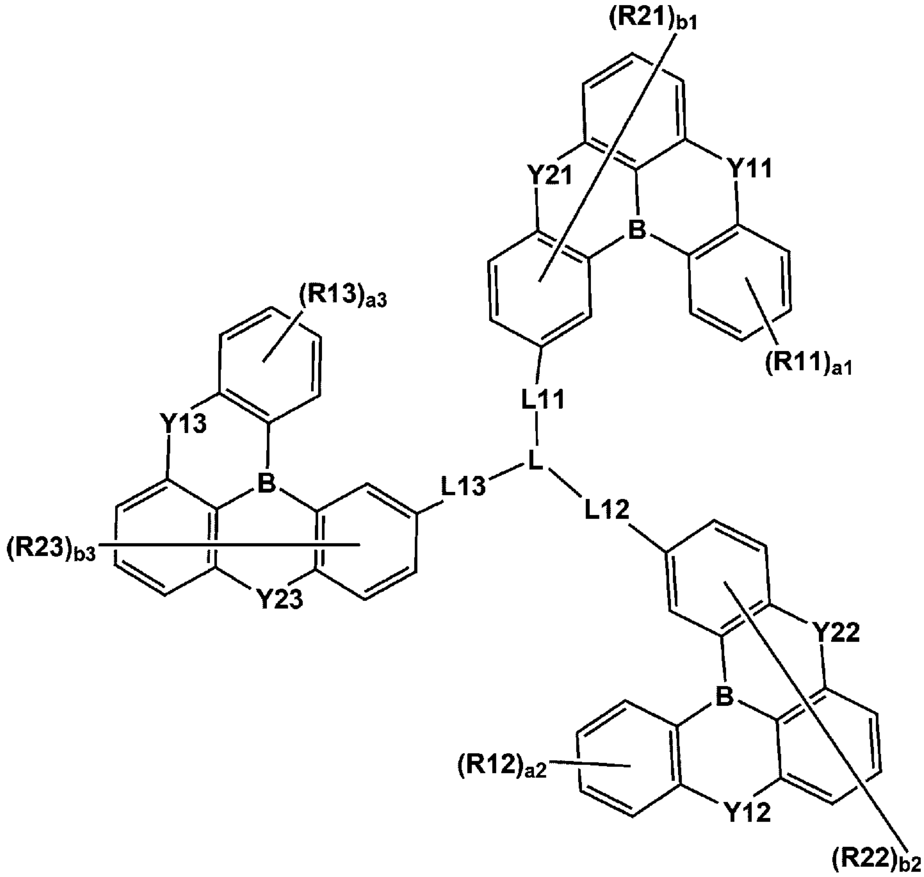

[Chemical Formula 3]

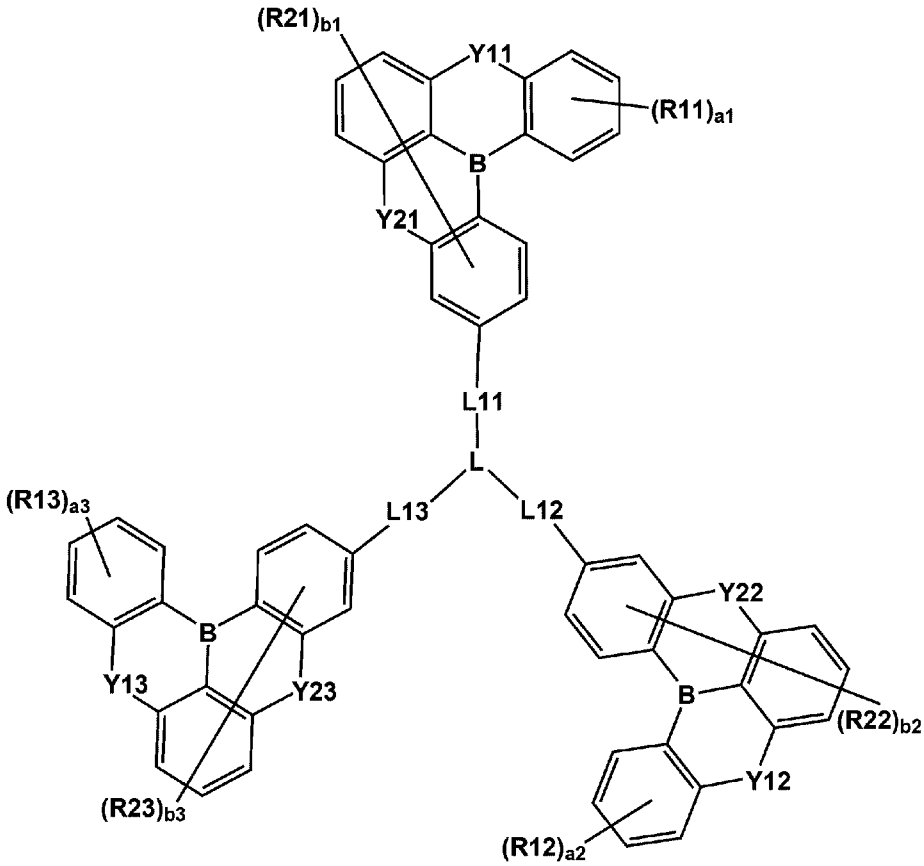

[Chemical Formula 4]

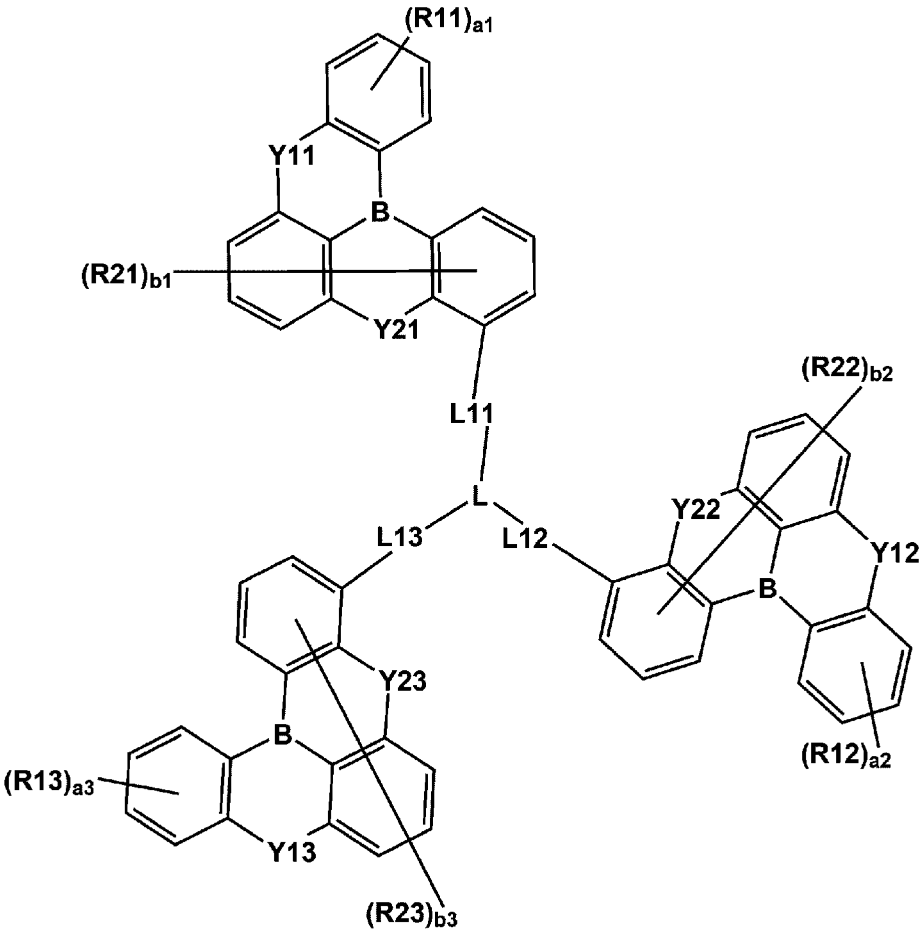

[Chemical Formula 5]

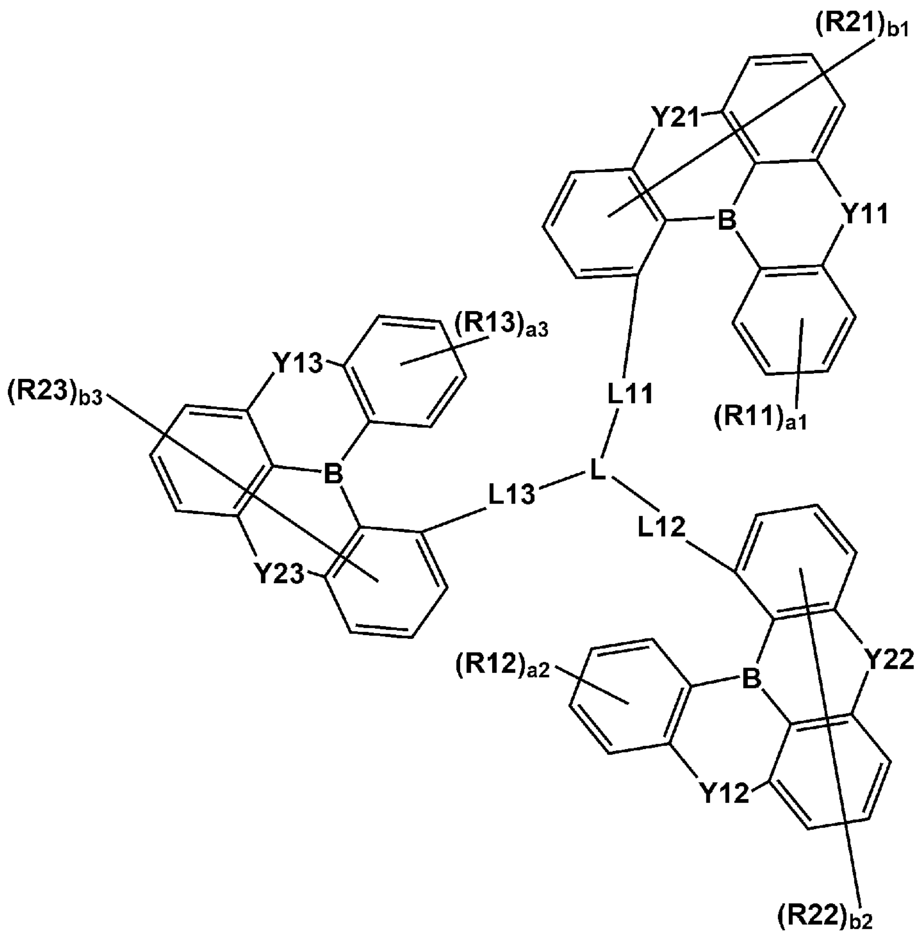

in Chemical Formulae 2 to 5,
L has the same definition as in Chemical Formula 1;
L11 to L13 are the same as or different from each other, and each independently have the same definition as L1 of Chemical Formula 1;
Y11 to Y13 and Y21 to Y23 have the same definitions as Y1 and Y2 in Chemical Formula 1;
R11 to R13 and R21 to R23 have the same definitions as R1 and R2 in Chemical Formula 1;
a1 to a3 have the same definition as a in Chemical Formula 1; and
b1 to b3 have the same definition as b in Chemical Formula 1.

**6.** The compound of Claim 1, wherein the structure of Chemical Formula 1 is represented by the following Chemical Formula 6 or 7:

[Chemical Formula 6]

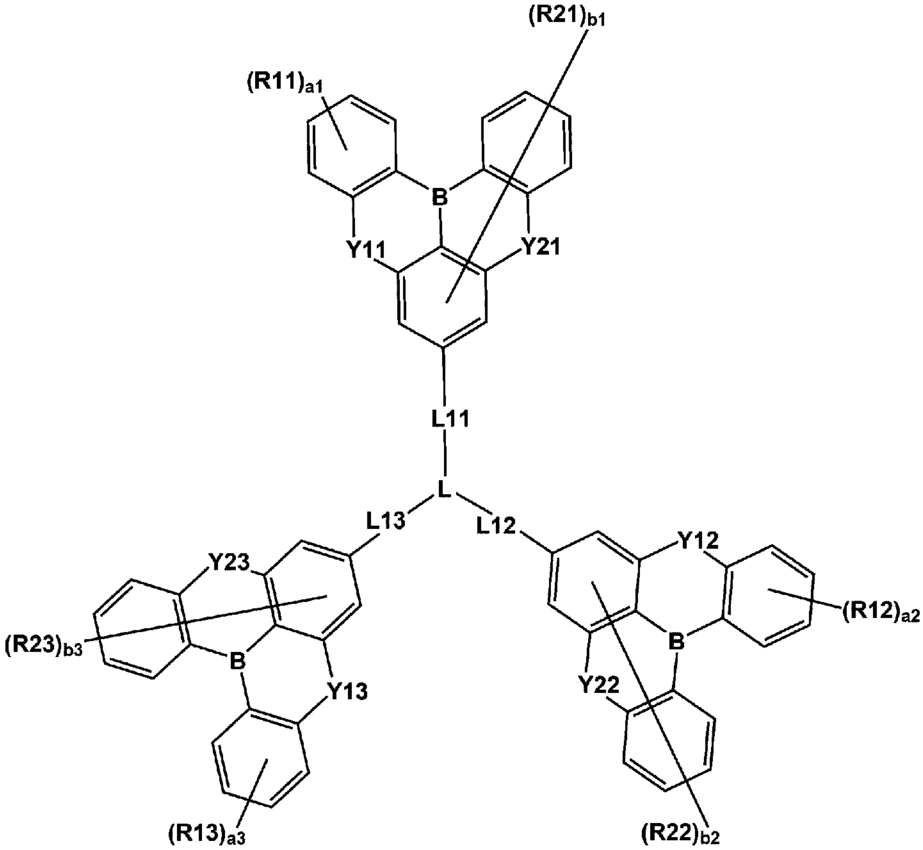

[Chemical Formula 7]

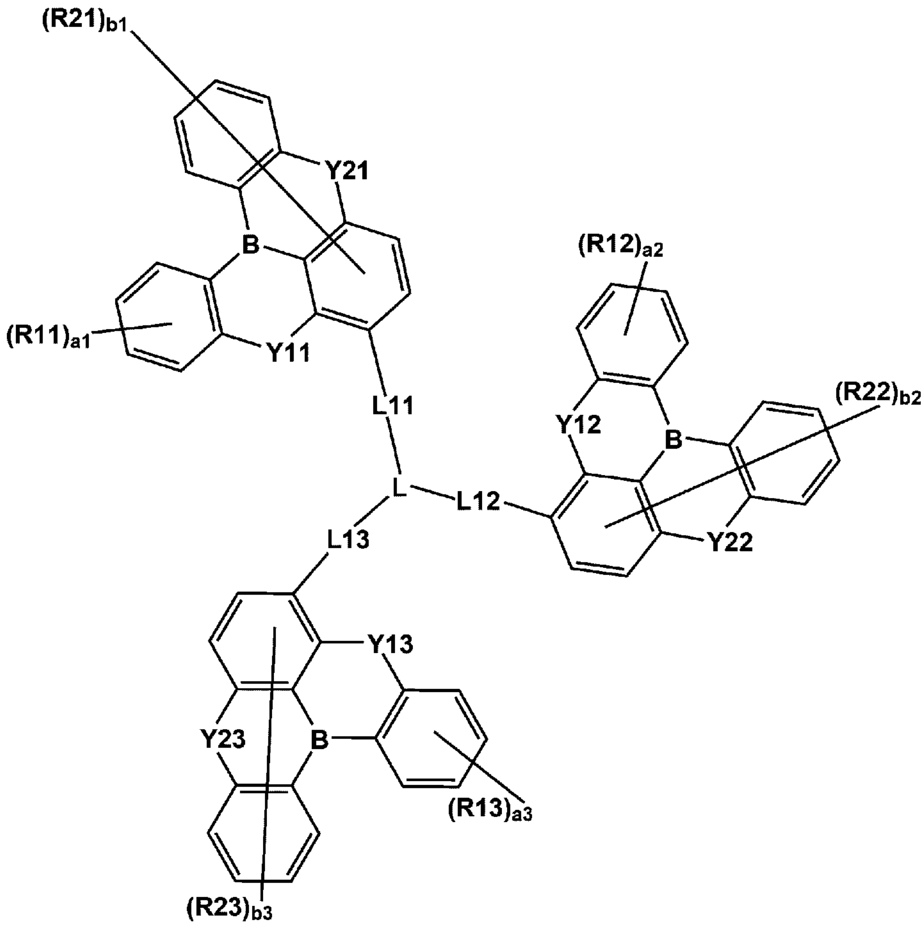

in Chemical Formulae 6 and 7,

L has the same definition as in Chemical Formula 1;

L11 to L13 are the same as or different from each other, and each independently have the same definition as L1 of Chemical Formula 1;

Y11 to Y13 and Y21 to Y23 have the same definitions as Y1 and Y2 in Chemical Formula 1;

R11 to R13 and R21 to R23 have the same definitions as R1 and R2 in Chemical Formula 1;

a1 to a3 have the same definition as a in Chemical Formula 1; and

b1 to b3 have the same definition as b in Chemical Formula 1.

**7.** The compound of Claim 1, wherein L is CR, N or SiR', and R and R' are the same as or different from each other and each independently hydrogen; or an alkyl group having 1 to 10 carbon atoms.

**8.** The compound of Claim 1, wherein Y1 and Y2 are NR", and R" is a substituted or unsubstituted aryl group having 6 to 20 carbon atoms; or a substituted or unsubstituted heteroaryl group having 2 to 20 carbon atoms.

**9.** The compound of Claim 1, wherein Y1 and Y2 are NR", and R" is an aryl group substituted with a substituent selected from the group consisting of an alkyl group, a silyl group, an amine group, an aryl group and a heteroaryl group.

**10.** The compound of Claim 1, wherein R1 and R2 are the same as or different from each other, and each independently hydrogen; deuterium; an alkyl group having 1 to 10 carbon atoms; a silyl group substituted with an alkyl group having 1 to 10 carbon atoms; an amine group substituted with an aryl group having 6 to 20 carbon atoms; a substituted or unsubstituted aryl group having 6 to 20 carbon atoms; or a substituted or unsubstituted heteroaryl group having 2 to 20 carbon atoms; and

the aryl group and the heteroaryl group is unsubstituted or substituted with one or more substituents selected from the group consisting of an alkyl group having 1 to 10 carbon atoms; a silyl group substituted with an alkyl group having 1 to 10 carbon atoms; an amine group substituted with an aryl group having 6 to 20 carbon atoms; an aryl group having 6 to 20 carbon atoms; and a heteroaryl group having 2 to 20 carbon atoms.

**11.** The compound of Claim 1, wherein the compound of Chemical Formula 1 is selected from among the following structural formulae:

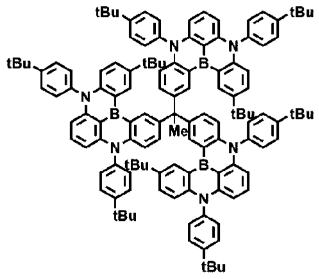
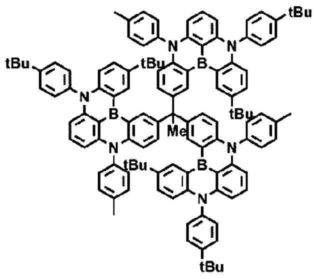
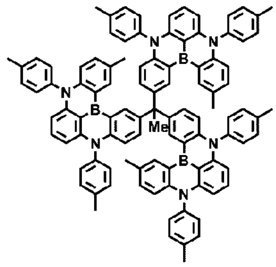

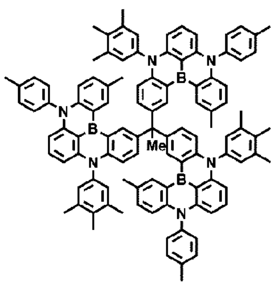
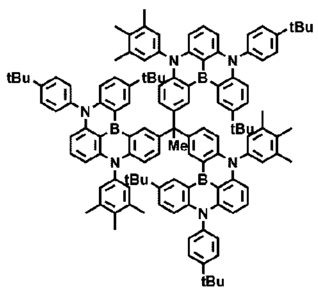
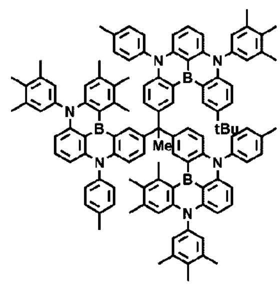

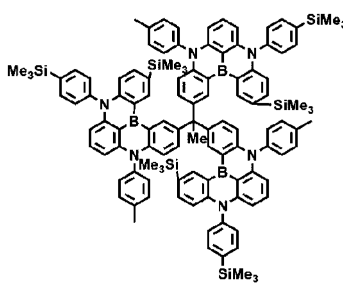
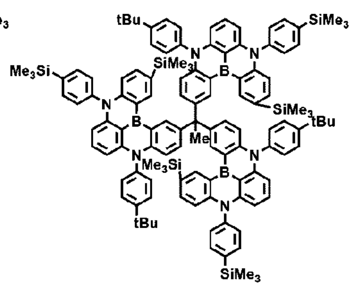
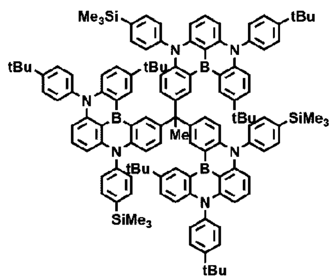

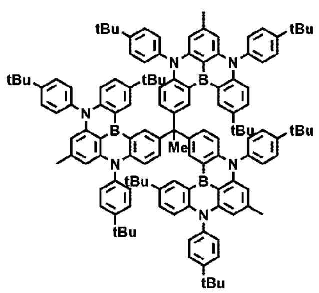
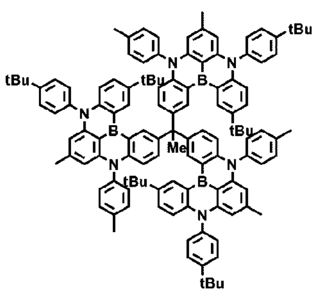
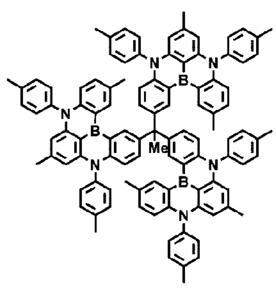

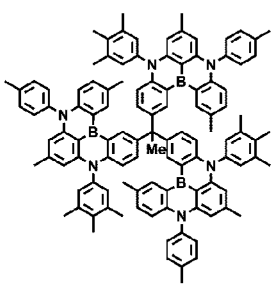
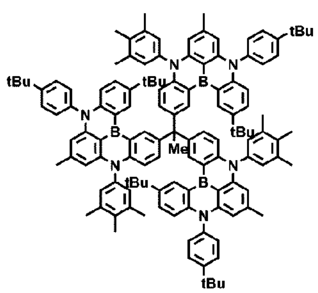
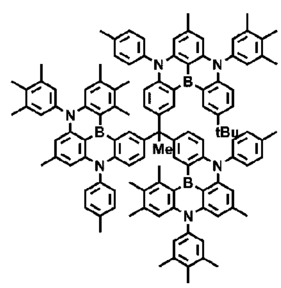

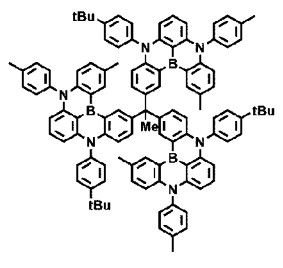
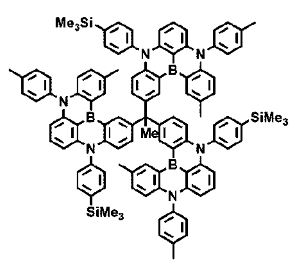
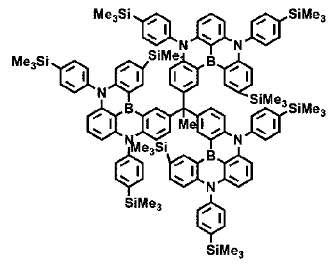

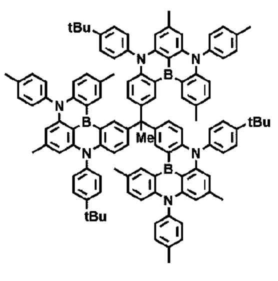
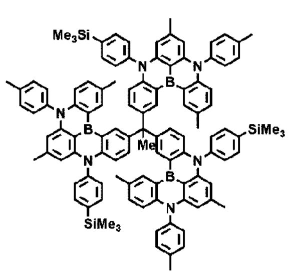
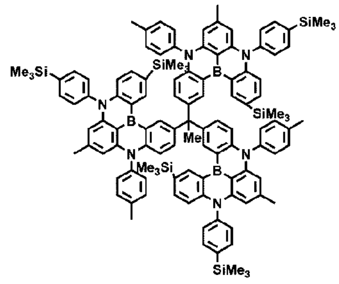

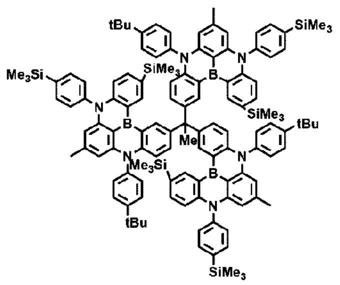
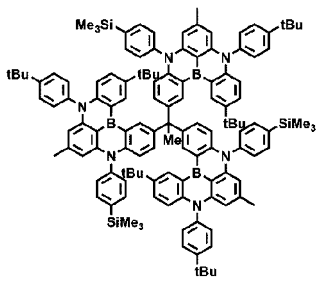
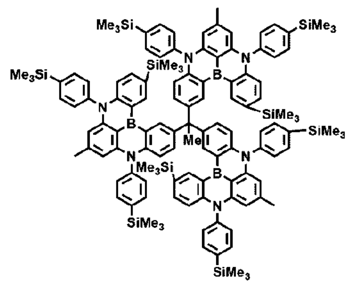

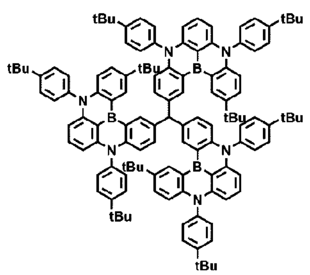
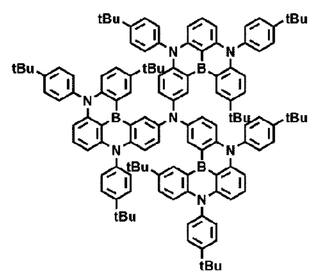
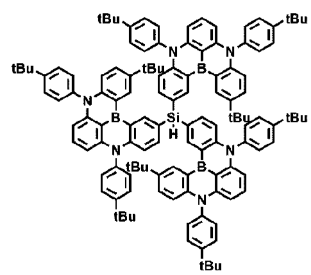

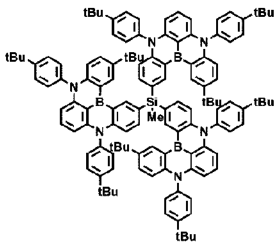

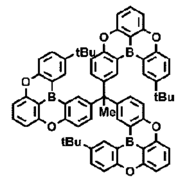

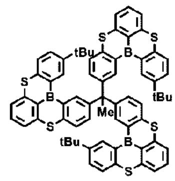

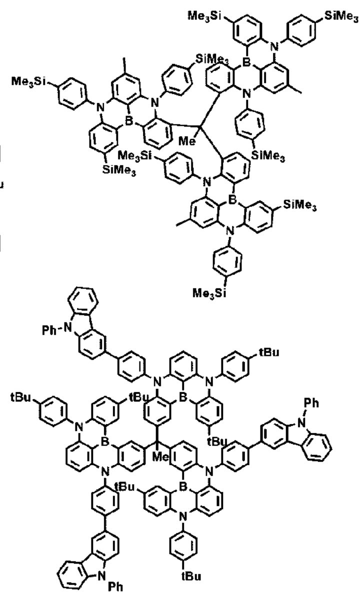

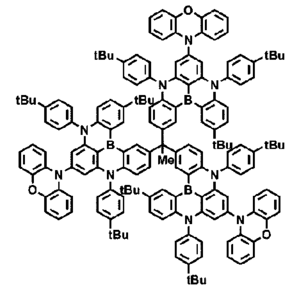

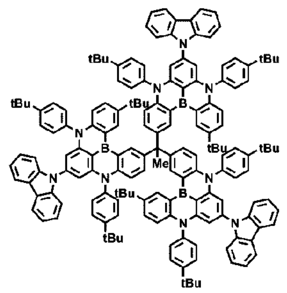

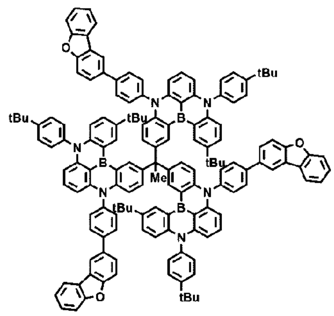

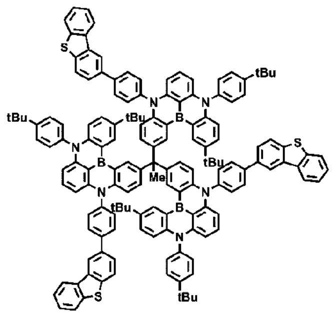

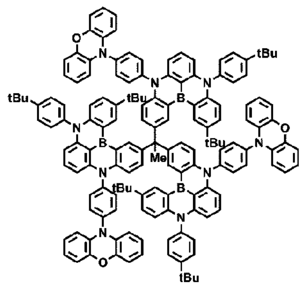

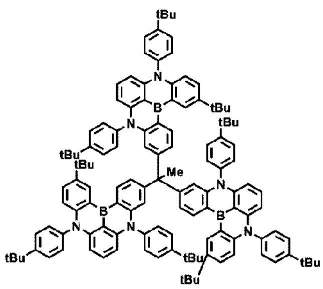

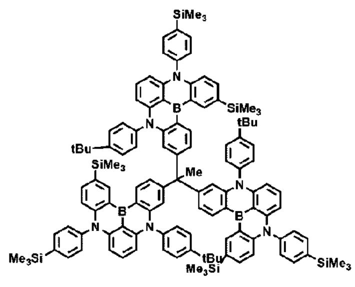

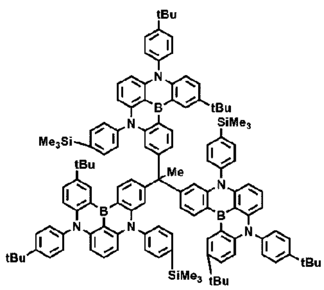

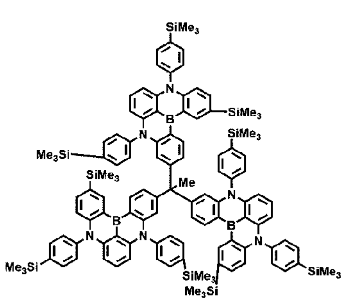

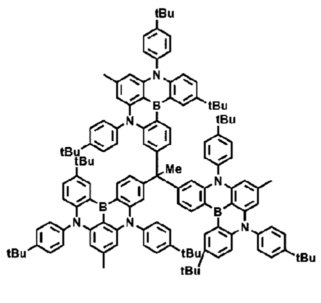

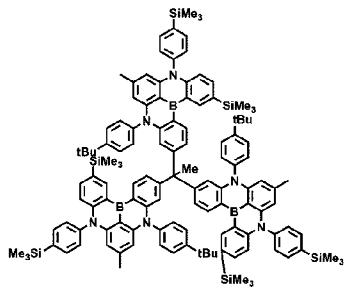

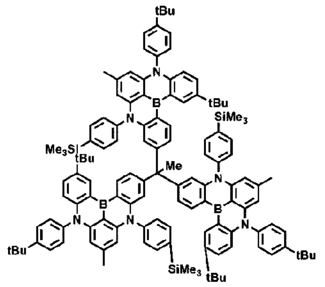
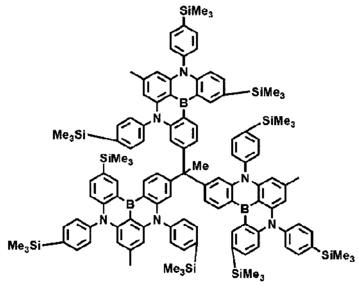
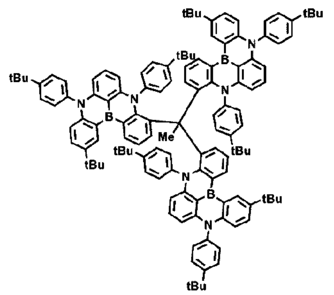

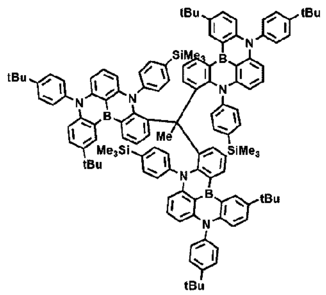
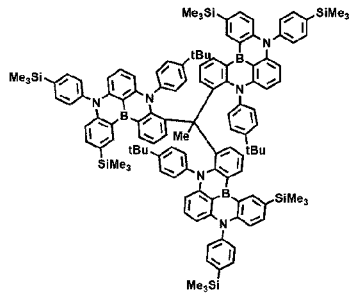
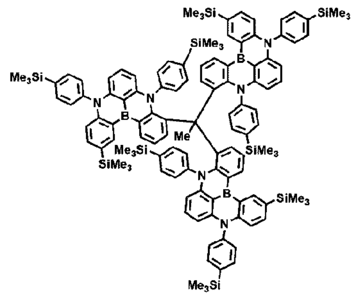

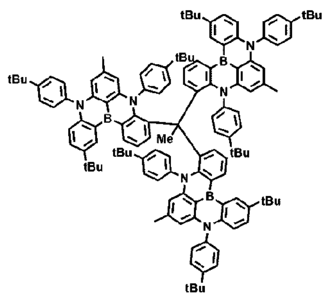
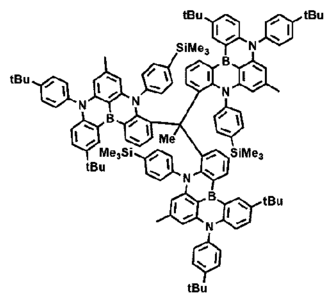
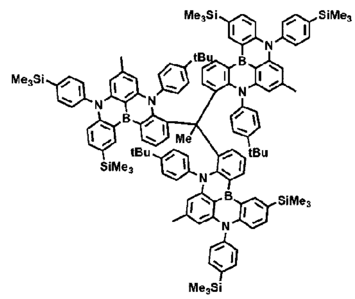

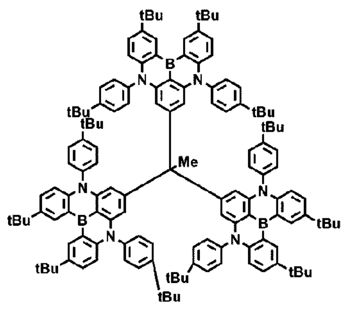
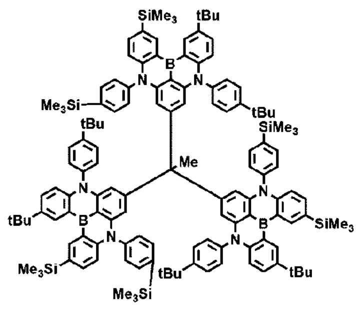
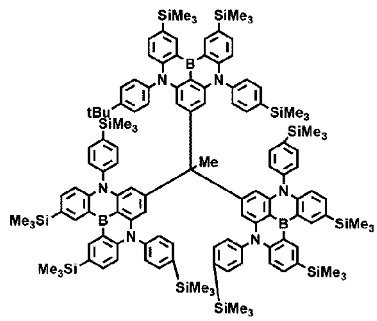

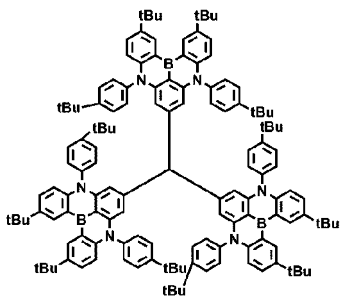
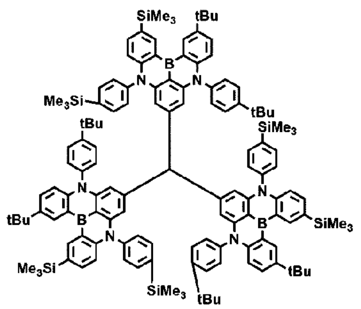
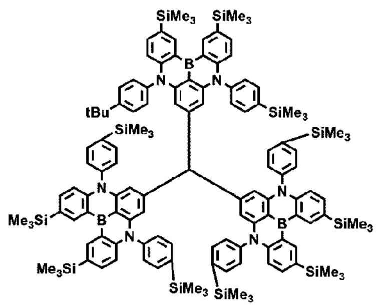

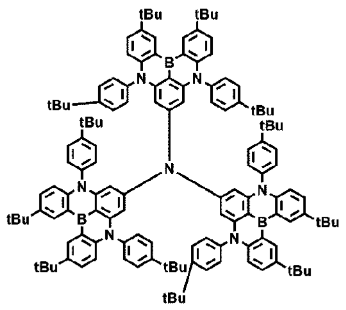
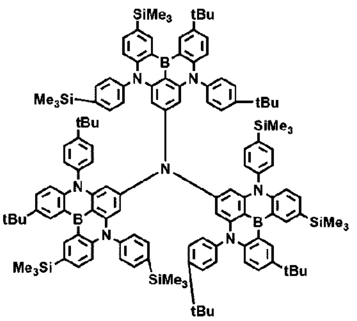
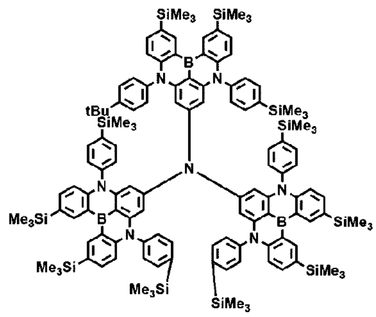

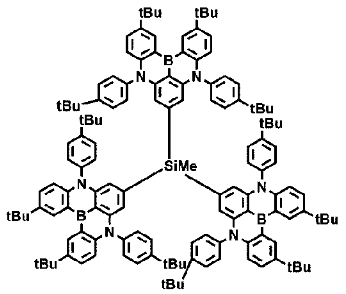
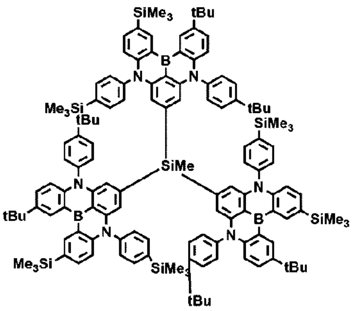
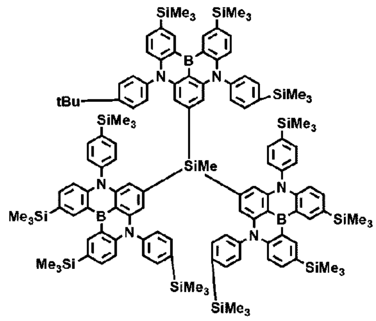

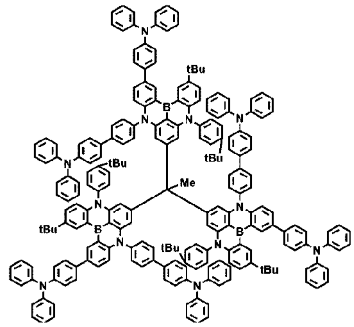
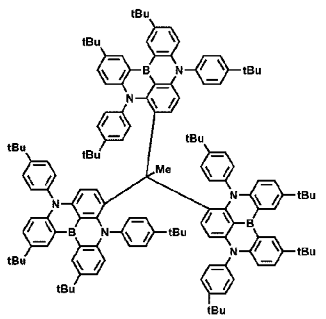
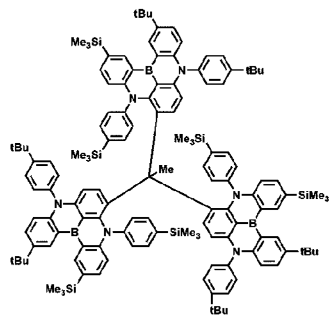

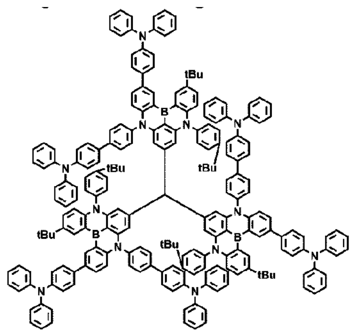
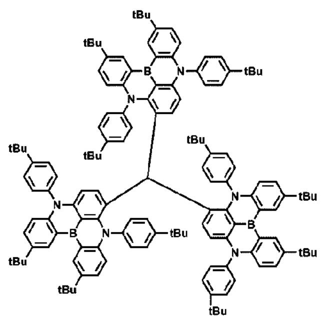
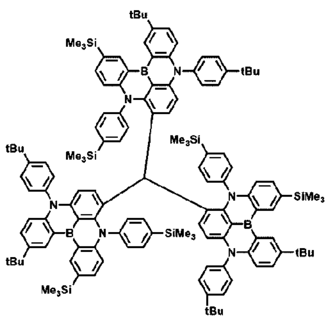

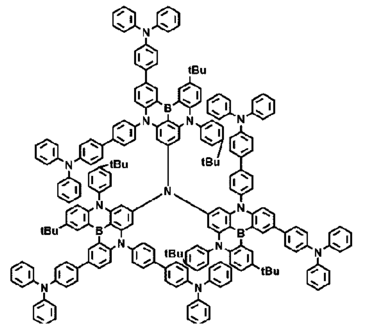
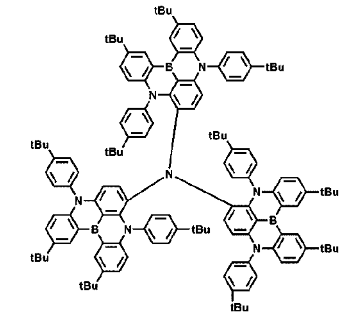
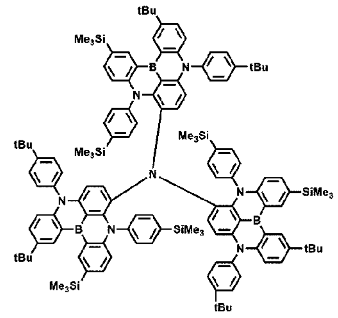

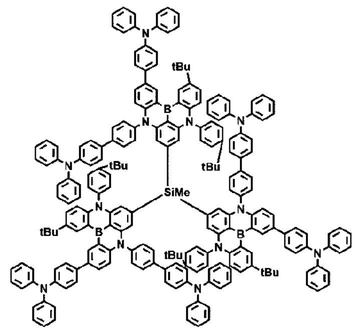
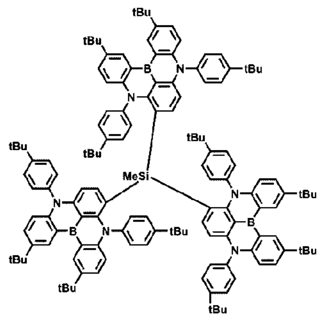
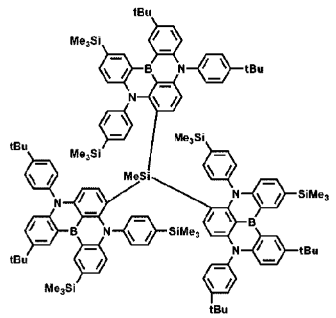

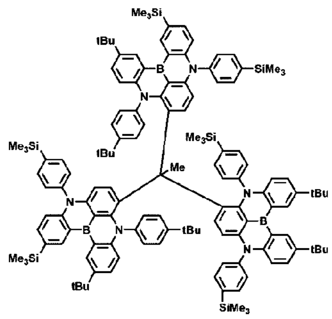
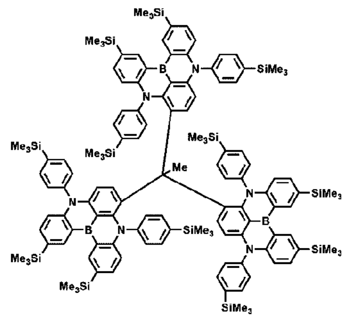
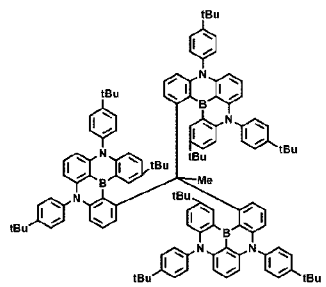

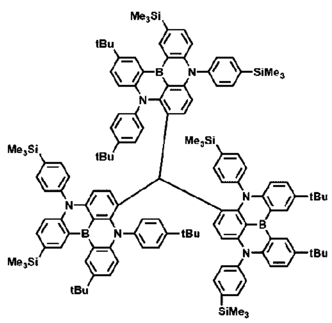
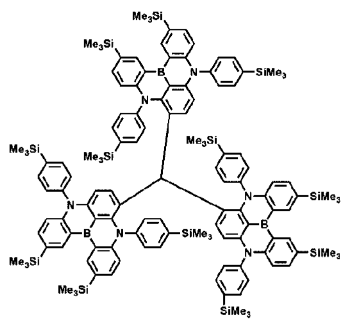
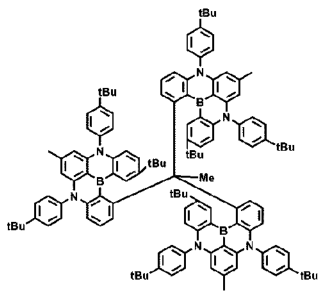

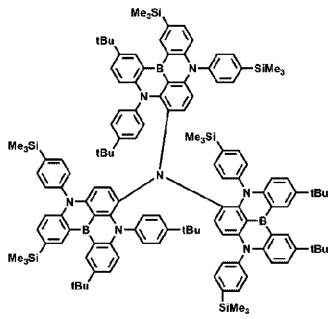
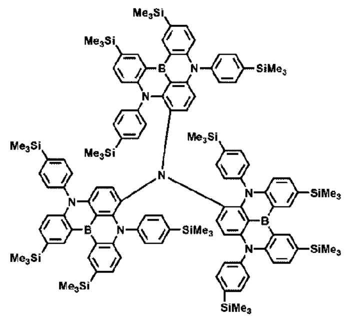
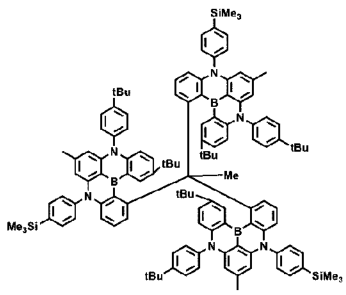
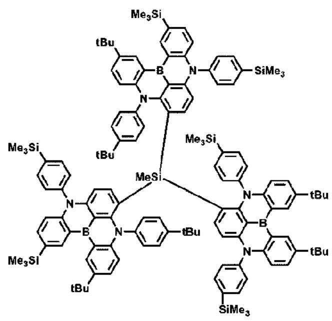
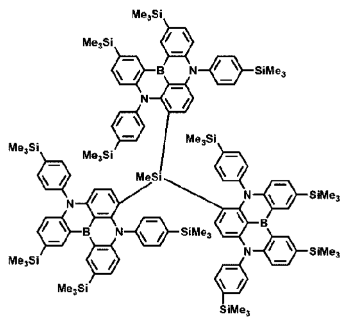
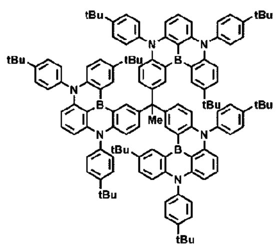
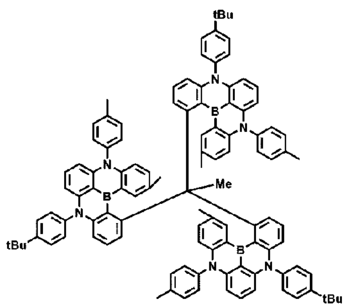
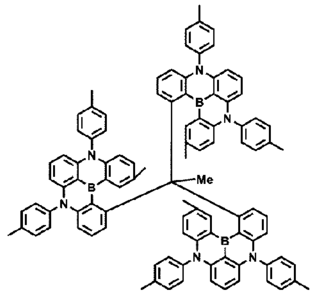
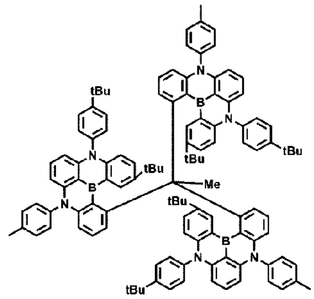
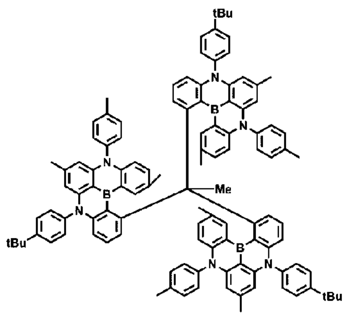
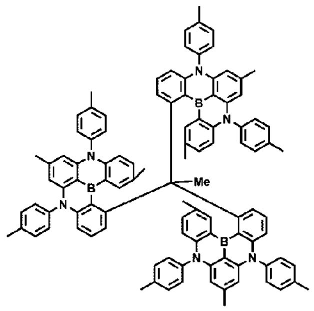
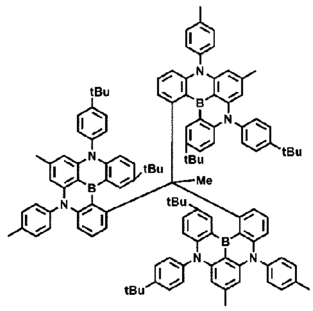
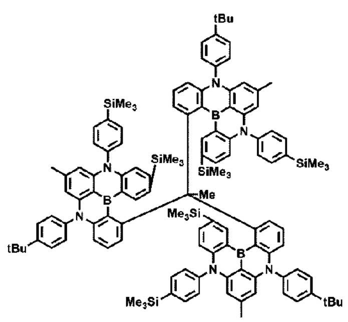
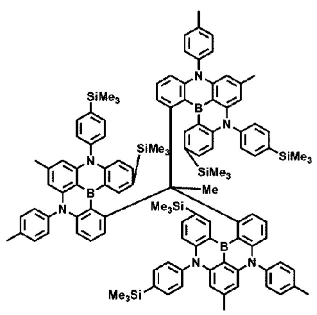
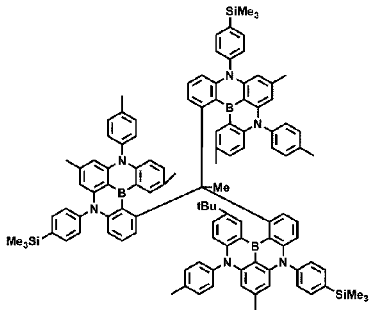

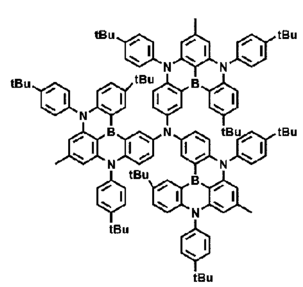

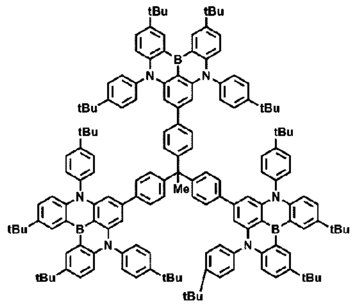

**12.** The compound of Claim 1, wherein the compound of Chemical Formula 1 is selected from among the following structural formulae:

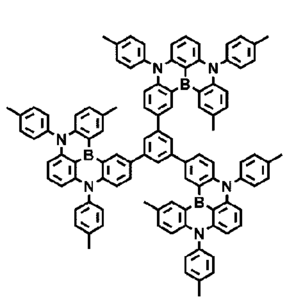

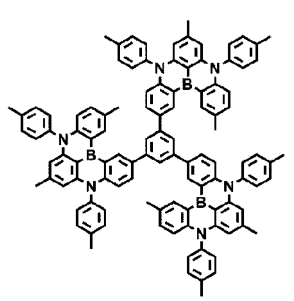

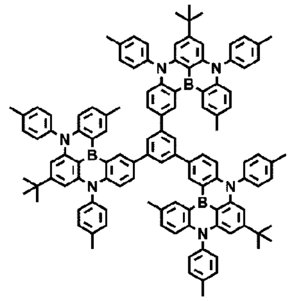

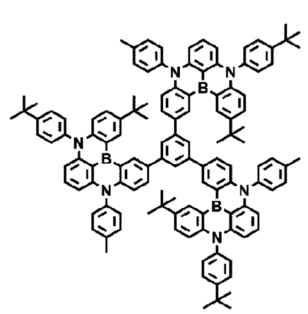

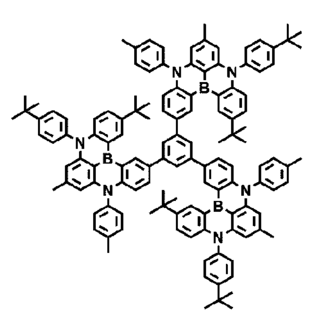

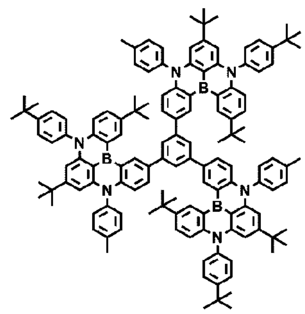

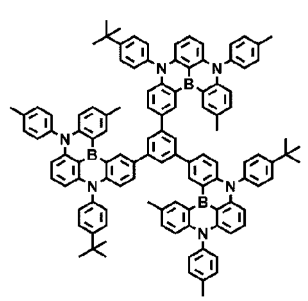

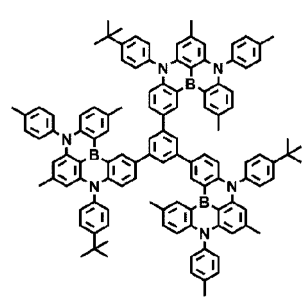

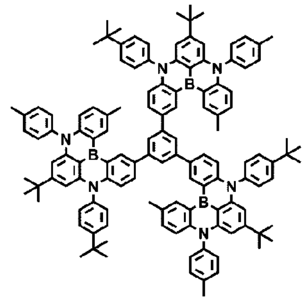

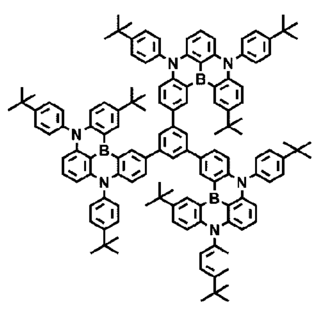

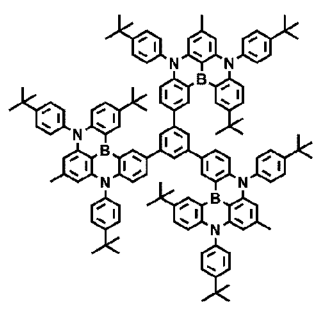

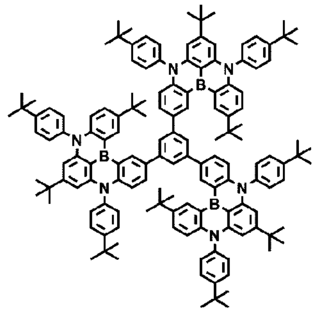

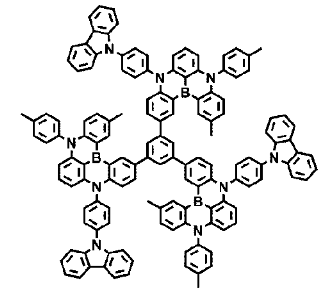
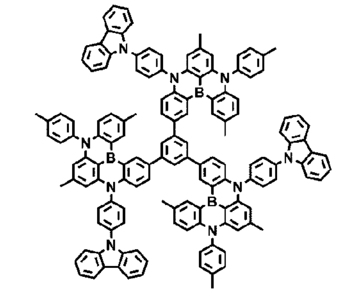
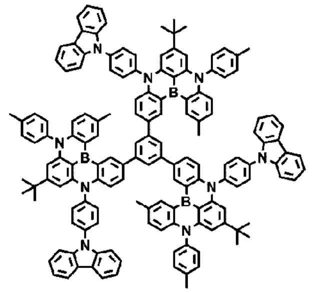

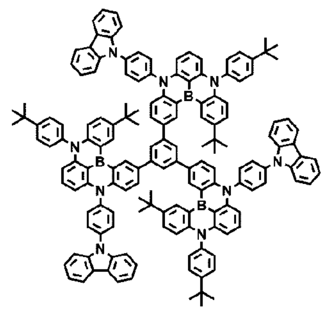
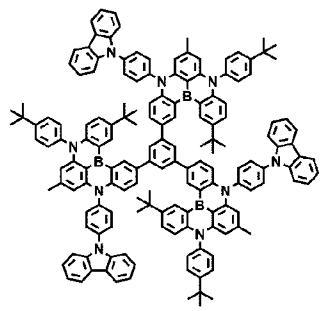
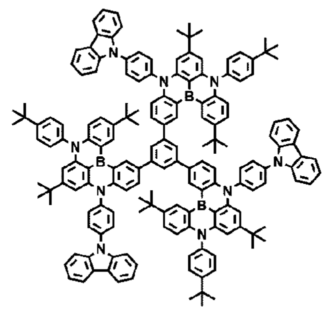

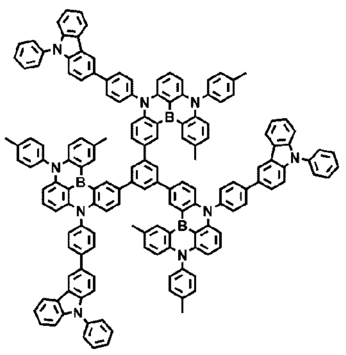
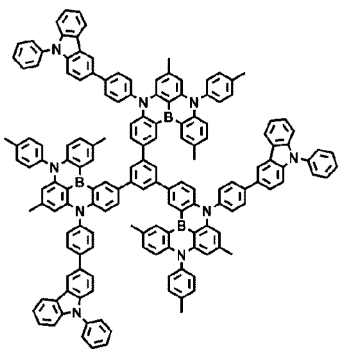
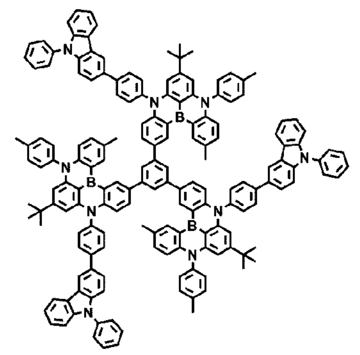

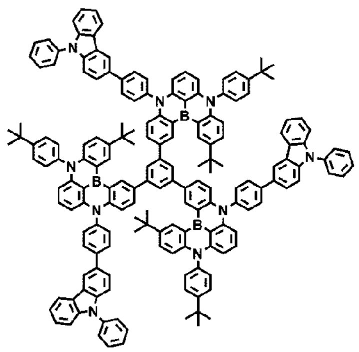
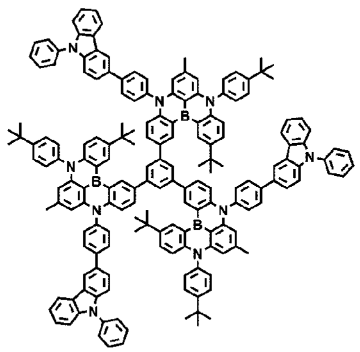
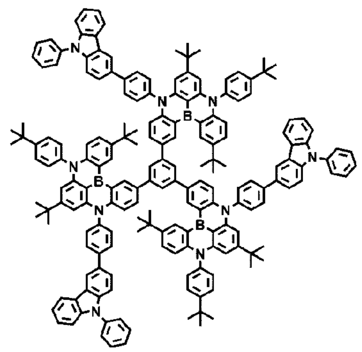

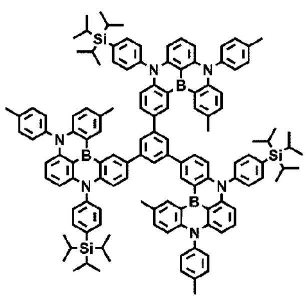
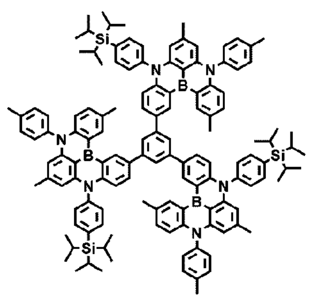
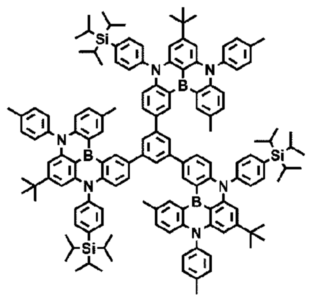

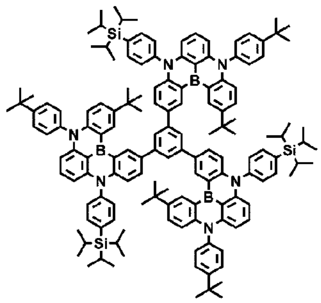
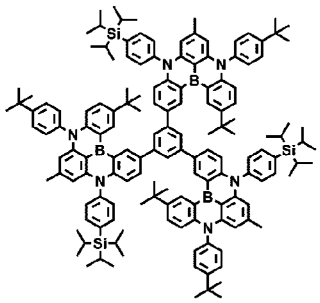
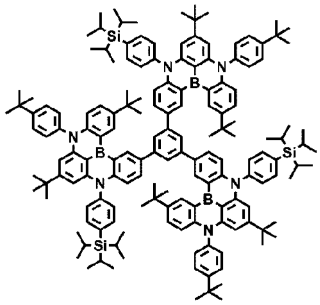

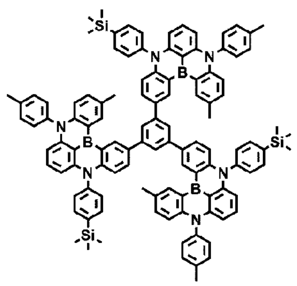
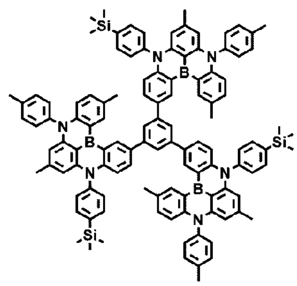
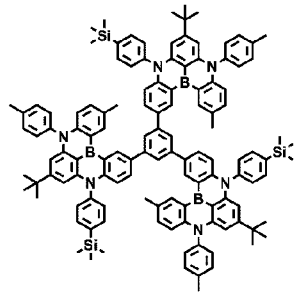

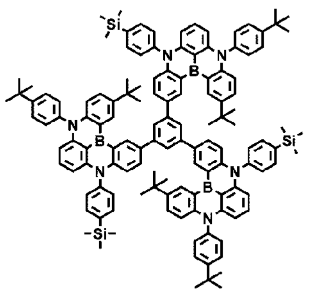
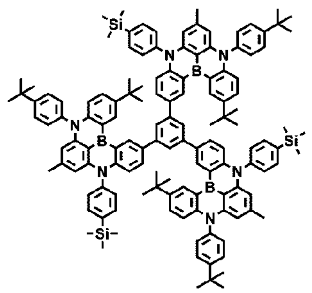
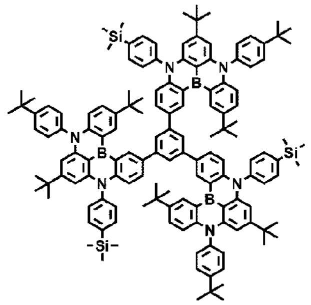

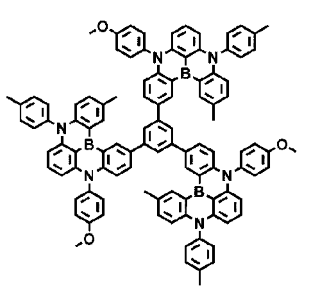
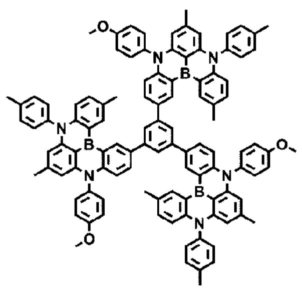
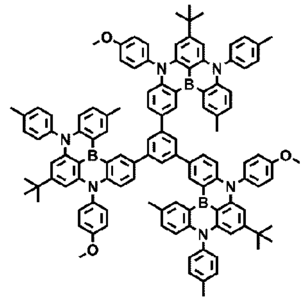

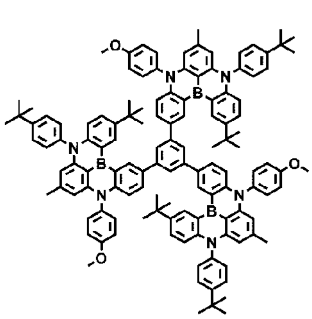
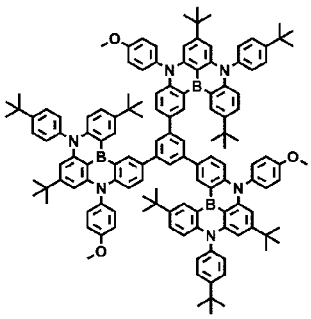
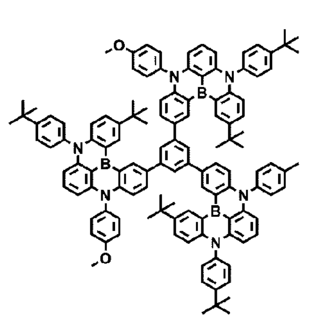

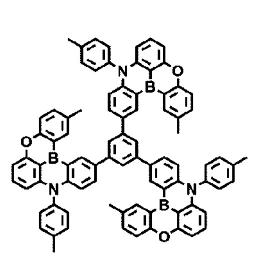
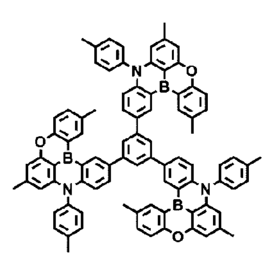
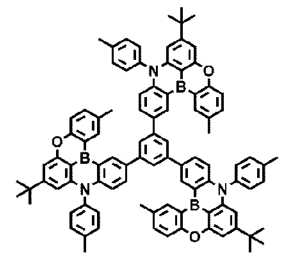

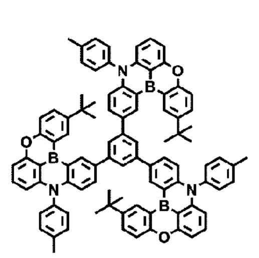
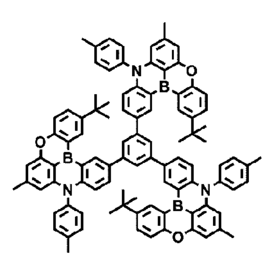
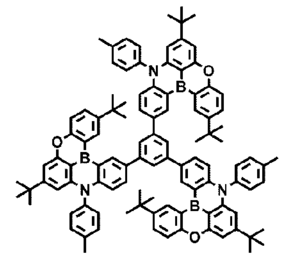

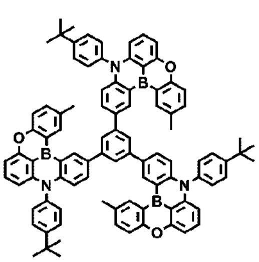
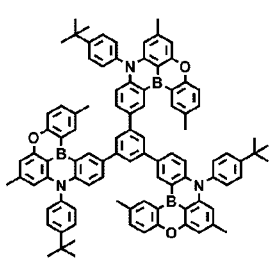
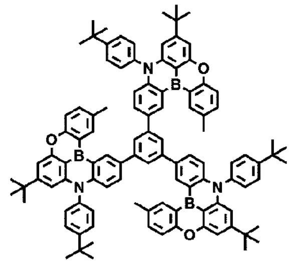

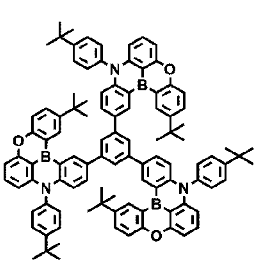
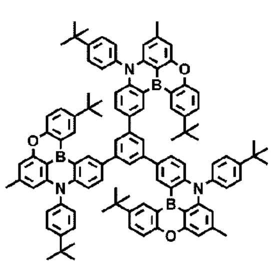
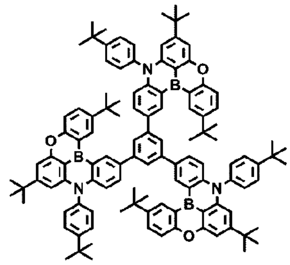

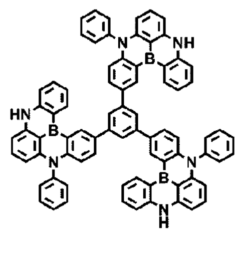
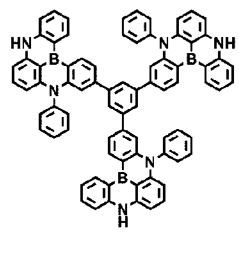
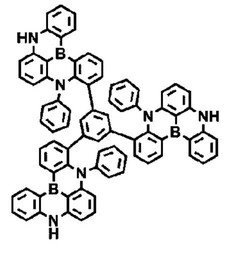

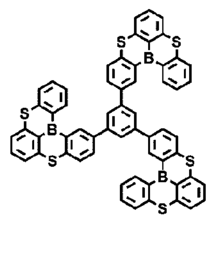
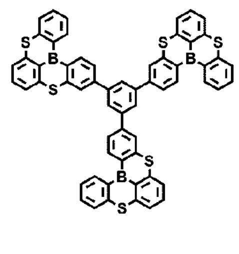
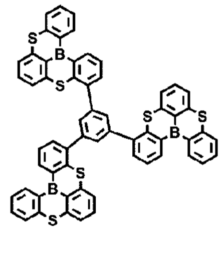

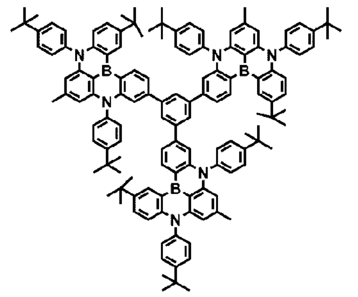

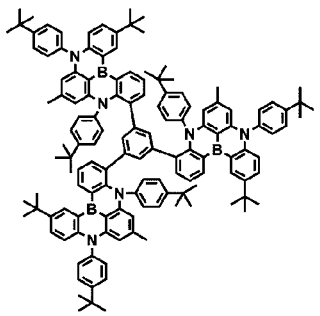

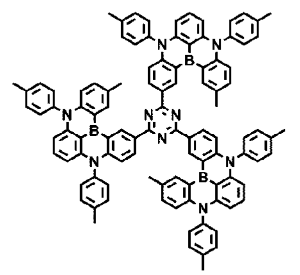

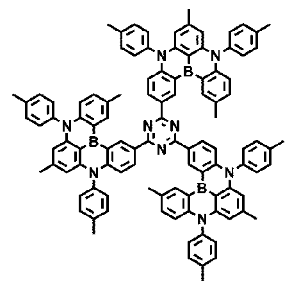

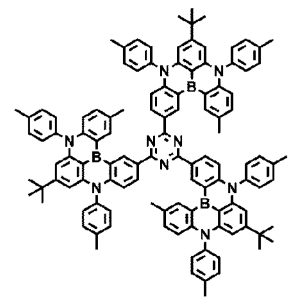

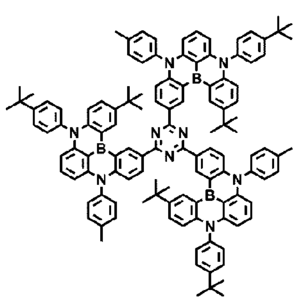

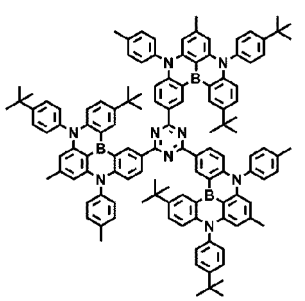

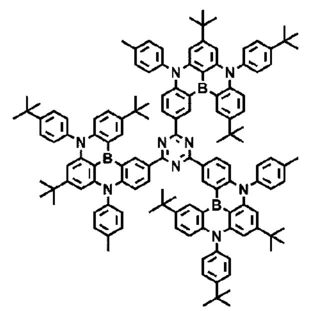

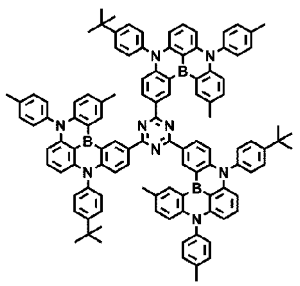

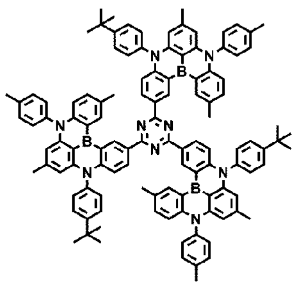

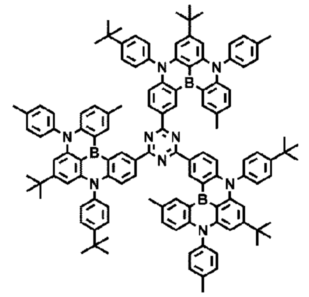

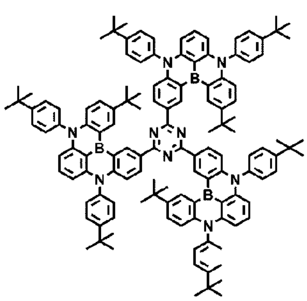

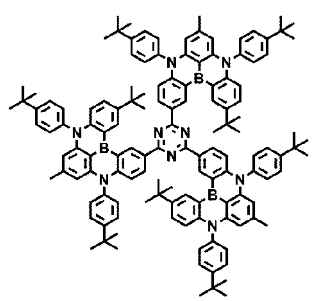

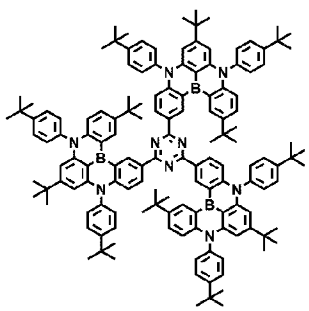

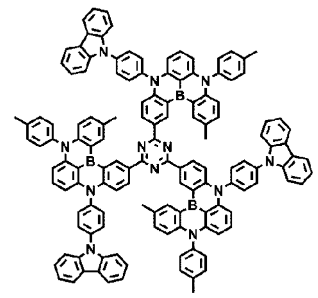
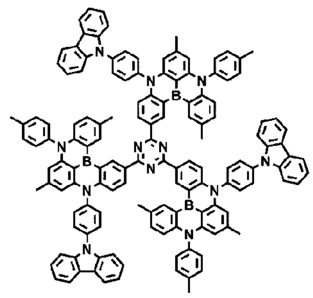
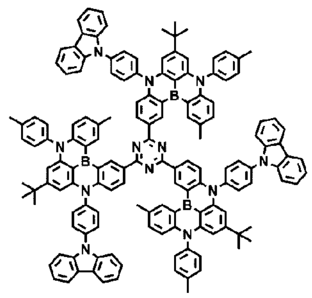

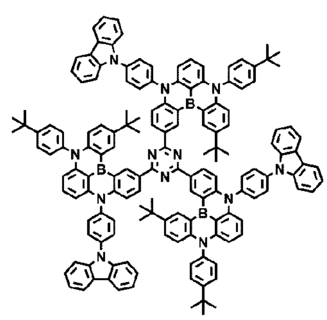
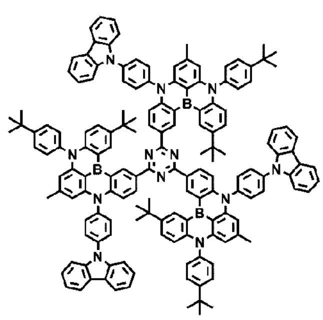
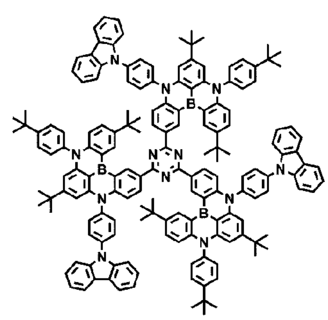

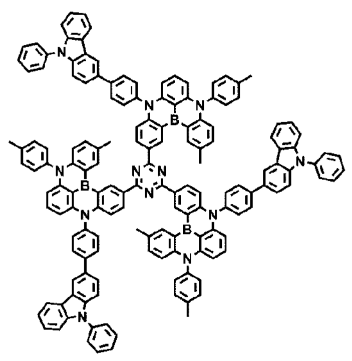
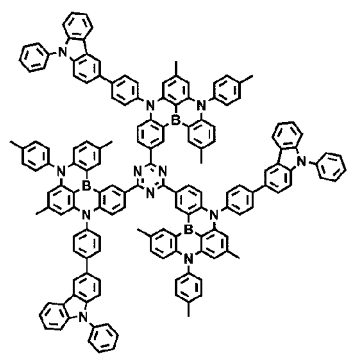
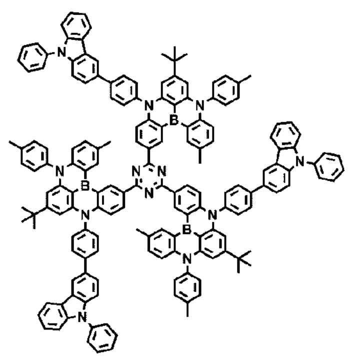

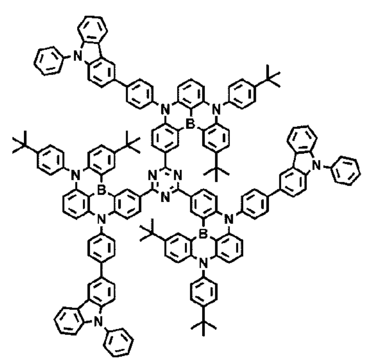
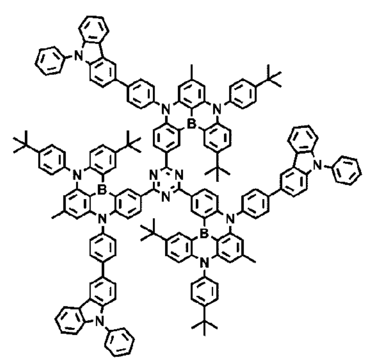
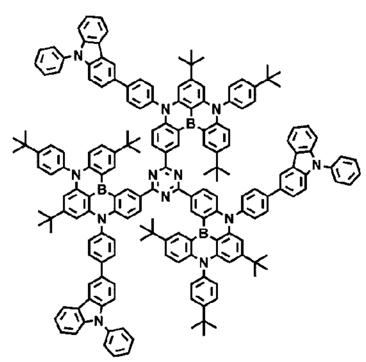

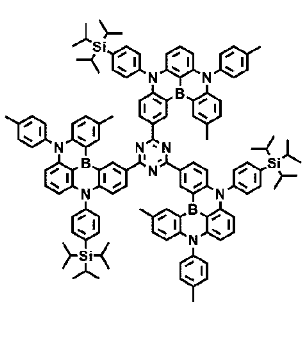
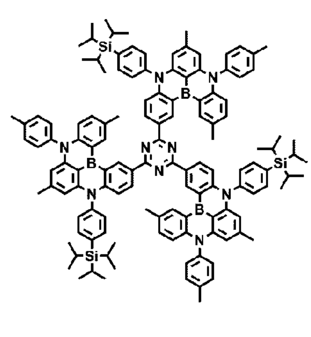
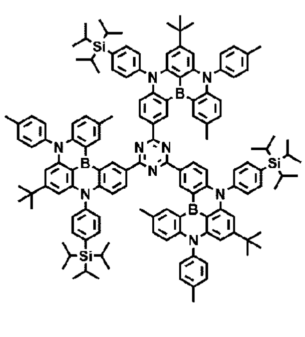

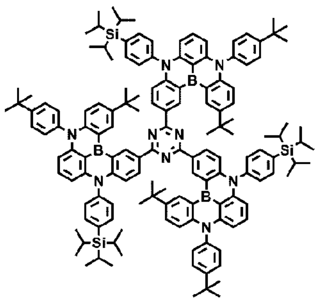
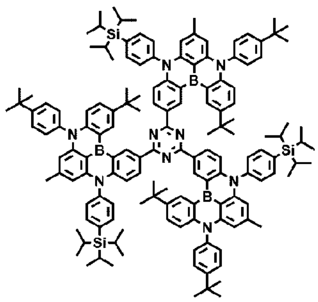
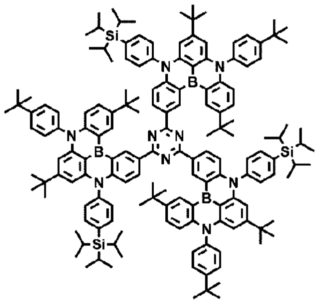

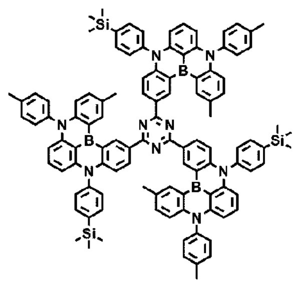
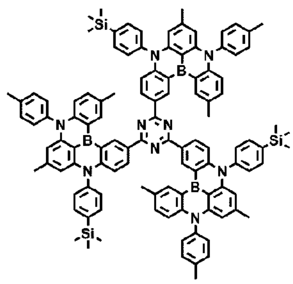
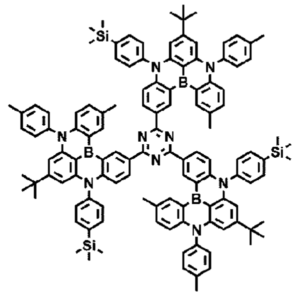

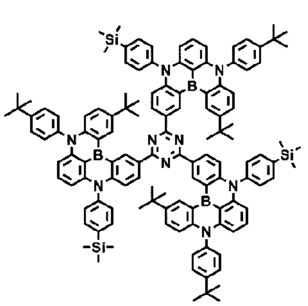
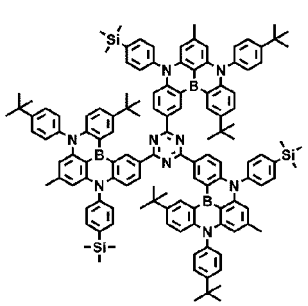
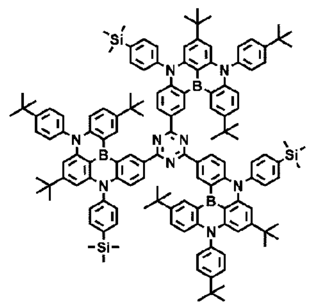

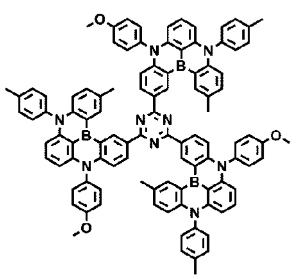
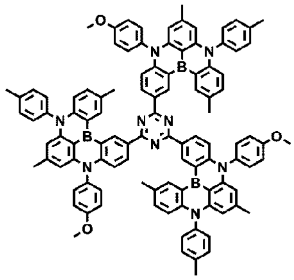
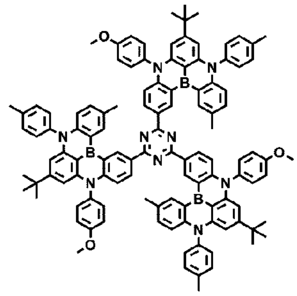

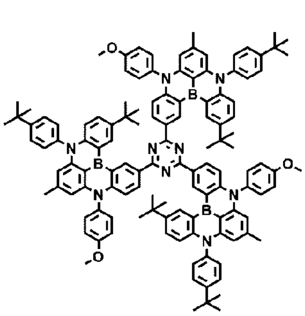
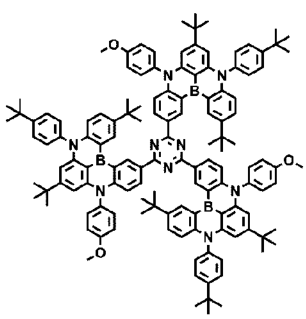
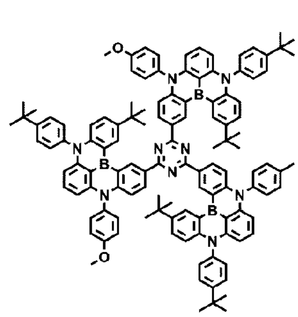

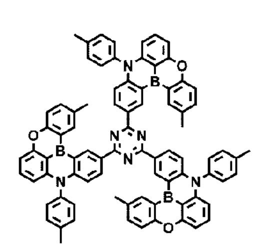
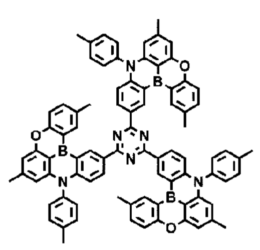
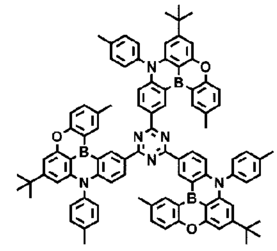

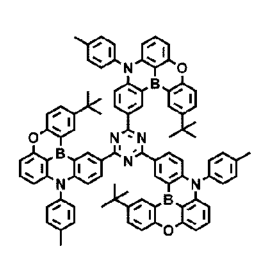
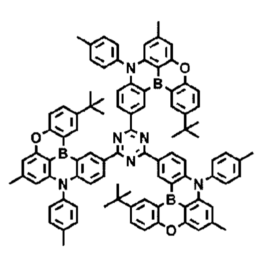
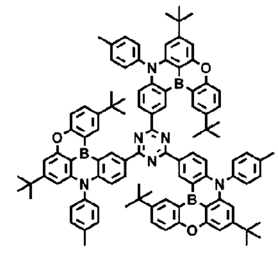

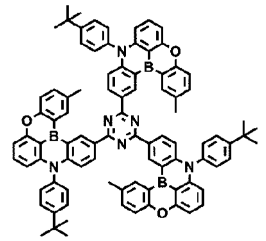
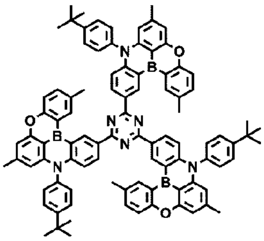
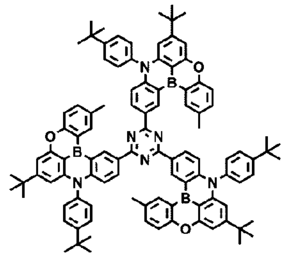

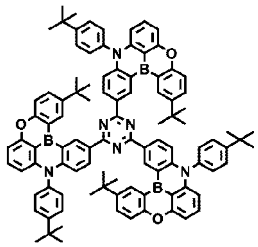
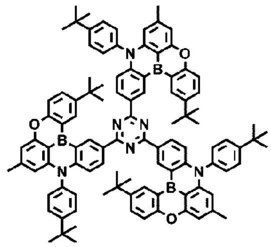
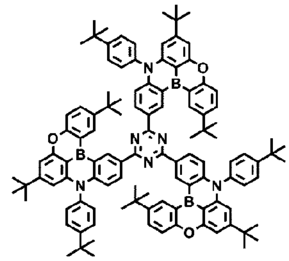

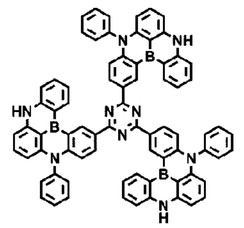
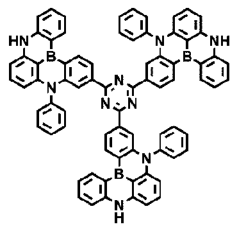
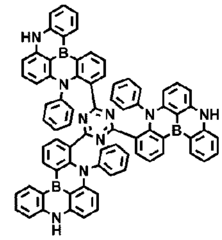

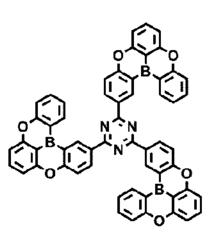
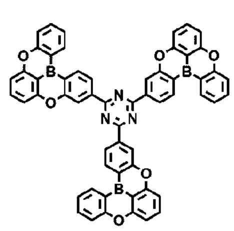
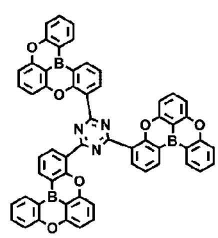

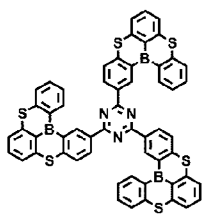
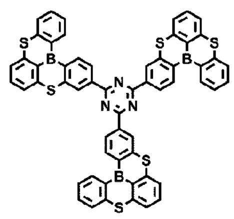
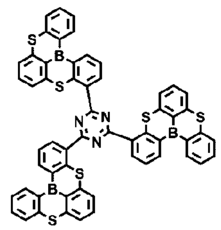

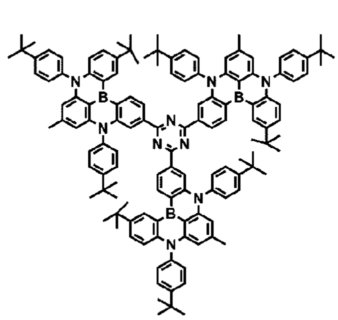
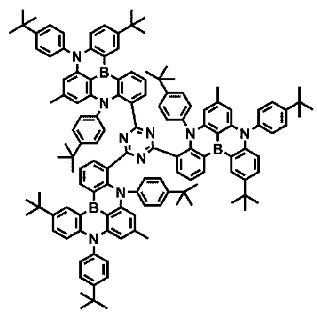
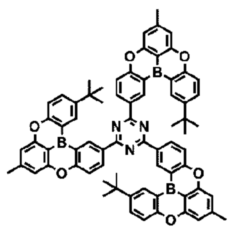
.

13. The compound of Claim 1, wherein the compound represented by Chemical Formula 1 is represented by the following Chemical Formula 10:

[Chemical Formula 10]

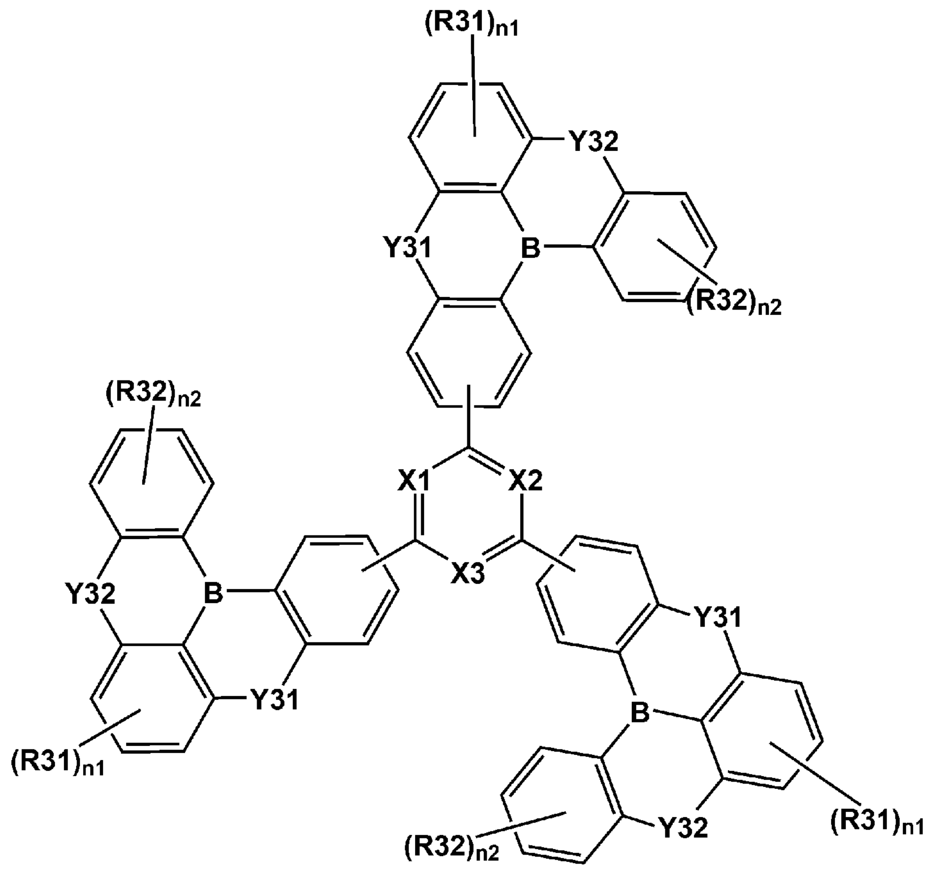

in Chemical Formula 10,

Y31 and Y32 are each independently N(R33), O or S;

X1 to X3 are each independently CH or N;

when X1 to X3 are CH, at least one of Y31 and Y32 is N(R33) or S;

R31, R32 and R33 are each independently hydrogen; deuterium; halogen; cyano; substituted or unsubstituted $C_{1-60}$ alkyl; substituted or unsubstituted $C_{1-60}$ alkoxy; substituted or unsubstituted $C_{2-60}$ alkynyl; substituted or unsubstituted $C_{3-60}$ cycloalkyl; substituted or unsubstituted $C_{6-60}$ aryl; substituted or unsubstituted $C_{2-60}$ heteroaryl including any one or more heteroatoms selected from the group consisting of N, O and S; substituted or unsubstituted tri ($C_{1-60}$ alkyl)silyl; or substituted or unsubstituted tri ($C_{6-60}$ aryl)silyl;

n1s are each independently an integer of 1 to 3; and

n2s are each independently an integer of 1 to 4.

**14.** The compound of Claim 13, wherein Y31 and Y32 are each independently N(R33).

**15.** A coating composition comprising the compound of any one of Claims 1 to 14.

**16.** The coating composition of Claim 15, which is for an organic light emitting device.

**17.** An organic light emitting device comprising:

a first electrode;

a second electrode provided opposite to the first electrode; and

one or more organic material layers provided between the first electrode and the second electrode,

wherein one or more layers of the organic material layers include the coating composition of Claim 15, or a cured material thereof.

**18.** The organic light emitting device of Claim 17, wherein the organic material layer includes a light emitting layer, and the light emitting layer includes the coating composition or a cured material thereof.

**19.** The organic light emitting device of Claim 17, wherein the light emitting layer is a blue light emitting layer.

**20.** The organic light emitting device of Claim 17, wherein the coating composition further includes a host material; and includes the compound and the host material in a weight ratio of 1:1 to 1:200.

**21.** The organic light emitting device of Claim 17, wherein the coating composition further includes a host material; and the host material is represented by the following Chemical Formula A:

[Chemical Formula A]

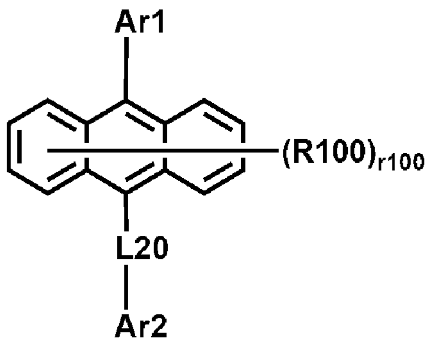

in Chemical Formula A,

Ar1 and Ar2 are the same as or different from each other, and each independently a substituted or unsubstituted aryl group; or a substituted or unsubstituted heteroaryl group;

L20 is a direct bond; or a substituted or unsubstituted arylene group;

R100 is hydrogen, deuterium, a halogen group, a nitrile group, a substituted or unsubstituted alkyl group, a substituted or unsubstituted aryl group; or a substituted or unsubstituted heteroaryl group; and

r100 is an integer of 0 to 8, and when r100 is 2 or greater, R100s are the same as or different from each other.

【FIG. 1】

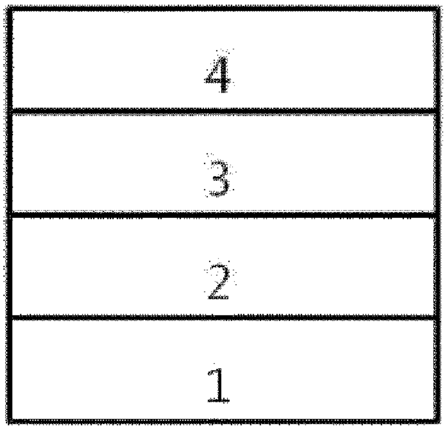


【FIG. 2】

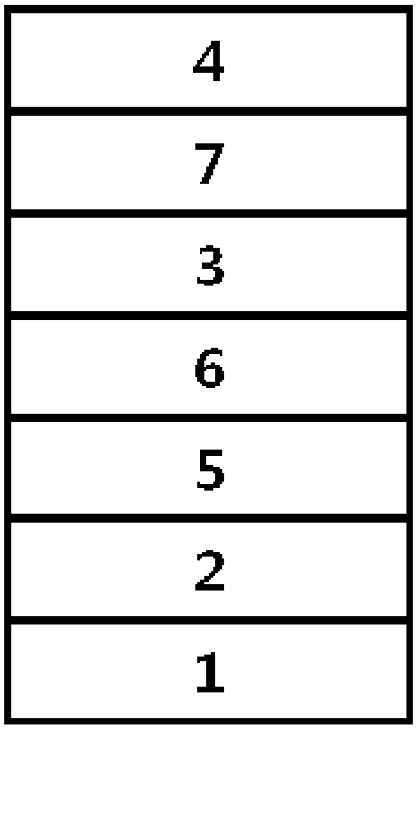

## INTERNATIONAL SEARCH REPORT

International application No.
**PCT/KR2020/009377**

**A. CLASSIFICATION OF SUBJECT MATTER**

**C07F 5/02**(2006.01)i; **H01L 51/00**(2006.01)i; **C09K 11/06**(2006.01)i; **H01L 51/50**(2006.01)i

According to International Patent Classification (IPC) or to both national classification and IPC

**B. FIELDS SEARCHED**

Minimum documentation searched (classification system followed by classification symbols)

C07F 5/02; C08G 61/12; C09K 11/06; H01L 51/00; H01L 51/50; H01L 51/54

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus, Marpat), Google & keywords: 유기발광다이오드 (OLED), 발광층 (emitting layer), 붕소 (boron), 헤테로아릴 화합물 (heteroaryl compound)

**C. DOCUMENTS CONSIDERED TO BE RELEVANT**

| Category* | Citation of document, with indication, where appropriate, of the relevant passages | Relevant to claim No. |
|---|---|---|
| A | WO 2019-035268 A1 (KWANSEI GAKUIN EDUCATIONAL FOUNDATION et al.) 21 February 2019. See claims 1-26. | 1-21 |
| A | CN 109411633 A (KUNSHAN GUO XIAN PHOTOELECTRIC CO., LTD. et al.) 01 March 2019. See claims 1-10. | 1-21 |
| A | WO 2019-004247 A1 (SUMITOMO CHEMICAL COMPANY, LIMITED) 03 January 2019. See entire document. | 1-21 |
| A | JP 2017-226838 A (KYULUX INC. et al.) 28 December 2017. See entire document. | 1-21 |

☑ Further documents are listed in the continuation of Box C.  ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **29 October 2020** | **30 October 2020** |

| Name and mailing address of the ISA/KR | Authorized officer |
|---|---|
| **Korean Intellectual Property Office**<br>**Government Complex Daejeon Building 4, 189, Cheongsa-ro, Seo-gu, Daejeon, Republic of Korea**<br>**35208** | |
| Facsimile No. **+82-42-481-8578** | Telephone No. |

Form PCT/ISA/210 (second sheet) (July 2019)

**INTERNATIONAL SEARCH REPORT**

International application No.
**PCT/KR2020/009377**

**C. DOCUMENTS CONSIDERED TO BE RELEVANT**

| Category* | Citation of document, with indication, where appropriate, of the relevant passages | Relevant to claim No. |
|---|---|---|
| A | WO 2018-095392 A1 (GUANGZHOU CHINARAY OPTOELECTRONIC MATERIALS LTD. et al.) 31 May 2018. See entire document. | 1-21 |

Form PCT/ISA/210 (second sheet) (July 2019)

**INTERNATIONAL SEARCH REPORT**
**Information on patent family members**

International application No.
**PCT/KR2020/009377**

| Patent document cited in search report | Publication date (day/month/year) | Patent family member(s) | Publication date (day/month/year) |
|---|---|---|---|
| WO 2019-035268 A1 | 21 February 2019 | KR 10-2020-0041832 A | 22 April 2020 |
| | | US 2020-0176680 A1 | 04 June 2020 |
| CN 109411633 A | 01 March 2019 | US 2020-0203617 A1 | 25 June 2020 |
| | | WO 2020-042608 A1 | 05 March 2020 |
| WO 2019-004247 A1 | 03 January 2019 | None | |
| JP 2017-226838 A | 28 December 2017 | None | |
| WO 2018-095392 A1 | 31 May 2018 | CN 109791993 A | 21 May 2019 |
| | | EP 3547385 A1 | 02 October 2019 |
| | | US 2019-0378991 A1 | 12 December 2019 |

Form PCT/ISA/210 (patent family annex) (July 2019)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020190086310
- KR 1020190085898